# EUROPEAN PATENT APPLICATION

(11) **EP 4 465 358 A1**
(43) Date of publication of application: **20.11.2024**
(21) Application number: 22920473.0
(22) Date of filing: 28.11.2022
(51) Int. Cl.: H01L 27/146, H01L 21/336, H01L 21/8234, H01L 21/8238, H01L 27/088, H01L 27/092, H01L 29/78, H04N 25/76, H10K 39/32

(54) **IMAGING DEVICE**

(30) Priority: 11.01.2022 JP 2022002621
(71) Applicant: Panasonic Intellectual Property Management Co., Ltd., Kadoma-shi, Osaka 571-0057 (JP)
(72) Inventor: NODA, Taiji, Kadoma-shi, Osaka 571-0057 (JP)
(74) Representative: Grünecker Patent- und Rechtsanwälte PartG mbB
(86) International application number: PCT/JP2022/043658
(87) International publication number: WO 2023/135953

(57) **Abstract**

An imaging device includes a pixel region including a pixel substrate portion and a pixel transistor provided in the pixel substrate portion and a first peripheral region including a first peripheral substrate portion and at least one first peripheral transistor provided in the first peripheral substrate portion. Signals are transmitted between the first peripheral region and the pixel region. A gate length of the at least one first peripheral transistor is shorter than a gate length of the pixel transistor. The at least one first peripheral transistor further includes, in the first peripheral substrate portion, a first source, a first drain, a first channel region, located between the first source and the first drain, through which carriers migrate, and a first strain-introducing layer that brings a strain to the first channel region.

## Description

### Technical Field

The present disclosure relates to an imaging device.

### Background Art

Image sensors are used in digital cameras or other devices. Examples of image sensors include CCD (charge-coupled device) image sensors and CMOS (complementary metal-oxide semiconductor) image sensors.

An image sensor according to one example has a photodiode provided in a semiconductor substrate. An image sensor according to another example has a photoelectric conversion layer provided above a semiconductor substrate.

An imaging device according to one specific example produces signal charge through photoelectric conversion. The signal charge thus produced is accumulated in a charge accumulation node. A signal corresponding to the amount of charge accumulated in the charge accumulation node is read out via a CCD or CMOS circuit formed in a semiconductor substrate.

PTL 1 discloses an imaging device. The imaging device of PTL 1 includes a pixel region and a peripheral region. PTL 2, PTL 3, and PTL 4 describe examples of transistors.

### Citation List

### Patent Literature

PTL 1: International Publication No. 2021/152943
PTL 2: Japanese Patent No. 5235486
PTL 3: Japanese Patent No. 3426573
PTL 4: U.S. Patent No. 7,141,477

### Summary of Invention

### Technical Problem

The present disclosure provides techniques that are suitable to improving the performance of an imaging device.

### Solution to Problem

An imaging device according to an aspect of the present disclosure includes a pixel region including a pixel substrate portion and a pixel transistor provided in the pixel substrate portion and a first peripheral region including a first peripheral substrate portion and at least one first peripheral transistor provided in the first peripheral substrate portion. Signals are transmitted between the first peripheral region and the pixel region. The pixel transistor and the at least one first peripheral transistor each include a gate. A gate length of the at least one first peripheral transistor is shorter than a gate length of the pixel transistor. The at least one first peripheral transistor further includes, in the first peripheral substrate portion, a first source, a first drain, a first channel region, located between the first source and the first drain, through which carriers migrate, and a first strain-introducing layer that brings a strain to the first channel region.

### Advantageous Effects of Invention

The techniques disclosed here are suitable to improving the performance of an imaging device.

### Brief Description of Drawings

[Fig. 1] Fig. 1 is a diagram schematically showing an exemplary configuration of an imaging device according to Embodiment 1.
[Fig. 2] Fig. 2 is a diagram schematically showing an exemplary circuit configuration of the imaging device.
[Fig. 3] Fig. 3 is a schematic cross-sectional view showing a pixel region, a peripheral region, and a blocking region located between the pixel region and the peripheral region.
[Fig. 4] Fig. 4 is a schematic plan view showing another example of the shape of a blocking region.
[Fig. 5A] Fig. 5A is a cross-sectional view showing a transistor according to a first configuration example.
[Fig. 5B] Fig. 5B is a schematic cross-sectional view for explaining a region in the transistor according to the first configuration example where carbon is distributed.
[Fig. 6A] Fig. 6A is a cross-sectional view showing a transistor according to a second configuration example.
[Fig. 6B] Fig. 6B is a schematic cross-sectional view for explaining a region in the transistor according to the second configuration example where carbon is distributed.
[Fig. 6C] Fig. 6C is a schematic cross-sectional view showing recessed portions formed in a first epitaxial layer.
[Fig. 6D] Fig. 6D is a schematic cross-sectional view for explaining embedded portions and raised portions.
[Fig. 7] Fig. 7 is a cross-sectional view showing a transistor according to a first modification of the first configuration example.
[Fig. 8] Fig. 8 is a cross-sectional view showing a transistor according to a second modification of the first configuration example.
[Fig. 9] Fig. 9 is a diagram showing impurity concentration profiles in regions along a straight line passing through a source diffusion layer according to a third modification of the first configuration example and extending in a direction parallel with the depth of a semiconductor substrate.
[Fig. 10] Fig. 10 illustrates cross-sectional views showing a method for manufacturing a transistor according to the first configuration example.
[Fig. 11] Fig. 11 illustrates cross-sectional views showing the method for manufacturing a transistor according to the first configuration example.
[Fig. 12] Fig. 12 illustrates cross-sectional views showing the method for manufacturing a transistor according to the first configuration example.
[Fig. 13] Fig. 13 illustrates cross-sectional views showing the method for manufacturing a transistor according to the first configuration example.
[Fig. 14] Fig. 14 illustrates graphs showing impurity concentration profiles in regions along a straight line passing through extension formation regions according to the first configuration example and extending in a direction parallel with the depth of a semiconductor substrate.
[Fig. 15] Fig. 15 illustrates cross-sectional views showing a method for manufacturing a transistor according to a second configuration example.
[Fig. 16] Fig. 16 is a schematic plan view showing a transistor of a pixel region and a transistor of a peripheral region.
[Fig. 17] Fig. 17 is a schematic plan view showing a transistor of a pixel region and a transistor of a peripheral region.
[Fig. 18] Fig. 18 illustrates schematic cross-sectional views showing a transistor of a pixel region and a transistor of a peripheral region.
[Fig. 19] Fig. 19 is a schematic plan view showing a transistor of a pixel region and transistors of a peripheral region.
[Fig. 20] Fig. 20 is a schematic plan view showing a transistor of a pixel region and transistors of a peripheral region.
[Fig. 21] Fig. 21 is a schematic plan view showing a transistor of a pixel region and transistors of peripheral regions.
[Fig. 22] Fig. 22 is a schematic plan view showing a transistor of a pixel region and transistors of peripheral regions.
[Fig. 23] Fig. 23 illustrates schematic cross-sectional views showing a transistor of a pixel region and transistors of peripheral regions.
[Fig. 24] Fig. 24 is a schematic plan view showing a transistor of a pixel region and transistors of peripheral regions.
[Fig. 25] Fig. 25 is a schematic plan view showing a transistor of a pixel region and transistors of peripheral regions.
[Fig. 26] Fig. 26 illustrates schematic cross-sectional views showing a transistor of a pixel region and transistors of peripheral regions.
[Fig. 27] Fig. 27 illustrates schematic cross-sectional views showing a transistor of a pixel region and transistors of peripheral regions.
[Fig. 28] Fig. 28 is a schematic view of a back-side illumination imaging device.
[Fig. 29] Fig. 29 is a schematic view showing shapes that a pixel region and peripheral regions of an imaging device may take.
[Fig. 30] Fig. 30 is a schematic view showing shapes that a pixel region and peripheral regions of an imaging device may take.
[Fig. 31] Fig. 31 is a schematic view showing shapes that a pixel region and peripheral regions of an imaging device may take.
[Fig. 32] Fig. 32 is a schematic view showing shapes that a pixel region and peripheral regions of an imaging device may take.
[Fig. 33] Fig. 33 is a schematic view of a chip stack imaging device.
[Fig. 34] Fig. 34 is a schematic cross-sectional view showing a pixel region, a peripheral region, and a blocking region.
[Fig. 35] Fig. 35 is a schematic perspective view illustrating a transistor of a pixel region and a transistor of a peripheral region.
[Fig. 36] Fig. 36 is a schematic perspective view illustrating a transistor of a pixel region and a transistor of a peripheral region.
[Fig. 37] Fig. 37 is a schematic perspective view illustrating a transistor of a pixel region and transistors of a peripheral region.
[Fig. 38] Fig. 38 is a schematic perspective view illustrating a transistor of a pixel region and transistors of a peripheral region.
[Fig. 39] Fig. 39 is a schematic perspective view illustrating a transistor of a pixel region and transistors of peripheral regions.
[Fig. 40] Fig. 40 is a schematic perspective view illustrating a transistor of a pixel region and transistors of peripheral regions.
[Fig. 41] Fig. 41 is a schematic perspective view illustrating a transistor of a pixel region and transistors of peripheral regions.
[Fig. 42] Fig. 42 is a schematic perspective view illustrating a transistor of a pixel region and transistors of peripheral regions.
[Fig. 43] Fig. 43 is a schematic view of a back-side illumination imaging device.
[Fig. 44A] Fig. 44A is a schematic cross-sectional view of an imaging device according to a specific example.
[Fig. 44B] Fig. 44B is a schematic perspective view of the imaging device according to the specific example.
[Fig. 45A] Fig. 45A is a schematic cross-sectional view of an imaging device according to a specific example.
[Fig. 45B] Fig. 45B is a schematic perspective view of the imaging device according to the specific example.
[Fig. 46A] Fig. 46A is a schematic cross-sectional view of an imaging device according to a specific example.
[Fig. 46B] Fig. 46B is a schematic perspective view of the imaging device according to the specific example.
[Fig. 47A] Fig. 47A is a schematic cross-sectional view of an imaging device according to a specific example.
[Fig. 47B] Fig. 47B is a schematic perspective view of the imaging device according to the specific example.
[Fig. 48A] Fig. 48A is a schematic cross-sectional view of an imaging device according to a specific example.
[Fig. 48B] Fig. 48B is a schematic perspective view of the imaging device according to the specific example.
[Fig. 49] Fig. 49 is a schematic view of a back-side illumination imaging device. Description of Embodiments

### (Brief Overview of an Aspect according to the Present Disclosure)

An imaging device according to a first aspect of the present disclosure includes a pixel region including a pixel substrate portion and a pixel transistor provided in the pixel substrate portion and a first peripheral region including a first peripheral substrate portion and at least one first peripheral transistor provided in the first peripheral substrate portion.

Signals are transmitted between the first peripheral region and the pixel region.

The pixel transistor and the at least one first peripheral transistor each include a gate.

A gate length of the at least one first peripheral transistor is shorter than a gate length of the pixel transistor.

The at least one first peripheral transistor further includes, in the first peripheral substrate portion, a first source, a first drain, a first channel region, located between the first source and the first drain, through which carriers migrate, and a first strain-introducing layer that brings a strain to the first channel region.

The technique according to the first aspect is suitable to improving the performance of an imaging device.

In a second aspect of the present disclosure, for example, in the imaging device according to the first aspect, the first strain-introducing layer may be a single-crystal layer.

The technique according to the second aspect is suitable to improving the performance of an imaging device.

In a third aspect of the present disclosure, for example, in the imaging device according to the first or second aspect, the first strain-introducing layer may be an epitaxial layer.

The technique according to the third aspect is suitable to improving the performance of an imaging device.

In a fourth aspect of the present disclosure, for example, in the imaging device according to any one of the first to third aspects, the first strain-introducing layer may be a crystal layer of silicon germanium, germanium, a Group III-V compound, silicon carbide, transition metal dichalcogenide, or carbon nanotubes.

The crystal layer of silicon germanium, germanium, a Group III-V compound, silicon carbide, transition metal dichalcogenide, or carbon nanotubes may bring a strain to the first channel region.

In a fifth aspect of the present disclosure, for example, in the imaging device according to any one of the first to fourth aspects,
the first strain-introducing layer may be a crystal layer of Si₁₋ₓGeₓ, and
X may be greater than 0 and less than 1.

The technique according to the fifth aspect is suitable to improving the performance of an imaging device.

In a sixth aspect of the present disclosure, for example, in the imaging device according to any one of the first to fifth aspects,
the first strain-introducing layer may be a crystal layer of Si₁₋ₓGeₓ, and
X may be greater than or equal to 0.1 and less than or equal to 0.8.

The technique according to the sixth aspect is suitable to improving the performance of an imaging device.

In a seventh aspect of the present disclosure, for example, in the imaging device according to any one of the first to sixth aspects,
the first peripheral substrate portion may include a first foundation layer that is adjacent to the first strain-introducing layer, and
a lattice constant of a crystal lattice of the first strain-introducing layer may be different from a lattice constant of a crystal lattice of the first foundation layer.

The technique according to the seventh aspect is suitable to improving the performance of an imaging device.

In an eighth aspect of the present disclosure, for example, in the imaging device according to the seventh aspect, the first foundation layer may be a single-crystal layer of silicon.

The technique according to the eighth aspect is suitable to improving the performance of an imaging device.

In a ninth aspect of the present disclosure, for example, in the imaging device according to any one of the first to eighth aspects,
the first peripheral substrate portion may include a supporting substrate,
the at least one first peripheral transistor may include a first cap layer in the first peripheral substrate portion,
the supporting substrate, the first strain-introducing layer, and the first cap layer may be arranged in an order from lower to upper parts of the imaging device,
the first cap layer may include an upper surface of the first peripheral substrate portion, and
a concentration of a conductive impurity of the first cap layer may be lower than a concentration of a conductive impurity of the supporting substrate.

The technique according to the ninth aspect is suitable to improving the performance of an imaging device.

In a tenth aspect of the present disclosure, for example, in the imaging device according to the ninth aspect, the first cap layer may be a non-doped epitaxial layer.

The technique according to the tenth aspect is suitable to improving the performance of an imaging device.

In an eleventh aspect of the present disclosure, for example, in the imaging device according to any one of the first to tenth aspects, the first channel region may include the first strain-introducing layer.

The configuration of the eleventh aspect is an example of a configuration of the imaging device.

In a twelfth aspect of the present disclosure, for example, in the imaging device according to any one of the first to eleventh aspects,
the first source may include the first strain-introducing layer, and
the first drain may include the first strain-introducing layer.

The configuration of the twelfth aspect is an example of a configuration of the imaging device.

In a thirteenth aspect of the present disclosure, for example, in the imaging device according to any one of the first to twelfth aspects,
the pixel transistor further may include a pixel gate insulator film,
the at least one first peripheral transistor may further include a first peripheral gate insulator film, and
the first peripheral gate insulator film may be thinner than the pixel gate insulator film.

The configuration of the thirteenth aspect is an example of a configuration of the imaging device.

In a fourteenth aspect of the present disclosure, for example, in the imaging device according to any one of the first to thirteenth aspects,
when at least one type of impurity that suppresses transient enhanced diffusion of a conductive impurity is defined as a diffusion-suppressing species, the at least one first peripheral transistor may further include a first specific layer that is located in the first peripheral substrate portion and that contains the diffusion-suppressing species, and
the diffusion-suppressing species may contain at least one selected from the group consisting of carbon, nitrogen, and fluorine.

The technique according to the fourteenth aspect is suitable to improving the performance of an imaging device.

In a fifteenth aspect of the present disclosure, for example, in the imaging device according to the fourteenth aspect,
the first channel region may include the first strain-introducing layer,
the at least one first peripheral transistor may further include a first pocket diffusion layer,
the first pocket diffusion layer may be adjacent to the first source or the first drain, and
the first specific layer may be included in at least one selected from the group consisting of (a) the first pocket diffusion layer and (b) a region between the first pocket diffusion layer and the first strain-introducing layer.

In other words, in the imaging device according to the fourteenth aspect, at least one selected from the group consisting of the following (a) and (b) may hold:
(a) the first pocket diffusion layer may include the first specific layer; and
(b) a region between the first pocket diffusion layer and the first strain-introducing layer may include the first specific layer.

The technique according to the fifteenth aspect is suitable to improving the performance of an imaging device.

In a sixteenth aspect of the present disclosure, for example, in the imaging device according to the fourteenth or fifteenth aspect,
at least one selected from the group consisting of the first source and the first drain may include the first strain-introducing layer,
the first peripheral substrate portion may include a first foundation layer,
a conductive impurity in the at least one selected from the group consisting of the first source and the first drain may spread in a first region of the first foundation layer astride an interface between the first foundation layer and the first strain-introducing layer included in the at least one selected from the group consisting of the first source and the first drain, and
the first region may include the first specific layer.

In other words, in the imaging device according to the fourteenth or fifteenth aspect,
the first source may include the first strain-introducing layer,
the first drain may include the first strain-introducing layer,
the first peripheral substrate portion may have a first foundation layer, and
at least one selected from among the following (c) and (d) may hold:
   (c) there may be a first interface between the first foundation layer and the first strain-introducing layer included in the first source,
   a conductive impurity of the first source may spread in a first predetermined region of the first foundation layer astride the first interface, and
   the first predetermined region may include the first specific layer; and
   (d) there may be a second interface between the first foundation layer and the first strain-introducing layer included in the first drain, and
   a conductive impurity of the first drain may spread in a second predetermined region of the first foundation layer astride the second interface.

The technique according to the sixteenth aspect is suitable to improving the performance of an imaging device.

In a seventeenth aspect of the present disclosure, for example, in the imaging device according to any one of the fourteenth to sixteenth aspects,
when at least one type of impurity that induces amorphization of a region into which the at least one type of impurity has been implanted is defined as an amorphizing species, the first specific layer may contain the amorphizing species, and
the amorphizing species may contain at least one selected from the group consisting of germanium, silicon, and argon.

The amorphizing species may be a trace of pre-amorphization that may enhance the diffusion-suppressing action on the conductive impurity by a diffusion-suppressing species.

In an eighteenth aspect of the present disclosure, for example, in the imaging device according to any one of the fourteenth to seventeenth aspects,
the pixel region further may include a charge accumulation region in which a charge generated by photoelectric conversion is accumulated and that is an impurity region, and
a concentration of carbon in the first specific layer may be higher than a concentration of carbon in the charge accumulation region.

Only a high-performance imaging device can have the feature of the eighteenth aspect.

In a nineteenth aspect of the present disclosure, for example, in the imaging device according to any one of the fourteenth to eighteenth aspects,
the pixel transistor may further include a source, a drain, and a channel region, located between the source and the drain, through which carriers migrate, and
a concentration of carbon in the first specific layer may be higher than a concentration of carbon in the channel region of the at least one pixel transistor.

Only a high-performance imaging device can have the feature of the nineteenth aspect.

In a twentieth aspect of the present disclosure, for example, in the imaging device according to any one of the first to nineteenth aspects,
when at least one type of impurity that suppresses transient enhanced diffusion of a conductive impurity is defined as a diffusion-suppressing species, the at least one first peripheral transistor may further include a first specific layer that is located in the first peripheral substrate portion and that contains the diffusion-suppressing species,
the at least one first peripheral transistor may comprise two first peripheral transistors,
the first peripheral region may further include a shallow trench isolation structure,
the shallow trench isolation structure may provide device isolation of the two first peripheral transistors from each other,
the shallow trench isolation structure may include a trench, and
a range of distribution of the diffusion-suppressing species in the first specific layer of at least either of the two first peripheral transistors may be shallower than a bottom of the trench.

The configuration of the twentieth aspect is an example of a configuration of the imaging device.

In a twenty-first aspect of the present disclosure, for example, the imaging device according to any one of the first to twentieth aspects may further comprise a second peripheral region including a second peripheral substrate portion and a second peripheral transistor provided in the second peripheral substrate portion,
the signals may be transmitted between the first peripheral region and the pixel region via the second peripheral region,
the second peripheral transistor may include a gate,
the gate length of the at least one first peripheral transistor may be shorter than a gate length of the second peripheral transistor,
the gate length of the pixel transistor may be longer than the gate length of the second peripheral transistor, and
the second peripheral transistor may further include, in the second peripheral substrate portion, a second source, a second drain, a second channel region, located between the second source and the second drain, through which carriers migrate, and a second strain-introducing layer that brings a strain to the second channel region.

The technique according to the twenty-first aspect is suitable to improving the performance of an imaging device.

In a twenty-second aspect of the present disclosure, for example, in the imaging device according to the twenty-first aspect,
the second peripheral substrate portion may include a second foundation layer that is adjacent to the second strain-introducing layer, and
a lattice constant of a crystal lattice of the second strain-introducing layer may be different from a lattice constant of a crystal lattice of the second foundation layer.

The technique according to the twenty-second aspect is suitable to improving the performance of an imaging device.

In a twenty-third aspect of the present disclosure, for example, in the imaging device according to the twenty-first or twenty-second aspect, at least one selected from the group consisting of the second channel region, the second source, and the second drain may include the second strain-introducing layer.

The configuration of the twenty-third aspect is an example of a configuration of the imaging device.

In a twenty-fourth aspect of the present disclosure, for example, in the imaging device according to any one of the twenty-first to twenty-third aspects,
the pixel transistor may further include a pixel gate insulator film,
the at least one first peripheral transistor may further include a first peripheral gate insulator film,
the second peripheral transistor may further include a second peripheral gate insulator film,
the first peripheral gate insulator film may be thinner than the second peripheral gate insulator film, and
the pixel gate insulator film nay be thicker than the second peripheral gate insulator film.

The configuration of the twenty-fourth aspect is an example of a configuration of the imaging device.

In a twenty-fifth aspect of the present disclosure, for example, in the imaging device according to any one of the first to twenty-fourth aspects,
the first peripheral region may be located outside the pixel region, and
the pixel substrate portion and the first peripheral substrate portion may be included in a single semiconductor substrate.

The configuration of the twenty-fifth aspect is an example of a configuration of the imaging device.

In a twenty-sixth aspect of the present disclosure, for example, in the imaging device according to any one of the first to twenty-fourth aspects, the pixel substrate portion and the first peripheral substrate portion may be stacked on top of each other.

The configuration of the twenty-sixth aspect is an example of a configuration of the imaging device.

The techniques of the first to twenty-sixth aspects may be combined as appropriate, provided no contradictory arises.

The following describes embodiments of the present disclosure in detail with reference to the drawings. It should be noted that the embodiments to be described below each illustrate a comprehensive and specific example. The numerical values, shapes, materials, constituent elements, placement and topology of constituent elements, steps, orders of steps, or other features that are shown in the following embodiments are just a few examples and are not intended to limit the present disclosure. The various aspects described herein may be combined with each other, provided no contradiction arises. Further, those of the constituent elements in the following embodiments which are not recited in an independent claim reciting the most superordinate concept are described as optional constituent elements.

In the following description, constituent elements having substantially the same functions are denoted by common reference signs, and a description of such constituent elements may be omitted. Further, for the avoidance of an overly complex drawing, an illustration of some elements may be omitted. Regarding various elements of an imaging device, dimensions, outward appearances, or other features depicted in the drawings may be different from the dimensions and outward appearances of an actual imaging device. That is, the accompanying drawings are only schematic views for understanding of the present disclosure and do not necessarily rigorously reflect the scale or other features of an actual imaging device.

The term "plan view" herein means a view as seen from a direction perpendicular to a first semiconductor substrate, a second semiconductor substrate, a third semiconductor substrate, a pixel substrate portion, a first peripheral substrate portion, or a second peripheral substrate portion. Terms such as "above", "below", "top", and "bottom" herein are used to designate the mutual arrangement of members, and are not used to limit the attitude of the imaging device during use.

The expression "substrate", as in "supporting substrate", "semiconductor substrate", or the like, is sometimes used herein. The substrate is not limited to a particular structure or manufacturing method. The substrate may have a single-layer structure or may have a stacked structure. The stacked structure may include, for example, a semiconductor layer, an insulating layer, or other layers. The substrate may be a wafer obtained by slicing an ingot, may be a film deposited by sputtering or other processes, or may be a film grown by epitaxial growth. The substrate may be a plate-like body that is used in a chip stack structure. Further, the substrate may be a plate-like body that is used in a stacked structure that is manufactured by a three-dimensional stacking technology 3DSI (3D Sequential Integration) so called Sequential 3D. The term "direction parallel with the depth of a substrate" can be read as "direction parallel with the thickness of a substrate".

The term "carrier mobility" herein means an index that represents the ease with which charged carriers migrate. The carrier mobility µ is given by µ = v/E, where E is an electric field that is applied to carriers and v is a component of the average velocity of the carriers in the direction of this electric field. The carriers are electrons or holes.

The term "single crystal" herein means a crystal all portions of which have a common crystal axis.

The term "epitaxial layer" herein means a layer formed by epitaxial growth.

Expressions such as "crystal layer of silicon germanium", "crystal layer of germanium", "crystal layer of a Group III-V compound", "crystal layer of silicon carbide", "crystal layer of transition metal dichalcogenide", "crystal layer of carbon nanotubes, and "a single crystal layer of silicon" may be used herein. A crystal layer of silicon germanium is a crystal layer in which silicon germanium accounts for 90wt% or more of the material total mass. The same applies to the crystal layer of germanium, the crystal layer of a Group III-V element, the crystal layer of silicon carbide, the crystal layer of transition metal dichalcogenide, the crystal layer of carbon nanotubes, the single crystal layer of silicon, or other crystal layers.

The expression "crystal layer of Si₁₋ₓGeₓ" may be used herein. The crystal layer of Si₁₋ₓGeₓ is a crystal layer in which silicon germanium accounts for 90wt% or more of the material total mass and the molar ratio of silicon to germanium in silicon germanium is 1-X:X.

The concept "extension diffusion layer" herein encompasses a so-called LDD (lightly-doped drain) diffusion layer.

A threshold voltage of a transistor herein refers to a gate-source voltage of the transistor at which a drain current starts to flow through the transistor.

There is herein an expression "the gate length of a peripheral transistor is shorter than the gate length of a pixel transistor". This expression may be supplemented with "at least one", as in "the gate length of at least one peripheral transistor is shorter than the gate length of at least one pixel transistor". In the expression thus supplemented, all peripheral transistors and pixel transistors that are present in an imaging device satisfy this magnitude relationship. The same applies to an expression regarding a magnitude relationship between the sizes of other elements. The same also applies to a magnitude relationship between the concentrations of impurities such as carbon. The same also applies to a magnitude relationship between an element of a first peripheral transistor and a second peripheral transistor.

There is herein an expression "conductive impurity". The conductive impurity is an impurity having a conductivity type. That is, the conductive impurity is a p-type or n-type impurity. The conductive impurity may be a p-type impurity. Examples of p-type impurities include boron (B), gallium (Ga), and indium (In). Further, the conductive impurity may be an n-type impurity. Examples of n-type impurities include phosphorus (P), arsenic (As), antimony (Sb), and bismuth (Bi).

There is herein an expression "concentration of a conductive impurity". In a case where the conductive impurity is constituted by plural types of impurity, the concentration of the conductive impurity refers to the total concentration of those plural types of impurity. In this respect, the same applies to the concentration of a diffusion-suppressing species, an amorphizing species, or other species.

There are herein expressions "first conductivity type" and "second conductivity". A conductive impurity of the first conductivity type is an n-type impurity or a p-type impurity. A conductive impurity of the second conductivity type is an impurity that is opposite in conductivity type to the conductive impurity of the first conductivity type. The conductive impurity of the second conductivity type is a p-type impurity or an n-type impurity. A transistor of the first conductivity type is an N-channel transistor or a P-channel transistor. A transistor of the second conductivity type is a transistor that is opposite in conductivity type to the transistor of the first conductivity type. The transistor of the second conductivity type is a P-channel transistor or an N-channel transistor.

The expression "an element A includes an element B" may be used herein. This expression is an expression intended to encompass an aspect in which the element A includes part of the element B and an aspect in which the element A includes all of the element B.

As in the case of an analog processor, a digital processor, or other processors, the expression "processor" may be used herein. The processor may be a processing circuit.

### (Embodiment 1)

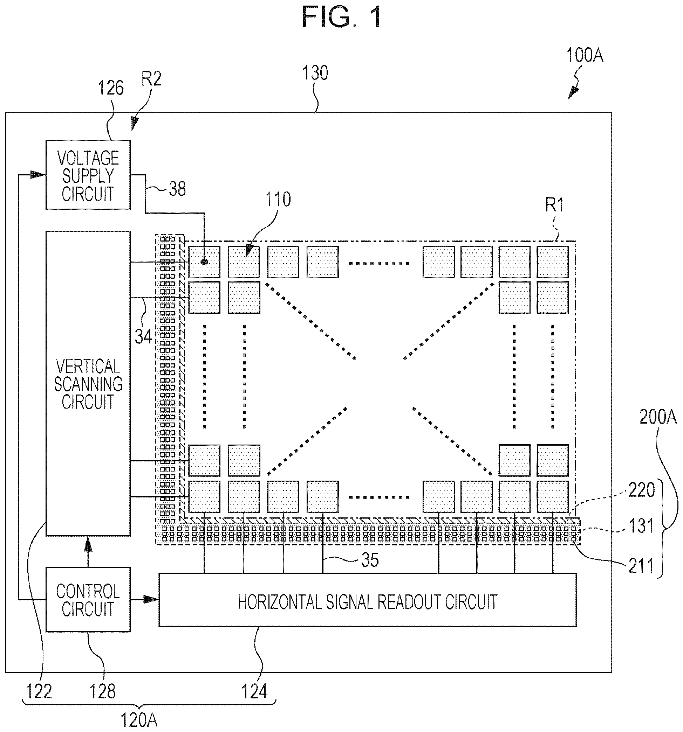

The following describes Embodiment 1 of the present disclosure with reference to Figs. 1 to 33.

Fig. 1 schematically shows an exemplary configuration of an imaging device 100A according to Embodiment 1 of the present disclosure. The imaging device 100A shown in Fig. 1 has a plurality of pixels 110 arrayed, for example, in a plurality of rows and columns. In the configuration illustrated in Fig. 1, the pixels 110 are arrayed in m rows and n columns and form a pixel region R1 having a substantially rectangular shape. Note here that m and n each independently represent an integer greater than or equal to 1.

In Embodiment 1, each of the plurality of pixels 110 has a photoelectric converter and a readout circuit. The photoelectric converter is supported by a semiconductor substrate 130. The readout circuit is formed in the semiconductor substrate 130 and electrically connected to the photoelectric converter. Each of the plurality of pixels 110 includes an impurity region, provided in the semiconductor substrate 130, that functions as part of a charge accumulation region that temporarily retains signal charge generated by the photoelectric converter. It is possible to, instead of providing such a photoelectric converter, provide a photodiode as a photoelectric converter in the semiconductor substrate.

The imaging device 100A further has a peripheral circuit 120A. The peripheral circuit 120A drives the plurality of pixels 110. In the example shown in Fig. 1, the peripheral circuit 120A includes a vertical scanning circuit 122, a horizontal signal readout circuit 124, a voltage supply circuit 126, and a control circuit 128. In Embodiment 1, some or all of these circuits are formed in the semiconductor substrate 130 as is the case with the readout circuit of each pixel. As schematically shown in Fig. 1, the peripheral circuit 120A is located in a first peripheral region R2 of the semiconductor substrate 130. The first peripheral region R2 is located outside a pixel region R1 including the plurality of pixels 110.

The imaging device 100A further has a blocking region 200A. The blocking region 200A is provided between the pixel region R1 and the first peripheral region R2. As schematically shown in Fig. 1, the blocking region 200A includes an impurity region 131 and a plurality of contact plugs 211. The impurity region 131 is provided in the semiconductor substrate 130. The plurality of contact plugs 211 are provided over the impurity region 131. The impurity region 131 is typically a P-type diffusion region.

By being provided over the impurity region 131, the plurality of contact plugs 211 are electrically connected to the impurity region 131. As will be mentioned later, by being connected to a power source (not illustrated in Fig. 1), the plurality of contact plugs 211 are configured such that a predetermined voltage can be supplied to the impurity region 131. That is, during operation of the imaging device 100A, the impurity region 131 is in a state in which a predetermined voltage is applied to the impurity region 131 via the contact plugs 211.

Further, the blocking region 200A has a device isolation 220. The device isolation 220 is a structure formed in the semiconductor substrate 130, for example, by a STI (shallow trench isolation) process. The device isolation 220 has a portion of the semiconductor substrate 130 located at least between ones of the plurality of pixels 110 located on the outermost periphery of the pixel region R1 and a digital circuit, such as the vertical scanning circuit 122, that operates in accordance with a digital clock. In this example, the device isolation 220 is located between pixels 110 located on the outermost periphery of the pixel region R1 and the vertical scanning circuit 122 and between pixels 110 located on the outermost periphery of the pixel region R1 and the horizontal signal readout circuit 124. A will be mentioned later, the device isolation 220 may be provided in the semiconductor substrate 130 so as to surround the pixel region R1 in a top view. The device isolation 220 is equivalent to the shallow trench isolation structure in the present disclosure.

In a configuration in which a peripheral circuit including a circuit that operates in accordance with a digital clock is formed in a semiconductor substrate provided with an impurity region that temporarily retains signal charge that is obtained by photoelectric conversion, the circuit that operates on a digital clock may become a noise source that generates noise every time an input pulse rises and falls. More specifically, the potential of a signal line through which a digital clock is supplied to a digital circuit typified by a CMOS logic circuit fluctuates according to the digital clock. The fluctuations in potential of the signal line due to the digital clock may become a factor for causing fluctuations in substrate potential and, as a result, generating excess charge in a well inside the semiconductor substrate. If the excess charge attributed to the fluctuations in substrate potential flows into an impurity region in a pixel that retains signal charge, there will be a decline in S/N ratio, causing a deterioration in a resulting image.

On the other hand, in the imaging device 100A shown in Fig. 1, the blocking region 200A, which includes the impurity region 131 configured to be connectable to a power source such as a ground by being provided with the plurality of contact plugs 211, is disposed between the pixel region R1, which includes the plurality of pixels 110, and a digital circuit. During operation of the imaging device 100A, the potential of the impurity region 131 of the blocking region 200A can be fixed by connecting a predetermined voltage source to the plurality of contact plugs 211. For example, the potential of the impurity region 131 of the blocking region 200A may be grounded via the plurality of contact plugs 211. At this point in time, the blocking region 200A functions as a low-impedance path through which excess charge generated inside the semiconductor substrate 130 is discharged. That is, electrostatic coupling between an impurity region in a pixel that retains signal charge and the peripheral circuit 120A can be suppressed. This makes it possible to advantageously reduce dark current whose noise source is a signal line through which a digital clock is supplied. Note, however, that the blocking region 200A is not essential.

Details of the circuits constituting the peripheral circuit 120A are given here. The vertical scanning circuit 122 has connections with a plurality of address signal lines 34. These address signal lines 34 are provided separately in correspondence with each of the rows of pixels 110. Each address signal line 34 is connected to one or more pixels 110 belonging to the corresponding row. The vertical scanning circuit 122 controls the timing of readout of signals from the pixels 110 to the after-mentioned vertical signal lines 35 by applying row selecting signals to the address signal lines 34. The vertical scanning circuit 122 is also called "row scanning circuit". It should be noted that the address signal lines 34 are not the only signal lines that are connected to the vertical scanning circuit 122. Plural types of signal line may be connected to the vertical scanning circuit 122 for each row of pixels 110.

As schematically shown in Fig. 1, the imaging device 100A also has a plurality of vertical signal lines 35. The vertical signal lines 35 are provided separately for each of the columns of pixels 110. Each vertical signal line 35 is connected to one or more pixels 110 belonging to the corresponding column. These vertical signal lines 35 are connected to the horizontal signal readout circuit 124. The horizontal signal readout circuit 124 sequentially output signals read out from the pixels 110 to output lines (not illustrated in Fig. 1). The horizontal signal readout circuit 124 is also called "column scanning circuit".

The control circuit 128 exercises overall control of the imaging device 100A upon receiving command data, clocks, or other signals that are supplied, for example, from outside the imaging device 100A. The control circuit 128 typically has a timing generator and supplies driving signals to the vertical scanning circuit 122, the horizontal signal readout circuit 124, the after-mentioned voltage supply circuit 126, or other circuits. In Fig. 1, arrows extending from the control circuit 128 schematically express the flow of output signals from the control circuit 128. The control circuit 128 may be implemented, for example, by a microcontroller including one or more processors. The functions of the control circuit 128 may be implemented by a combination of a general-purpose circuit and software, or may be implemented by hardware specialized in such processing.

In Embodiment 1, the peripheral circuit 120A includes the voltage supply circuit 126, which is electrically connected to each pixel 110 in the pixel region R1. The voltage supply circuit 126 supplies a predetermined voltage to a pixel 110 via a voltage line 38. The voltage supply circuit 126 is not limited to a particular power-supply circuit. The voltage supply circuit 126 may be a circuit that converts a voltage supplied from a power source such as a battery into a predetermined voltage, or may be a circuit that generates a predetermined voltage. The voltage supply circuit 126 may be part of the aforementioned vertical scanning circuit 122. As schematically shown in Fig. 1, these circuits constituting the peripheral circuit 120A are disposed in the first peripheral region R2 outside the pixel region R1.

It should be noted that the number and placement of the pixels 110 are not limited to the illustrated example. For example, the number of pixels 110 that are included in the imaging device 100A may be 1. Although, in this example, the center of each pixel 110 is located at a lattice point of a tetragonal lattice, the plurality of pixels 110 may be placed so that the center of each pixel 110 is located at a lattice point of a triangular lattice, a hexagonal lattice, or other lattices. For example, the pixels 110 may be arrayed one-dimensionally, and in this case, the imaging device 100A may be utilized as a line sensor.

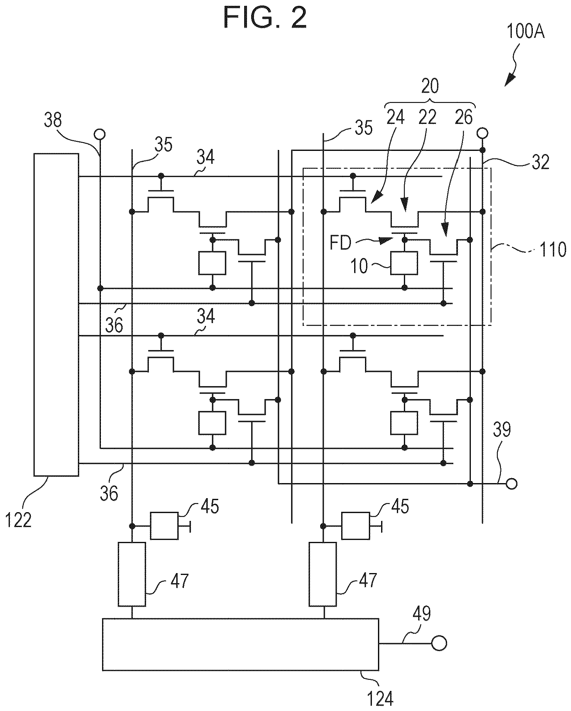

Fig. 2 is a diagram schematically showing an exemplary circuit configuration of the imaging device 100A shown in Fig. 1. For the avoidance of an overly complex drawing, Fig. 2 illustrates only four of the plurality of pixels 110 arrayed in two rows and two columns. Each of these pixels 110 includes a photoelectric converter 10 supported by the semiconductor substrate 130 and a readout circuit 20 electrically connected to the photoelectric converter 10. As will be described in detail later with reference to the drawings, the photoelectric converter 10 includes a photoelectric conversion layer disposed above the semiconductor substrate 130. The photoelectric converter 10 may also be referred to as "photoelectric conversion structure".

By having a connection with the voltage line 38, which is connected to the voltage supply circuit 126, the photoelectric converter 10 of each pixel 110 is configured such that a predetermined voltage can be applied via the voltage line 38 during operation of the imaging device 100A. For example, in a case where of positive and negative charge generated by photoelectric conversion, the positive charge is utilized as signal charge, a positive voltage of, for example, approximately 10 V may be applied to the voltage line 38 during operation of the imaging device 100A. The following illustrates a case where a hole is utilized as signal charge.

In the configuration illustrated in Fig. 2, the readout circuit 20 includes an amplifying transistor 22, an address transistor 24, and a reset transistor 26. The amplifying transistor 22, the address transistor 24, and the reset transistor 26 are typically field-effect transistors formed in the semiconductor substrate 130. Unless otherwise noted, the following describes an example involving the use of N-channel MOSFETs (metal-oxide semiconductor field-effect transistors) as the transistors.

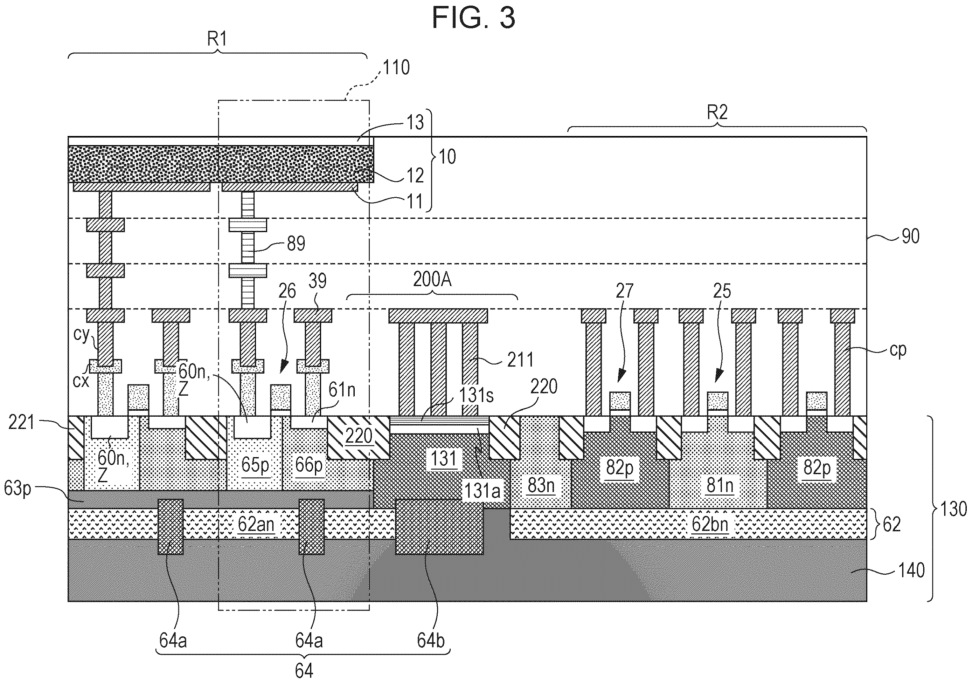

As schematically shown in Fig. 2, the amplifying transistor 22 has its gate electrically connected to the photoelectric converter 10. A hole can for example be accumulated as signal charge in a charge accumulation node FD by applying a predetermined voltage to the photoelectric converter 10 of each pixel 110 from the voltage supply circuit 126 via the voltage line 38 during operation. Note here that the charge accumulation node FD is a node at which the gate of the amplifying transistor 22 is connected to the photoelectric converter 10. The charge accumulation node FD has a function of temporarily retaining charge generated by the photoelectric converter 10. The charge accumulation node FD includes as part thereof an impurity region formed in the semiconductor substrate 130. A charge accumulation region Z of Fig. 3, which will be described later, corresponds to the impurity region included in the charge accumulation node FD.

As shown in Fig. 2, the amplifying transistor 22 of each pixel 110 has its drain connected to a power-supply wire 32. The power-supply wire 32 supplies a power-supply voltage VDD to the amplifying transistor 22 during operation of the imaging device 100A. The power-supply voltage VDD is for example approximately 3.3 V. On the other hand, the amplifying transistor 22 has its source connected to a vertical signal line 35 via the address transistor 24. By having its drain supplied with the power-supply voltage VDD, the amplifying transistor 22 outputs a signal voltage corresponding to the amount of signal charge accumulated in the charge accumulation node FD.

The address transistor 24 is connected between the amplifying transistor 22 and the vertical signal line 35. The address transistor 24 has its gate connected to an address signal line 34. The vertical scanning circuit 122 controls the turning on and turning off of the address transistor 24 by applying a row-selecting signal to the address signal line 34. That is, by controlling a row-selecting signal, the vertical scanning circuit 122 allows an output from the amplifying transistor 22 of a selected pixel 110 to be read out to the corresponding vertical signal line 35. Without being limited to the example shown in Fig. 2, the address transistor 24 may be disposed between the drain of the amplifying transistor 22 and the power-supply wire 32.

Each of the vertical signal lines 35 is connected to a load circuit 45 and a column signal processing circuit 47. The load circuit 45 forms a source-follower circuit with the amplifying transistor 22. The column signal processing circuit 47 executes noise suppression signal processing, analog-digital conversion, or other processing. The noise suppression signal processing is for example correlated double sampling. The column signal processing circuit 47 is also called "row signal accumulation circuit". The horizontal signal readout circuit 124 sequentially reads out signals from a plurality of the column signal processing circuits 47 to a horizontal common signal line 49. The column signal processing circuit 47 may be part of the horizontal signal readout circuit 124. The load circuit 45 and the column signal processing circuit 47 may be part of the aforementioned peripheral circuit 120A.

In this example, the readout circuit 20 includes the reset transistor 26 in addition to the amplifying transistor 22 and the address transistor 24. A first one of a drain and a source of the reset transistor 26 is part of the charge accumulation node FD. A second one of the drain and the source is connected to a reset voltage line 39. The first one of the drain and the source of the reset transistor 26 corresponds to the charge accumulation region Z of Fig. 3 and, specifically, to an impurity region 60n. The reset voltage line 39 has a connection with a reset voltage supply circuit (not illustrated in Fig. 2). As a result of this, a predetermined reset voltage Vref may be supplied to the reset transistor 26 of each pixel 110 during operation of the imaging device 100A. The reset voltage Vref is for example a voltage of 0 V or nearly 0 V. As is the case with the aforementioned voltage supply circuit 126, the reset voltage supply circuit needs only be able to apply the reset voltage Vref to the reset voltage line 39, and is not limited in specific configuration to a particular power-supply circuit. The reset voltage supply circuit may be part of the vertical scanning circuit 122. The voltage supply circuit 126 and the reset voltage supply circuit may be independent separate circuits, or may be in the form of a single voltage supply circuit disposed in the imaging device 100A. The reset voltage supply circuit too may be part of the aforementioned peripheral circuit 120A.

The reset transistor 26 has its gate connected to a reset signal line 36. As is the case with the address signal lines 34, these reset signal lines 36 are provided separately for each of the rows of pixels 110 and, in this example, are connected to the vertical scanning circuit 122. As mentioned above, by applying row-selecting signals to the address signal lines 34, the vertical scanning circuit 122 can select, on a row-by-row basis, pixels 110 to which signals are to be read out. Similarly, by applying reset signals to the gates of the reset transistors 26 via the reset signal lines 36, the vertical scanning circuit 122 can turn on a selected row of reset transistors 26. The turning on of the reset transistors 26 causes the potentials of the charge accumulation nodes FD to be reset.

### (Pixels and Blocking Region)

Fig. 3 schematically shows a cross-section including the pixel region R1, the first peripheral region R2, and the blocking region 200A. This is a cross-section of two representative ones of the plurality of pixels 110 located near the blocking region 200A.

First, attention is focused on the pixel region R1. The pixel region R1 is provided with a photoelectric conversion layer 12. The photoelectric conversion layer 12 is supported by the semiconductor substrate 130. Over the photoelectric conversion layer 12, a counter electrode 13 having translucency is disposed. As shown in Fig. 3, the photoelectric conversion layer 12 and the counter electrode 13 are each typically successively provided above the semiconductor substrate 130 across the plurality of pixels 110.

The pixels 110 are unit structures that constitute the pixel region R1. The pixels 110 each include a photoelectric converter 10. The photoelectric converter 10 has part of the photoelectric conversion layer 12, part of the counter electrode 13, and a pixel electrode 11. The pixel electrode 11 of the photoelectric converter 10 is located between the photoelectric conversion layer 12 and the semiconductor substrate 130. The pixel electrode 11 is formed from metal such as aluminum or copper, a metal nitride, polysilicon given electrical conductivity by being doped with an impurity, or other substances. As schematically shown in Fig. 3, the pixel electrode 11 of each pixel 110 is electrically separated from the pixel electrode 11 of another adjacent pixel by spatial separation of one pixel from another.

The photoelectric conversion layer 12 of the photoelectric converter 10 is formed from an organic material or an inorganic material. Examples of inorganic materials include amorphous silicon and quantum dots. The photoelectric conversion layer 12 generates positive and negative charge through photoelectric conversion upon receiving incident light via the counter electrode 13. That is, the photoelectric converter 10 has a function of converting light into charge. The photoelectric conversion layer 12 may include a layer composed of an organic material and a layer composed of an inorganic material.

The counter electrode 13 of the photoelectric converter 10 is formed from a transparent conducting material such as ITO (indium tin oxide). The term "translucency" herein means allowing passage of at least a portion of light of a wavelength that the photoelectric conversion layer 12 can absorb, and it is not essential to allow passage of light across the whole range of wavelengths of visible light. Although not illustrated in Fig. 3, the counter electrode 13 has a connection with the aforementioned voltage line 38. During operation of the imaging device 100A, the potential of the voltage line 38 is controlled so that the potential of the counter electrode 13 becomes for example higher than the potential of the pixel electrode 11. As a result of this, of positive and negative charge generated by photoelectric conversion, the positive charge can be selectively collected by the pixel electrode 11. Forming the counter electrode 13 in the shape of a single layer extending across the plurality of pixels 110 makes it possible to apply a predetermined potential to the counter electrode 13 of the plurality of pixels 110 en bloc via the voltage line 38.

Each of the plurality of pixels 110 further includes part of the semiconductor substrate 130. As schematically shown in Fig. 3, the semiconductor substrate 130 has a plurality of the impurity regions 60n as first impurity regions near a surface thereof. The impurity region 60n functions as a first one of the drain and the source of the reset transistor 26, which is included in the aforementioned readout circuit 20. Further, the semiconductor substrate 130 also has an impurity region 61n serving as a second one of the drain and the source of the reset transistor 26. As schematically shown in Fig. 3, the impurity region 61n is connected to the aforementioned reset voltage line 39 via a polysilicon plug or other plugs. In this example, the impurity region 60n and the impurity region 61n have an n-type conductivity type. These impurity regions 60n and 61n are typically n-type diffusion regions.

As can be understood from the foregoing, in the semiconductor substrate 130, a plurality of the readout circuits 20 are formed in correspondence with the plurality of pixels 110. The readout circuit 20 of each pixel is electrically separated from the readout circuit 20 of another pixel by a device isolation 220 provided in the semiconductor substrate 130.

As shown in Fig. 3, an interlayer insulating layer 90 covering the semiconductor substrate 130 is located between the photoelectric converter 10 and the semiconductor substrate 130. The interlayer insulating layer 90 generally includes a plurality of insulating layers and a plurality of wiring layers. The plurality of wiring layers disposed in the interlayer insulating layer 90 may include a wiring layer having the address signal lines 34, the reset signal lines 36, or other wires as part thereof, a wiring layer having the vertical signal line 35, the power-supply wire 32, the reset voltage line 39, or other wires as part thereof, or other wiring layers. The numbers of insulating layers and wiring layers in the interlayer insulating layer 90 are not limited to this example but may be arbitrarily set.

The interlayer insulating layer 90 has provided therein a conducting structure 89 electrically connecting the pixel electrode 11 of the photoelectric converter 10 to the readout circuit 20, which is formed in the semiconductor substrate 130. As schematically shown in Fig. 3, the conducting structure 89 includes a wire and a via that are disposed in the interlayer insulating layer 90. The wire and the via are typically formed from metal such as copper or tungsten or a metal compound such as a metal nitride or a metal oxide. The conducting structure 89 also includes a contact plug cx connected to the aforementioned impurity region 60n. The contact plug cx, which is connected to the impurity region 60n, is typically a polysilicon plug, and is doped with an impurity such as phosphorus for superior electrical conductivity. Although not illustrated in Fig. 3, the conducting structure 89 also has an electrical connection with the gate electrode of the amplifying transistor 22. A plug cy is connected to the contact plug cx. Examples of metal that the plug cy may contain include tungsten and copper.

Attention is focused on the semiconductor substrate 130. The semiconductor substrate 130 includes a supporting substrate 140 and one or more semiconductor layers formed over the supporting substrate 140. In the example shown in Fig. 3, the semiconductor substrate 130 has an n-type impurity layer 62 provided over the supporting substrate 140. The following takes a p-type silicon substrate as an example of the supporting substrate 140. The supporting substrate 140 may have a lower electric resistivity than the impurity layer 62. It should be noted that the semiconductor substrate 130 may be an SOI (silicon-on-insulator) substrate, a substrate having an epitaxial layer provided on a surface thereof by epitaxial growth or other processes, or other substrates.

Attention is focused on the pixel region R1 first in the configuration illustrated in Fig. 3. The semiconductor substrate 130 has an n-type semiconductor layer 62an and a p-type semiconductor layer 63p. The n-type semiconductor layer 62an is provided over the supporting substrate 140. The p-type semiconductor layer 63p is provided over the n-type semiconductor layer 62an. The n-type semiconductor layer 62an, which is located between the supporting substrate 140 and p-type semiconductor layer 63p, is part of the aforementioned impurity layer 62. During operation of the imaging device 100A, the potential of the impurity layer 62 is controlled via a well contact (not illustrated in Fig. 3). The impurity layer 62 includes the n-type semiconductor layer 62an, which is located in the pixel region R1, as part thereof and is provided inside the semiconductor substrate 130. This makes it possible to reduce the flow of a small number of carriers from the supporting substrate 140 or the peripheral circuit into a charge accumulation region that accumulates signal charge.

In the configuration illustrated in Fig. 3, the semiconductor substrate 130 further has a p-type semiconductor layer 66p and a p-type impurity region 65p. The p-type semiconductor layer 66p is located over the p-type semiconductor layer 63p. The p-type impurity region 65p is provided in the p-type semiconductor layer 66p. In this example, the aforementioned impurity region 60n, which has a connection with the conducting structure 89, is provided in the p-type impurity region 65p. A junction capacitor that is formed by a p-n junction between the impurity region 60n and the p-type impurity region 65p, which serves as a p well, functions as a capacitor that stores at least a portion of signal charge that is collected by the pixel electrode 11. That is, the impurity region 60n constitutes a charge accumulation region that temporarily retains signal charge. On the other hand, the impurity region 61n is provided in the p-type semiconductor layer 66p. In this example, the p-type impurity region 65p is lower in impurity concentration than the p-type semiconductor layer 66p.

Further, the semiconductor substrate 130 has a plurality of p-type regions 64. The plurality of p-type regions 64 are provided in such a way as to pass completely through the impurity layer 62. The p-type regions 64 have a comparatively high impurity concentration. Providing the p-type regions 64 makes it possible to electrically connect two regions of the same conductivity type separated from each other by the impurity layer 62.

In this example, the plurality of p-type regions 64 include a plurality of p-type regions 64a and one or more p-type regions 64b. The p-type regions 64a are located in the pixel region R1 when seen from a direction normal to the semiconductor substrate 130. The p-type region 64b is located below the plurality of contact plugs 211 of the blocking region 200A. The p-type regions 64a are formed between the p-type semiconductor layer 63p and the supporting substrate 140 in such a way as to pass completely through the n-type semiconductor layer 62an, and electrically connect the p-type semiconductor layer 63p to the supporting substrate 140. On the other hand, the p-type region 64b is electrically connected to the impurity region 131 of the blocking region 200A by having one end reaching the impurity region 131, and electrically connects the impurity region 131 to the supporting substrate 140.

Accordingly, in this example, an electrical path leading from the impurity region 131 of the blocking region 200A to the p-type semiconductor layer 63p via the p-type region 64b, the supporting substrate 140, and the p-type regions 64a is formed in the semiconductor substrate 130. As mentioned above, the plurality of contact plugs 211 are connected to the impurity region 131 of the blocking region 200A, and these contact plugs 211 are configured to be connectable to a power source (not illustrated) such as a ground. For example, the potential of the impurity region 131 of the blocking region 200A can be grounded via the plurality of contact plugs 211. Connecting an appropriate power source to the plurality of contact plugs 211 of the blocking region 200A makes it possible to control the potentials of the p-type impurity region 65p and the p-type semiconductor layer 66p via the p-type semiconductor layer 63p by utilizing an electrical path including the impurity region 131, the p-type region 64b, the supporting substrate 140, and the p-type regions 64a.

In the example shown in Fig. 3, an impurity region 131a that is relatively high in impurity concentration is formed in a portion of the impurity region 131 located near the surface of the semiconductor substrate 130. The contact plugs 211 are typically formed from metal. Providing the impurity region 131a, which is relatively high in impurity concentration in the impurity region 131, and connecting the plurality of contact plugs 211 to the impurity region 131a brings about an effect of reducing contact resistance between the plurality of contact plugs 211 and the impurity region 131.

Furthermore, in this example, a silicide layer 131s is formed between the plurality of contact plugs 211 and the impurity region 131. Providing the silicide layer 131s in a portion of the impurity region 131a near the surface of the semiconductor substrate 130 and connecting the plurality of contact plugs 211 to the silicide layer 131s makes it possible to further reduce the contact resistance.

Next, attention is focused on the first peripheral region R2 of the semiconductor substrate 130. As mentioned above, a circuit for driving the plurality of pixels 110 and a circuit for processing signals read out from the plurality of pixels 110 are formed in the first peripheral region R2. The first peripheral region R2 includes, for example, a plurality of transistors 25 and a first peripheral transistor 27 that constitute a logic circuit such as a multiplexer. As schematically shown in Fig. 3, in this example, an n-type semiconductor layer 62bn that is another part of the impurity layer 62 is formed over the supporting substrate 140, and an n-type impurity region 81n and a p-type impurity region 82p are formed as wells over the n-type semiconductor layer 62bn. Each of the transistors 25 has its drain and source located in the p-type impurity region 82p, and the first peripheral transistor 27 has its drain and source located in the n-type impurity region 81n. It should be noted that the n-type semiconductor layer 62bn is separated by the mediation of part of the supporting substrate 140 from the n-type semiconductor layer 62an all around the pixel region R1. The n-type semiconductor layer 62bn is supplied with a predetermined voltage by being connected to a power source (not illustrated). In the following, the n-type impurity region 81n is sometimes referred to as "n-type well". The p-type impurity region 82p is sometimes referred to as "p-type well".

The depth of the n-type semiconductor layer 62an of the pixel region R1 and the depth of the n-type semiconductor layer 62bn of the first peripheral region R2 may be equal to or different from each other.

In the configuration illustrated in Fig. 3, contact plugs cp are connected to the drain, source, and gate electrodes of peripheral transistors such as the transistors 25 and the first peripheral transistor 27.

In the example shown in Fig. 3, the blocking region 200A further includes an n-type impurity region 83n located near a boundary with the first peripheral region R2. The n-type impurity region 83n is located over the n-type semiconductor layer 62bn of the impurity layer 62, and has an electrical connection with the n-type semiconductor layer 62bn. The n-type impurity region 83n may be provided with a plug. Connecting an appropriate power source to the plug connected to the n-type impurity region 83n makes it possible to control the potentials of the n-type impurity region 83n and the n-type semiconductor layer 62bn.

Each of the impurity layers and impurity regions located above the supporting substrate 140 is formed by ion implantation of an impurity into an epitaxial layer obtained by epitaxial growth over the supporting substrate 140. It should be noted that the p-type regions 64a, which is located in the pixel region R1, of the p-type region 64 may be formed in places that do not overlap the device isolation in the pixels in a plan view.

In the present embodiment, the blocking region 200A is formed between the pixel region R1 and the first peripheral region R2. As mentioned above, the blocking region 200A includes the device isolation 220, which is located between the pixel region R1 and the first peripheral region R2, and the impurity region 131, over which the plurality of contact plugs 211 are disposed. Since the blocking region 200A includes at least the impurity region 131, a so-called gettering effect can be exerted by utilizing a dopant contained in the impurity region 131. For example, it is known that diffusion of a metal impurity into a region in a semiconductor substrate supporting a photoelectric conversion layer in which pixels are disposed causes degradation in image quality. By causing the dopant contained in the impurity region 131 to function as a gettering center, the diffusion of a metal impurity into the charge accumulation region is suppressed, so that degradation in image quality due to the diffusion of the metal impurity may be avoided.

Examples of p-type impurities, i.e. dopants, for silicon substrates include boron, indium, and gallium, and examples of n-type dopants include phosphorus, arsenic, antimony, and bismuth. Of these substances, the p-type dopants are known to be able to exert a gettering effect on most metals and, accordingly, are suitable as dopants for the impurity region 131. In a typical embodiment of the present disclosure, the p type is selected as the conductivity type of the impurity region 131 of the blocking region 200A. For example, disposing the blocking region 200A, which has its impurity region 131 doped with a p-type impurity, between the pixel region R1 and the first peripheral region R2 makes it possible to effectively suppress the diffusion of a metal impurity into the pixel region R1. That is, the diffusion of a metal impurity into the charge accumulation regions of the pixels 110 is suppressed, so that a deterioration in image quality due to the diffusion of the metal impurity can be reduced.

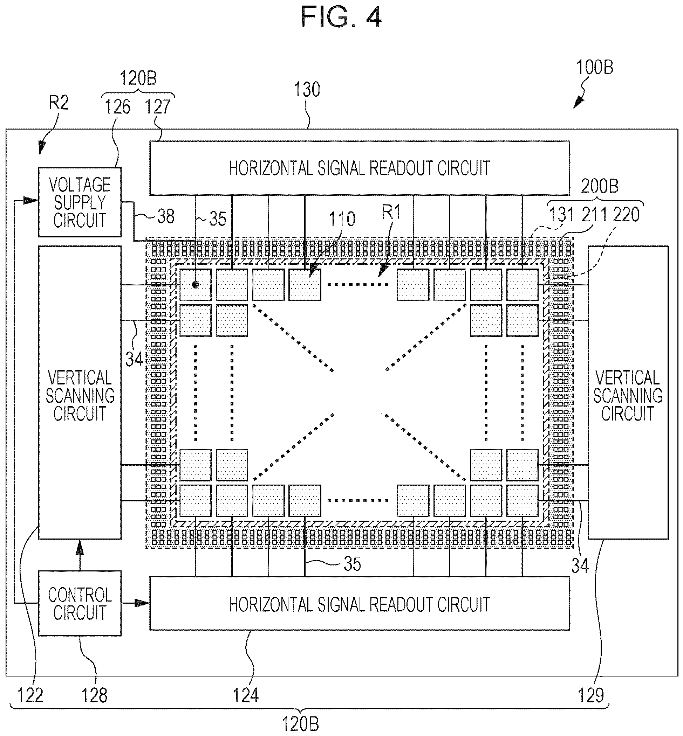

Fig. 4 shows another example of the shape of a blocking region. An imaging device 100B shown in Fig. 4 differs from the imaging device 100A shown in Fig. 1 in that instead of the blocking region 200A, the imaging device 100B has a blocking region 200B surrounding the pixel region R1 in the shape of a rectangle. As compared with the aforementioned blocking region 200A, the impurity region 131 of the blocking region 200B surrounds the pixel region R1 in seamless manners in a circular pattern in a plan view. As schematically shown in Fig. 4, in this example too, the plurality of contact plugs 211 are connected to the impurity region 131. In this example, the device isolation 220 of the blocking region 200B too surrounds the pixel region R1 in seamless manners in a circular pattern inside the impurity region 131. In such a configuration, it may be said that a boundary between the pixel region R1 and the first peripheral region R2 is defined by the device isolation 220.

In this example, a peripheral circuit 120B provided in the first peripheral region R2 includes a second vertical scanning circuit 129 and a second horizontal signal readout circuit 127 in addition to the vertical scanning circuit 122, the horizontal signal readout circuit 124, the voltage supply circuit 126, and the control circuit 128. The vertical scanning circuit 129 is disposed to face the vertical scanning circuit 122 across the pixel region R1. As illustrated, to the vertical scanning circuit 129 too, address signal lines 34 provided separately in correspondence with each of the rows of pixels 110 are connected. Similarly, the horizontal signal readout circuit 127 is disposed to face the horizontal signal readout circuit 124 across the pixel region R1, and to the horizontal signal readout circuit 127, vertical signal lines 35 provided separately in correspondence with each of the columns of pixels 110 are connected.

For example, the vertical scanning circuit 122 is responsible for a row-selecting operation on pixels in the left half of the pixel; region R1, and the vertical scanning circuit 129 is responsible for a row-selecting operation on pixels in the right half of the pixel region R1. Further, the horizontal signal readout circuit 124 is responsible for processing of signals read out from pixels in the lower half of the pixel region R1, and the horizontal signal readout circuit 127 is responsible for processing of signals read out from pixels in the upper half of the pixel region R1. By thus partitioning the pixel region R1 and executing a readout of signals through a plurality of vertical scanning circuits and horizontal signal readout circuits, the speeding up of operations, such as the shortening of frame rates, can be achieved.

In the configuration illustrated in Fig. 4, the vertical scanning circuits 122 and 129 and the horizontal signal readout circuits 124 and 127 are disposed along the four sides of the rectangular shape of the pixel region R1. In other words, in this example, the blocking region 200B is interposed between the vertical scanning circuit 122 and a set of pixels 110, between the vertical scanning circuit 129 and a set of pixels 110, between the horizontal signal readout circuit 124 and a set of pixels 110, and between the horizontal signal readout circuit 127 and a set of pixels 110.

Forming the blocking region 200B in the semiconductor substrate 130 in a shape that surrounds the pixel region R1, which includes an array of pixels 110, in a plan view makes it possible to effectively suppress migration of charge between charge accumulation regions of the pixels and the circuits formed in the first peripheral region R2. It is not essential in the embodiment of the present disclosure that in a case where as in the case of the example shown in Fig. 4, a group of circuits constituting a peripheral circuit is disposed, for example, to surround a rectangular pixel region R1, a blocking region surround the pixel region R1 in seamless manners in a circular pattern in a plan view. For example, a blocking region may include a plurality of portions each including a device isolation 220 and an impurity region 131, and the plurality of portions may be disposed as a whole to surround the pixel region R1. Such a configuration too is expected to bring about effects which are similar to those which are brought about in a case where a blocking region is provided in such a way as to surround the pixel region R1 in seamless manners in a circular pattern in a plan view. Further, the blocking region 200B is not indispensable.

### (Transistor of First Peripheral Region R2)

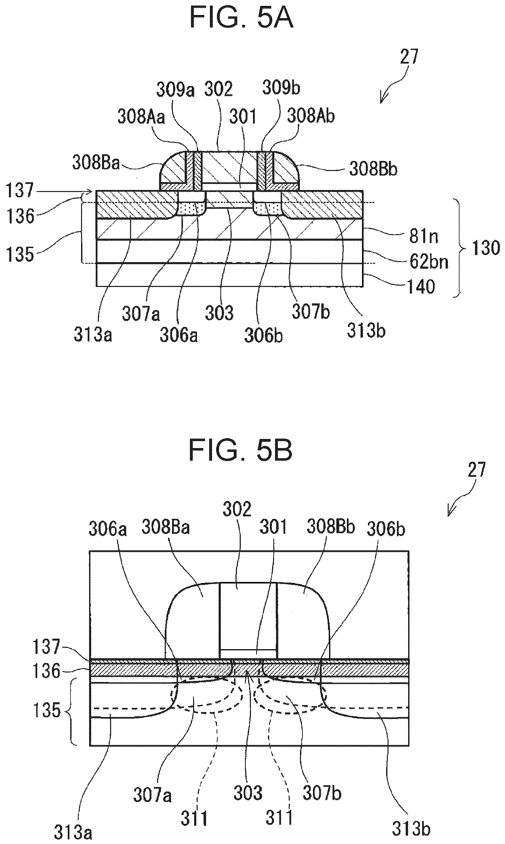

As noted above, the first peripheral region R2 includes the first peripheral transistor 27. The following describes a configuration example of the first peripheral transistor 27 according to the embodiment with reference to Figs. 5A to 15.

### [First Configuration Example]

Fig. 5A shows a cross-sectional configuration of a first peripheral transistor 27 according to a first configuration example. Fig. 5B is a schematic cross-sectional view for explaining a region in the first peripheral transistor 27 according to the first configuration example where carbon is distributed. The following describes the first configuration example with reference to Figs. 5A and 5B. It should be noted that Fig. 5B omits to illustrate elements such as first side walls 308Aa and 308Ab and offset spacers 309a and 309b.

The first peripheral transistor 27 according to the first configuration example is specifically a MIS transistor, more specifically a MOSFET. Further, this first peripheral transistor 27 is a P-channel transistor.

As shown in Figs. 5A and 5B, for example, a gate insulator film 301 composed of silicon oxide (SiO₂) is interposed between a principal surface of a semiconductor substrate 130 and a gate electrode 302 composed of polysilicon or gate metal and formed over the principal surface. The semiconductor substrate 130 has formed in an upper part thereof an N-channel diffusion layer 303 in which, for example, arsenic (As) is diffused and the N-type impurity region 81n, which is an N-type well in which, for example, arsenic (As) and phosphorus (P) are diffused and that is greater in junction depth than the N-type channel diffusion layer 303. In the semiconductor substrate 130, the supporting substrate 140, the n-type semiconductor layer 62bn, and the impurity region 81n, which is an N-type well, are stacked in this order.

In regions in the N-type channel diffusion layer 303 along a gate length, first extension diffusion layers 306a and 306b and first pocket diffusion layers 307a and 307b under the first extension diffusion layers 306a and 306b are formed, respectively. The first extension diffusion layers 306a and 306b are P-type extension high-concentration diffusion layers in which a P-type impurity such as boron (B) is diffused and that have comparatively shallow junctions. The first pocket diffusion layers 307a and 307b are N-type pocket diffusion layers in which an N-type impurity such as arsenic (As) is diffused.

In regions in the semiconductor substrate 130 outside the first extension diffusion layers 306a and 306b, a p-type source diffusion layer 313a and a p-type drain diffusion layer 313b are formed. The p-type source diffusion layer 313a and the p-type drain diffusion layer 313b are connected to the first extension diffusion layers 306a and 306b, and are greater injunction depth than the first extension diffusion layers 306a and 306b.

The supporting substrate 140 is a silicon substrate. Specifically, the supporting substrate 140 is a p-type silicon substrate.

A first epitaxial layer 135 is formed over the supporting substrate 140. In this example, the first epitaxial layer 135 is a silicon (Si) layer.

A second epitaxial layer 136 is formed over the first epitaxial layer 135. The second epitaxial layer 136 is a silicon-germanium (SiGe) layer.

A third epitaxial layer 137 is formed over the second epitaxial layer 136. The third epitaxial layer 137 constitutes a surface of the semiconductor substrate 130. The third epitaxial layer 137 is a silicon (Si) layer. The third epitaxial layer 137 may be referred to as "cap layer".

The supporting substrate 140, the first epitaxial layer 135, the second epitaxial layer 136, and the third epitaxial layer 137 are stacked in this order. In this example, the second epitaxial layer 136 is thinner than the first epitaxial layer 135. The third epitaxial layer 137 is thinner than the second epitaxial layer 136.

The first epitaxial layer 135 includes the n-type semiconductor layer 62bn and the n-type impurity region 81n. The first epitaxial layer 135 includes the N-type channel diffusion layer 303. The first epitaxial layer 135 includes the first pocket diffusion layer 307a and the first pocket diffusion layer 307b. The first epitaxial layer 135 includes the p-type source diffusion layer 313a and the p-type drain diffusion layer 313b.

The second epitaxial layer 136 includes the N-type channel diffusion layer 303. A portion of the second epitaxial layer 136 included in the N-type channel diffusion layer 303 constitutes a cSiGe (channel SiGe) layer. The second epitaxial layer 136 includes the first extension diffusion layer 306a and the first extension diffusion layer 306b. The second epitaxial layer 136 includes the p-type source diffusion layer 313a and the p-type drain diffusion layer 313b.

The third epitaxial layer 137 includes the N-type channel diffusion layer 303. The third epitaxial layer 137 includes the first extension diffusion layer 306a and the first extension diffusion layer 306b. The third epitaxial layer 137 includes the p-type source diffusion layer 313a and the p-type drain diffusion layer 313b.

As can be understood from the foregoing description, in the N-type channel diffusion layer 303 according to the first configuration example, the first epitaxial layer 135, which is made of silicon, and the second epitaxial layer 136, which is made of silicon germanium, are bonded to each other. Silicon and silicon germanium have different lattice constants. Specifically, the lattice constant of the silicon-germanium layer is greater than the lattice constant of the silicon layer, and a compression strain is applied to the silicon substrate. This causes a compression strain on the N-type channel diffusion layer 303. The compression strain brings about improvement in the carrier mobility of the P-channel transistor. This may improve the driving force of the first peripheral transistor 27 and increase the speed of operation of the first peripheral transistor 27. This brings about improvement in the characteristics of the first peripheral transistor 27. Further, this is advantageous from the point of view of reducing the area of the first peripheral region R2. In the first configuration example, the second epitaxial layer 136 is equivalent to a first strain-introducing layer.

The compression strain is further described. The first epitaxial layer 135 is a Si layer obtained by epitaxially growing Si. In this Si layer, Si is a constituent element of a crystal lattice. The second epitaxial layer 136 is a cSiGe layer obtained by epitaxially growing SiGe. In this cSiGe layer, SiGe is a constituent element of a crystal lattice. For this reason, the difference in material of the layers between Si and SiGe causes the difference in lattice constant between the layers. The difference in lattice constant brings about the compression strain.

Furthermore, in the first configuration example, a quantum-confined effect based on the second epitaxial layer 136 may be expressed. This quantum-confined effect too may bring about improvement in the characteristics of the first peripheral transistor 27. The improvement in the characteristics by the quantum-confined effect is easily seen in a case where the second epitaxial layer 136 is thin and the concentration of germanium in the second epitaxial layer 136 is high.

The first extension diffusion layers 306a and 306b may contain carbon (C). Carbon (C) may suppress induced transient enhanced diffusion (hereinafter abbreviated as "TED") of boron. This makes it possible to keep shallow impurity concentration profiles in the first extension diffusion layers 306a and 306b. This is advantageous from the point of view of achieving the first peripheral transistor 27 with increased driving force.

Carbon also makes it possible to suppress phosphorus-induced TED. For example, the N-type channel diffusion layer 303 and the first pocket diffusion layers 307a and 307b may contain phosphorus and carbon. In this configuration example, TED of phosphorus may be suppressed by carbon in the N-type channel diffusion layer 303 and the first pocket diffusion layers 307a and 307b. This is advantageous from the point of view of achieving the first peripheral transistor 27 with reduced variation in threshold voltage.

Incidentally, in the process of manufacturing an imaging device, heat treatment may be executed for the purpose of heating the pixel region R1. This heat treatment may cause the first peripheral region R2 to be heated too. However, the aforementioned diffusion-suppressing action derived from carbon suppresses the redistribution of the impurity in the first peripheral transistor 27 of the first peripheral region R2 even in a case where the first peripheral region R2 is heated by such heat treatment. For example, in a case where the first extension diffusion layers 306a and 306b contain boron and carbon, the redistribution of boron is suppressed by carbon, whereby the shallow junctions may be maintained. Further, in a case where the N-type channel diffusion layer 303 contains phosphorus and carbon, the redistribution of phosphorus may be suppressed by carbon.

Further, the inclusion of carbon in the first extension diffusion layers 306a and 306b also brings about an effect of reducing the occurrence of residual defects in the first extension diffusion layers 306a and 306b. Examples of residual defects include EOR (end-of-range) defects. The term "EOR defect" here refers to a defect layer that is formed in a region directly below an amorphous/crystal (a/c) interface before thermal processing in a case where the semiconductor substrate 130, which is composed of silicon, is subjected to thermal processing in an amorphized state.

TED is suppressed by carbon implantation through the following mechanism. That is, carbon forms, for example, carbon-lattice silicon or carbon-vacancy complexes or clusters with enhanced point defects, which induce TED, and thereby reduces enhanced point defects. Further, in consideration of the fact that enhanced point defects may grow to generate secondary defects such as dislocation loops, it can be said that carbon reduces crystal defects. For example, by using, in extension formation regions of the semiconductor substrate 130, crystal layers with reduced generation of residual defect layers such as secondary defects, even the occurrence of junction leaks due to residual defect layers can be reduced.

When variations in the threshold voltage of the first peripheral transistor 27 are small, it is not necessary to secure a wide design margin of the first peripheral transistor 27. In addition, a Pelgrom coefficient can be reduced. Note here that variations in the threshold voltage of a transistor can be expressed by σvt = Avt/√(Lg·Wg), and are proportionate to the reciprocal of the square root of the product of the gate length (Lg) and the gate width (Wg). The tilt Avt at this point in time is known as a Pelgrom coefficient. This makes it possible to select a small-size (specifically, small-area) transistor with a small gate length (Lg) and/or a small gate width (Wg).

When variations in the threshold voltage of the first peripheral transistor 27 are small, it is easy to reduce the number of variations in size differences that the first peripheral transistor 27 should include. Think of, for example, a case in which variations in the threshold voltage of the first peripheral transistor 27 are small and other characteristics of the first peripheral transistor 27 are satisfactory. Sizes of transistor that make the characteristics of a transistor suitable vary from one characteristic to another. For example, a size of transistor for achieving a suitable Pelgrom coefficient, a size of transistor for achieving a suitable mutual conductance (gm), and a size of transistor for achieving a suitable drain conductance (gds) are different from one another. However, in the aforementioned case, it is not highly necessary for the first peripheral transistor 27 to include variations that vary in size from characteristic to characteristic. This makes it possible to reduce the number of first peripheral transistors 27 that are disposed in the first peripheral region, thereby making it possible to reduce the area of the first peripheral region.

It should be noted that carbon, fluorine, and nitrogen are easily segregated in an EOR defect. In the present configuration example, EOR defects are present in portions directly below the first extension diffusion layers 306a and 306b, and carbon is segregated in the EOR defects.

The suppression of TED by carbon (C) in the first configuration example is further described.

As mentioned above, the second epitaxial layer 136 of the first configuration example is a cSiGe layer obtained by epitaxially growing SiGe. A SiGe layer is less prone to TED mediated by interstitial silicon than a Si layer. TED mediated by interstitial silicon is for example TED of a p-type impurity such as boron (B). On the other hand, a SiGe layer is more prone to TED mediated by atomic vacancy than a Si layer. TED mediated by atomic vacancy is for example TED of an n-type impurity such as arsenic (As). The likelihood of TED mediated by atomic vacancy in a SiGe layer increases as the content of Ge in the SiGe layer increases.

In an example of the first configuration example, such a cSiGe layer is formed in the first peripheral transistor 27, and a n-type impurity such as arsenic (As) is present in the first peripheral transistor 27. Specifically, the first pocket diffusion layers 307a and 307b contain arsenic. In this case, when heat treatment is performed for the purpose of heating the pixel region R1, the first peripheral region R2 too is heated. This may cause arsenic to diffuse by TED. Specifically, the diffusion tends to occur in a direction toward the SiGe layer. This may cause an increase in the concentration of arsenic in the cSiGe layer.

However, in the first configuration example, carbon is contained in a region near the cSiGe layer. This makes it difficult for an n-type impurity such as arsenic (As) from diffusing into the cSiGe layer by TED.

The region near the cSiGe layer may include the first extension diffusion layers 306a and 306b. The region near the cSiGe layer may include the first pocket diffusion layers 307a and 307b. In Fig. 5B, carbon-implanted layers 311 are exemplarily indicated by dotted circles. A similar effect may be brought about in a case where the impurity contained in the first pocket diffusion layers 307a and 307b is an n-type impurity other than arsenic.

In the present configuration example, the p-type source diffusion layer 313a and the p-type drain diffusion layer 313b contain carbon (C). Note, however, that either or both of the p-type source diffusion layer 313a and the p-type drain diffusion layer 313b may not contain carbon (C).

On both side surfaces of the gate electrode 302, offset spacers 309a and 309b having insulation properties are formed. The offset spacers 309a and 309b contain elements implanted in the step of implanting an impurity for forming the first extension diffusion layers 306a and 306b and/or the step of implanting an impurity for forming the first pocket diffusion layers 307a and 307b. Examples of elements that are implanted into the offset spacers 309a and 309b include boron, arsenic, and carbon. Furthermore, first side walls 308Aa and 308Ab with L-shaped cross-sections are formed over the semiconductor substrate 130. The first side walls 308Aa and 308Ab extend from over outer side surfaces of the offset spacers 309a and 309b to upper portions of inner ends of the p-type source diffusion layer 313a and the p-type drain diffusion layer 313b, respectively. Further, second side walls 308Ba and 308Bb having insulation properties are formed on outer sides of the first side walls 308Aa and 308Ab, respectively.

In the first configuration example, arsenic ions are used as an impurity of the N-type channel diffusion layer 303. Note, however, that the N-type channel diffusion layer 303 may contain phosphorus ions instead of or in combination with arsenic ions. Further, the N-type channel diffusion layer 303 may contain, instead of or in combination with arsenic ions, ions of an element that is larger in atomic number than arsenic and that exhibits an n type. Examples of elements that are larger in atomic number than arsenic and that exhibit an n type include antimony and bismuth.

An impurity that can be employed as an impurity of the N-type channel diffusion layer 303 may be employed as an impurity of the first pocket diffusion layers 307a and 307b. Further, an impurity that can be employed as an impurity of the first pocket diffusion layers 307a and 307b may be employed as an impurity of the N-type channel diffusion layer 303. Examples of impurities that the N-type channel diffusion layer 303 and the first pocket diffusion layers 307a and 307b may contain include phosphorus, arsenic, antimony, and bismuth.

Further, carbon is not the only impurity that contributes to suppression of TED. Instead of or in combination with carbon, at least one selected from the group consisting of nitrogen, fluorine, germanium, silicon, and argon may be used. Nitrogen, fluorine, germanium, silicon, argon, or other impurities may contribute to suppression of TED. Specifically, as is the case with carbon, impurities such as nitrogen and fluorine form, for example, impurity-lattice silicon or impurity-vacancy complexes or clusters with enhanced point defects, which induce TED, and thereby reduce enhanced point defects. Specifically, enhanced point defects are reduced by the formation of, for example, carbon-lattice silicon, nitrogen-lattice silicon, fluorine-lattice silicon, carbon-vacancy, nitrogen-vacancy, and fluorine-vacancy complexes. Germanium, silicon, argon, or other impurities contribute to suppression of TED through the pre-amorphization action. Besides, at least one selected from among non-conducting elements in the group consisting of elements in groups 14, 17, and 18 may be used as an impurity that contributes to suppression of TED.

Further, in the first configuration example, the first peripheral transistor 27 is a P-channel MIS transistor. Note, however, that a configuration in which the first peripheral transistor 27 is an N-channel MIS transistor may be adopted too. In a case where the first peripheral transistor 27 is an N-channel MIS transistor, arsenic (As) ions, ions of a Group V element that are larger in atomic number than arsenic ions, such as phosphorus (P) ions, antimony (Sb) ions, or bismuth (Bi) ions, or a combination thereof can be used as n-type impurity ions that constitute an n-type extension diffusion layer. Further, in a case where the first peripheral transistor 27 is an N-channel MIS transistor, boron (B) ions or indium (In) ions, ions of a Group III element that are larger in atomic number than boron ions, such as gallium (Ga) ions, or a combination thereof can be used in a p-type pocket diffusion layer. In this configuration too, TED of the p-type pocket diffusion layer may be suppressed. For example, TED of boron may be suppressed by causing the p-type pocket diffusion layer to contain carbon or other substances in combination with boron. Further, indium too is prone to TED mediated by interstitial silicon, albeit to a lesser degree than boron. This makes it possible to suppress TED of indium by co-implanting carbon or other substances in combination with indium, suppression of TED makes it possible to reduce variations in threshold voltage attributed to pocket profiles. For example, in a case where the first peripheral transistor 27 is a P-channel MIS transistor, boron (B) ions or indium (In) ions, ions of a Group III element that are larger in atomic number than boron ions, such as gallium (Ga) ions, or a combination of two or more thereof may be used as p-type impurity ions that constitute a p-type extension diffusion layer. Arsenic (As) ions, ions of a Group V element that are larger in atomic number than arsenic ions, such as phosphorus (P) ions, antimony (Sb) ions, or bismuth (Bi) ions, or a combination thereof can be used as n-type impurity ions that constitute an n-type pocket diffusion layer.

### [Second Configuration Example]

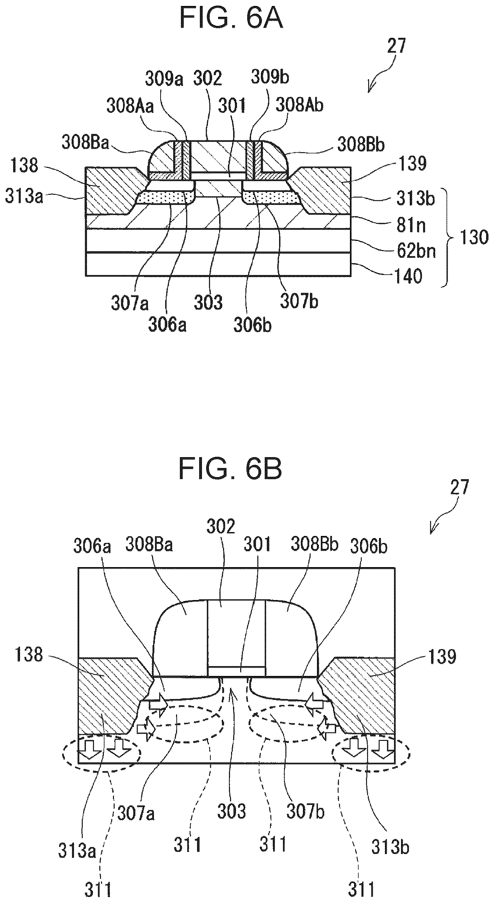

Fig. 6A shows a cross-sectional configuration of a first peripheral transistor 27 according to a second configuration example. Fig. 6B is a schematic cross-sectional view for explaining a region in the first peripheral transistor 27 according to the second configuration example where carbon is distributed. The following describes the second configuration example with reference to Figs. 6A and 6B. It should be noted that Fig. 6B omits to illustrate elements such as first side walls 308Aa and 308Ab and offset spacers 309a and 309b. A description of configurations that the second configuration example has in common with the first configuration example may be omitted.

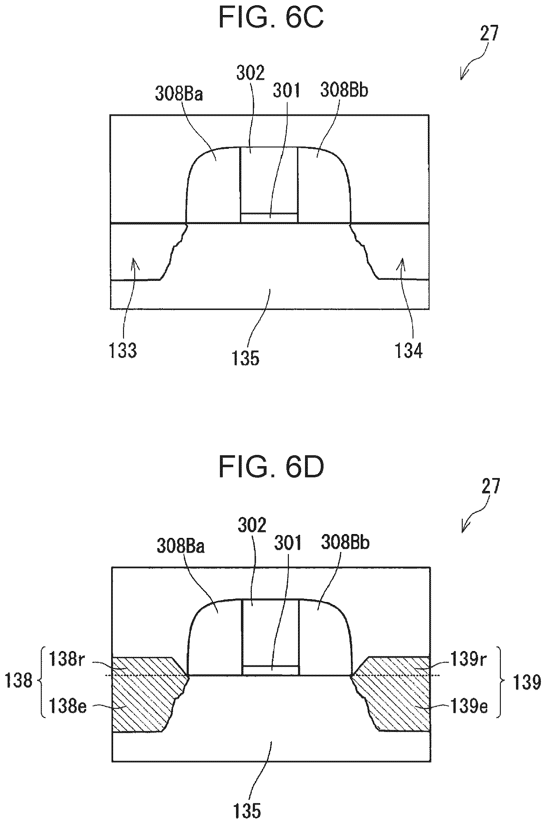

As shown in Fig. 6C, a first recessed portion 133 and a second recessed portion 134 are formed in the first epitaxial layer 135. As shown in Fig. 6D, a fourth epitaxial layer 138 is formed over the first recessed portion 133. As shown in Fig. 6D, a fifth epitaxial layer 139 is formed over the second recessed portion 134. The fourth epitaxial layer 138 and the fifth epitaxial layer 139 are silicon-germanium (SiGe) layers. Fig. 6C is a schematic cross-sectional view showing the first recessed portion 133 and the second recessed portion 134, which are formed in the first epitaxial layer 135. Fig. 6C omits to illustrate the fourth epitaxial layer 138, the fifth epitaxial layer 139, or other layers.

The fourth epitaxial layer 138 has an embedded portion 138e and a raised portion 138r. The embedded portion 138e is a portion embedded in the first recessed portion 133. The raised portion 138r is a portion raised from the embedded portion 138e. Further, the raised portion 138r is a portion projecting out of the first recessed portion 133.

The fifth epitaxial layer 139 has an embedded portion 139e and a raised portion 139r. The embedded portion 139e is a portion embedded in the second recessed portion 134. The raised portion 139r is a portion raised from the embedded portion 139e. Further, the raised portion 139r is a portion projecting out of the second recessed portion 134.

Fig. 6D is a schematic cross-sectional view for explaining the embedded portion 138e, the raised portion 138r, the embedded portion 139e, and the raised portion 139r.

The embedded portion 138e and the embedded portion 139e constitute an eSiGe (embedded SiGe) layer. The raised portion 138r and the raised portion 139r constitute an rSiGe (raised SiGe) layer.

The first epitaxial layer 135 includes the N-type channel diffusion layer 303. The first epitaxial layer 135 includes the first extension diffusion layer 306a and the first extension diffusion layer 306b. The first epitaxial layer 135 includes the first pocket diffusion layer 307a and the first pocket diffusion layer 307b.

The p-type source diffusion layer 313a is formed using the fourth epitaxial layer 138. The p-type drain diffusion layer 313b is formed using the fifth epitaxial layer 139.

As can be understood from the foregoing description, in the second configuration example, the N-type channel diffusion layer 303 is disposed between the p-type source diffusion layer 313a and the p-type drain diffusion layer 313b. The N-type channel diffusion layer 303 is formed using the first epitaxial layer 135 of silicon. The p-type source diffusion layer 313a is formed using the fourth epitaxial layer 138 of silicon germanium. The p-type drain diffusion layer 313b is formed using the fifth epitaxial layer 139 of silicon germanium. According to this configuration, the N-type channel diffusion layer 303 is pushed in from the p-type source diffusion layer 313a and the p-type drain diffusion layer 313b. This causes a compression strain on the N-type channel diffusion layer 303. The compression strain brings about improvement in carrier mobility. This may improve the driving force of the first peripheral transistor 27 and increase the speed of operation of the first peripheral transistor 27. This brings about improvement in the characteristics of the first peripheral transistor 27. Further, this is advantageous from the point of view of reducing the area of the first peripheral region R2. In the second configuration example, the p-type source diffusion layer 313a and the p-type drain diffusion layer 313b are equivalent to a first strain-introducing layer.

In the second configuration example too, as in the first configuration example, suppression of TED by carbon (C) may be expressed. The following further describes the suppression of TED by carbon (C) in the second configuration example.

As mentioned above, in the second configuration example, the fourth epitaxial layer 138 and the fifth epitaxial layer 139 are an eSiGe layer and an rSiGe layer having boron as an impurity. Specifically, the fourth epitaxial layer 138 and the fifth epitaxial layer 139 are layers formed by in-situ-dope epitaxial growth. The in-situ-dope epitaxial growth is a technique for performing epitaxial growth while performing impurity doping. The impurity here is boron. When based on boron as an impurity, the in-situ-dope epitaxial growth makes it possible to achieve high boron concentrations in the fourth epitaxial layer 138 and the fifth epitaxial layer 139. That is, high boron concentrations in the p-type source diffusion layer 313a and the p-type drain diffusion layer 313b can be achieved. High boron concentrations are advantageous from the point of view of reducing the values of resistance of the p-type source diffusion layer 313a and the p-type drain diffusion layer 313b.

Note, however, that when heat treatment is performed for the purpose of heating the pixel region R1, the first peripheral region R2 too is heated. This causes boron to exude or diffuse from the p-type source diffusion layer 313a, which is constituted using the eSiGe layer and the rSiGe layer, to the Si layer derived from the first epitaxial layer 135. This also causes boron to exude or diffuse from the p-type drain diffusion layer 313b, which is constituted using the eSiGe layer and the rSiGe layer, to the Si layer derived from the first epitaxial layer 135. When boron having exuded to the Si layer diffuses by TED in the Si layer, a short channel effect may be brought about in the first peripheral transistor 27. The short channel effect may change the threshold voltage of a transistor from a desired value and invite a decrease in performance of the first peripheral transistor 27. Since a SiGe layer is higher in solid solubility of boron than a Si layer, a high concentration of boron may be present in a SiGe layer. From the point of view of reducing the values of resistance of the p-type source diffusion layer 313a and the p-type drain diffusion layer 313b, it is possible to increase concentrations of doped-boron in the SiGe layers used to constitute these diffusion layers. In such a situation, the aforementioned exudation may become obvious. A higher content of Ge in a SiGe layer leads to higher solid solubility of boron in the SiGe layer.

However, in the second configuration example, carbon is contained in regions near the eSiGe layer and the rSiGe layer. This suppresses boron from diffusing by TED in the Si layer even if boron exudes from the eSiGe layer and the rSiGe layer to the Si layer. This may suppress the short channel effect and reduce deterioration of the performance of the first peripheral transistor 27. In Fig. 6B, carbon-implanted layers 311 are exemplarily indicated by dotted circles.

### (First Modification of First Configuration Example)

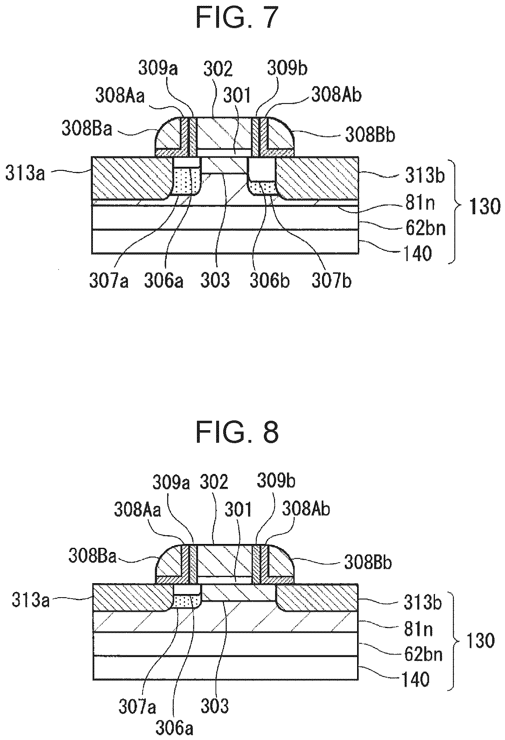

Fig. 7 shows a cross-sectional configuration of a transistor according to a first modification of the first configuration example. Fig. 7 omits to illustrate the first epitaxial layer 135, the second epitaxial layer 136, and the third epitaxial layer 137.

In the transistor according to the first modification, as shown in Fig. 7, the impurity concentration profiles of the first extension diffusion layers 306a and 306b, which are P-type extension high-concentration diffusion layers, are bilaterally asymmetric with respect to the gate electrode 302. Making a source region shallower and steeper in extension profile than a drain region as shown in Fig. 7 effect an increase in carrier concentration gradient between the source region and a channel region, bringing about improvement in driving force in the MIS transistor. Further, since the drain region is deeper in extension profile than the source region, less hot carriers are generated than in a symmetrical, shallow, and steep profile structure. It should be noted that a transistor having the configuration of Fig. 7 may be fabricated, for example, with reference to PTL 2.

In the example shown in Fig. 7, the first extension diffusion layer 306a is shallower than the first extension diffusion layer 306b. Note, however, that a configuration in which the first extension diffusion layer 306b is shallower than the first extension diffusion layer 306a may be adopted.

In the second configuration example too, the bilaterally asymmetric impurity concentration profiles of the first extension diffusion layers 306a and 306b can be applied.

### (Second Modification of First Configuration Example)

Fig. 8 shows a cross-sectional configuration of a transistor according to a second modification of the first configuration example. Fig. 8 omits to illustrate the first epitaxial layer 135, the second epitaxial layer 136, and the third epitaxial layer 137.

As shown in Fig. 8, the transistor according to the second modification has a P-type extension high-concentration diffusion layer beside only either the p-type source diffusion layer 313a or the p-type drain diffusion layer 313b.

In the example shown in Fig. 8, the transistor according to the second modification has the first extension diffusion layer 306a as a p-type extension high-concentration diffusion layer that is adjacent to the p-type source diffusion layer 313a and, meanwhile, does not have a first extension diffusion layer that is adjacent to the p-type drain diffusion layer 313b. Note, however, that a configuration in which the transistor does not have a first extension diffusion layer that is adjacent to the p-type source diffusion layer 313a and, meanwhile, has the first extension diffusion layer 306b adjacent to the p-type drain diffusion layer 313b may be adopted.

Further, as shown in Fig. 8, the transistor according to the second modification has an n-type pocket diffusion layer beside only either the p-type source diffusion layer 313a or the p-type drain diffusion layer 313b. Specifically, the transistor according to the second modification has the first pocket diffusion layer 307a adjacent to the p-type source diffusion layer 313a and, meanwhile, does not have a first pocket diffusion layer that is adjacent to the p-type drain diffusion layer 313b. Note, however, that a configuration in which the transistor does not have a first pocket diffusion layer that is adjacent to the p-type source diffusion layer 313a and, meanwhile, has the first pocket diffusion layer 307b adjacent to the p-type drain diffusion layer 313b may be adopted.

It is also possible to adopt a configuration of the second configuration example in which either the first extension diffusion layer 306a or the first extension diffusion layer 306b is absent. It is also possible to adopt a configuration of the second configuration example in which either the first pocket diffusion layer 307a or the first pocket diffusion layer 307b is absent.

### (Third Modification of First Configuration Example)

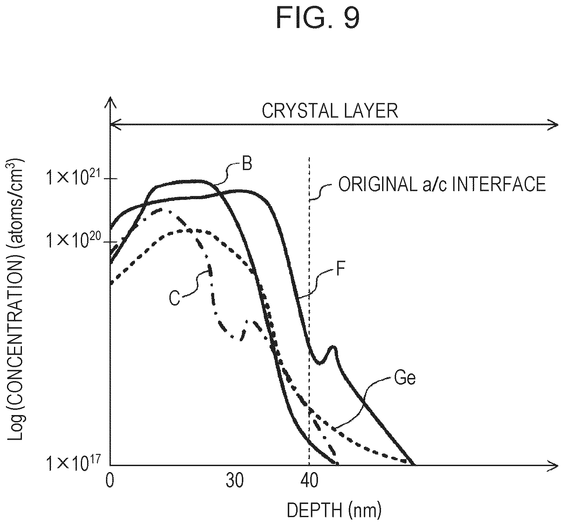

In a third modification of the first configuration example, the p-type source diffusion layer 313a and the p-type drain diffusion layer 313b contain fluorine (F) and carbon (C). Fluorine may bring about partial amorphization of the semiconductor substrate 130. Further, fluorine may suppress transient enhanced diffusion (TED) of impurities. Fig. 9 shows examples of impurity concentration distributions in regions along a straight line passing through the p-type source diffusion layer 313a and extending in a direction parallel with the depth of the semiconductor substrate 130. The vertical axis represents the concentrations of fluorine (F), carbon (C), boron (B), and germanium (Ge) on a log scale. The concentration distributions of Fig. 9 relate to a case where fluorine is implanted for amorphization and suppression of the diffusion of the impurities and diffused during annealing. In the examples shown in Fig. 9, the concentration distribution of fluorine has segregation near the original position of the a/c interface. In this example, impurity concentration distributions in regions along a straight line passing through p-type drain diffusion layer 313b and extending in a direction parallel with the depth of the semiconductor substrate 130 too are distributions shown in Fig. 9.

According to the third modification, the diffusion of the impurities is suppressed after the aforementioned annealing. Further, even if the first peripheral region R2 is heated during thermal processing for the pixel region R1, redistributions of the impurities may fall within narrow ranges.

In the second configuration example too, impurity concentration distributions such as those shown in Fig. 9 are applicable.

### (Fourth Modification of First Configuration Example)

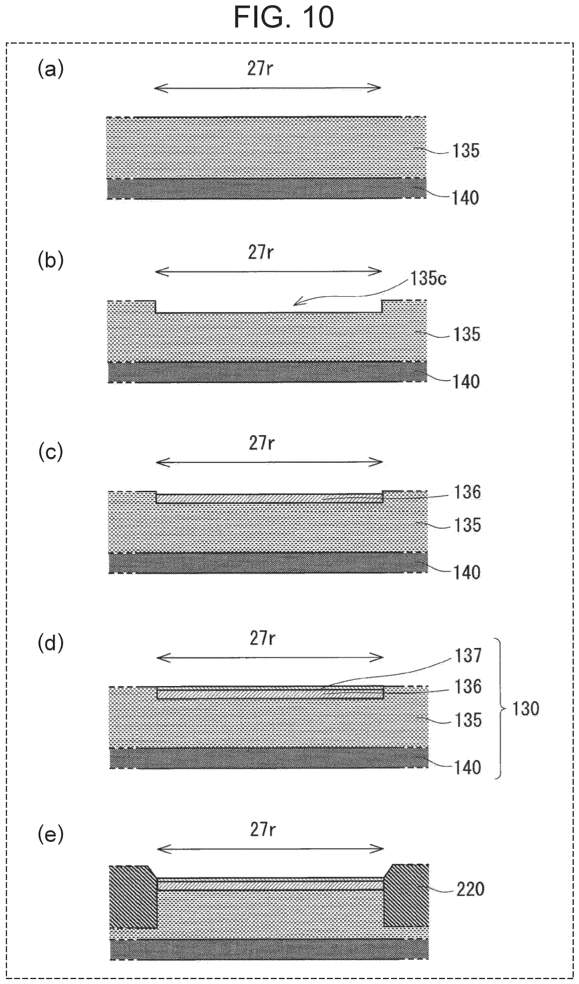

As described with reference to Figs. 5A and 5B, in the first configuration example, the first peripheral transistor 27 has the third epitaxial layer 137, i.e. the cap layer. As can be understood from the following description of a manufacturing method with reference to Figs. 10 to 13, in the first configuration example, the cap layer is an impurity-doped layer. In the fourth modification, the third epitaxial layer 137, i.e. the cap layer, is a non-doped layer. The cap layer of the fourth modification can be prepared by adjusting the range of implantation of an impurity.

### (Fifth Modification of First Configuration Example)

As described with reference to Figs. 5A and 5B, in the first configuration example, the first peripheral transistor 27 has the third epitaxial layer 137, i.e. the cap layer. Specifically, in the first configuration example, the cap layer constitutes the surface of the semiconductor substrate 130. Note, however, that this is not essential. In the fifth modification, the third epitaxial layer 137, i.e. the cap layer, is not present. The second epitaxial layer 136, i.e. the cSiGe layer, constitutes the surface of the semiconductor substrate 130.

In addition, the features of the first configuration example described with reference to Figs. 5A and 5B and the features of the second configuration example described with reference to Figs. 6A to 6D may be combined. For example, the surface of the semiconductor substrate 130 in the second configuration example may be constituted by the third epitaxial layer 137, i.e. the cap layer. Further, the first peripheral transistor 27 may have the first epitaxial layer 135, the second epitaxial layer 136, the third epitaxial layer 137, the fourth epitaxial layer 138, and the fifth epitaxial layer 139.

### [Method for Manufacturing First Peripheral Transistor according to First Configuration Example]

The following describes, with reference to Figs. 10 to 13, a method for manufacturing a first peripheral transistor 27 according to the first configuration example shown in Figs. 5A and 5B. Figs. 10 to 13 illustrate cross-sectional views showing the method for manufacturing a first peripheral transistor 27 according to the first configuration example.

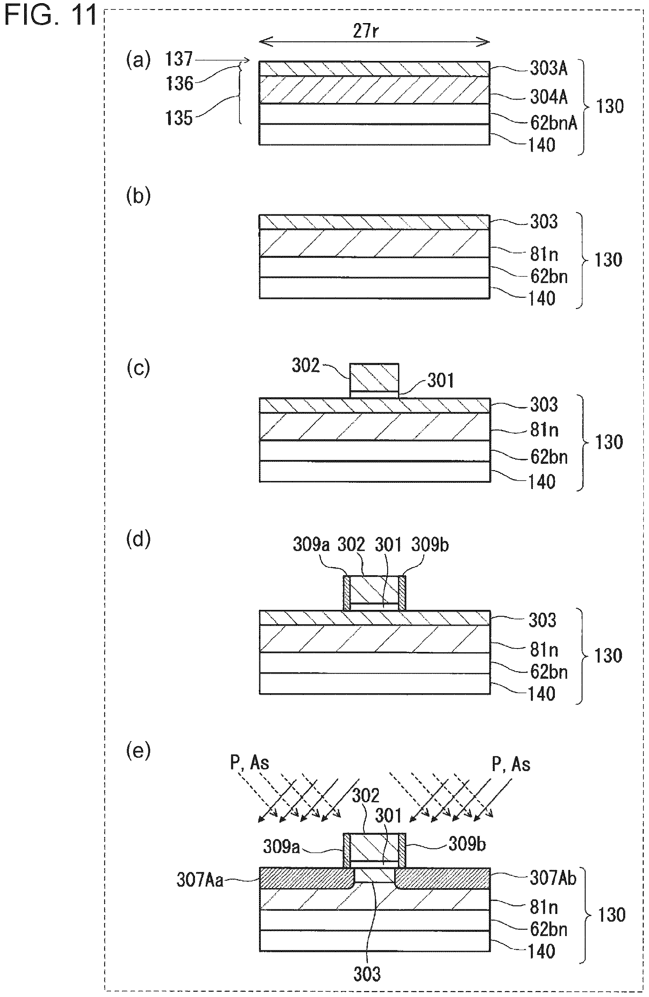

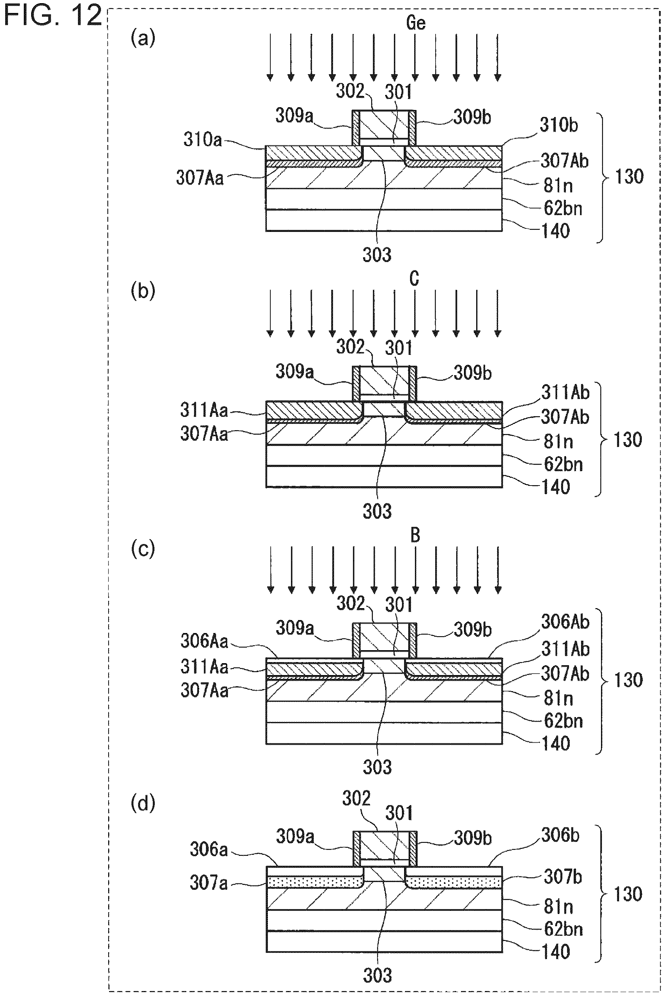

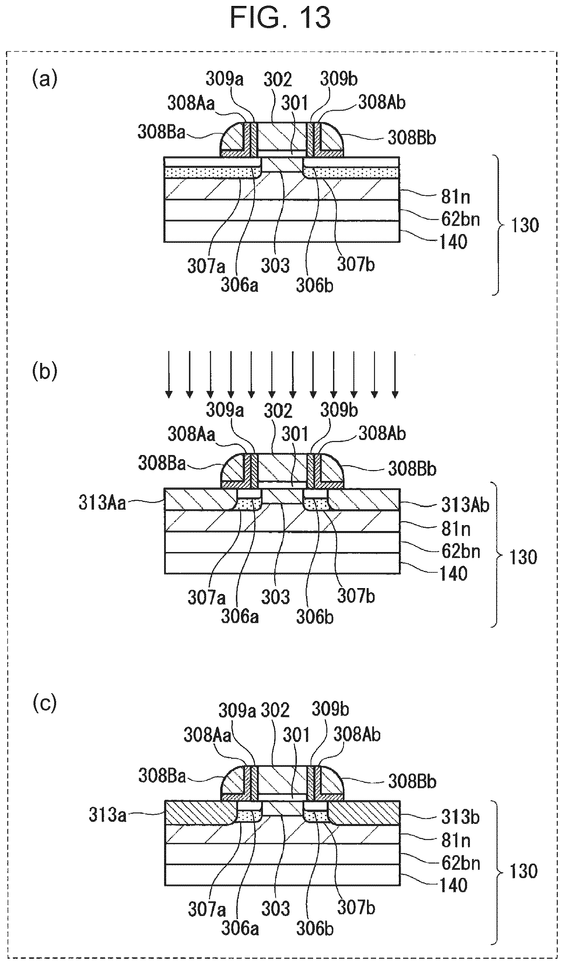

Portions (a) to (e) of Fig. 10, portions (a) to (e) of Fig. 11, portions (a) to (d) of Fig. 12, and portions (a) to (c) of Fig. 13 show cross-sectional configurations in the order of steps of a method for manufacturing a MIS transistor according to the first configuration example.

First, as shown in portion (a) of Fig. 10, silicon (Si) is epitaxially grown over a supporting substrate 140. As a result of this, a first epitaxial layer 135 is formed over the supporting substrate 140. In the example of Fig. 10, the first epitaxial layer 135 is formed by epitaxially growing silicon over the supporting substrate 140 in both the pixel region R1 and the first peripheral region R2. As one example, the first epitaxial layer has a film thickness falling within a range of 3 µm to 10 µm. It should be noted that the semiconductor substrate 130 may be an SOI (silicon-on-insulator) substrate, a substrate having an epitaxial layer provided on a surface thereof by epitaxial growth or other processes, or other substrates.

Next, as shown in portion (b) of Fig. 10, a portion 27r of the first epitaxial layer 135 in which a first peripheral transistor 27 is to be formed is recessed. As a result of this, a recessed portion 135c is formed in the first epitaxial layer 135. The depth of the recessed portion 135c is shallower than the depth of the N-type channel diffusion layer 303 to be formed. Specifically, the recessed portion 135c is formed by etching involving the use of a mask having an opening in a portion corresponding to the portion 27r in which the first peripheral transistor 27 is to be formed.

Next, as shown in portion (c) of Fig. 10, silicon germanium (SiGe) is epitaxially grown in the recessed portion 135c. This epitaxial growth is performed with the aforementioned mask kept provided. As a result of this, a second epitaxial layer 136 is formed in the recessed portion 135c. The second epitaxial layer 136 constitutes a cSiGe layer. The thickness of the cSiGe layer is for example less than or equal to 10 nm. Specifically, the thickness of the cSiGe layer may be greater than or equal to 5 nm and less than or equal to 7 nm. When silicon germanium of the cSiGe layer is denoted by Si₁₋ₓGeₓ, X is larger than 0 and smaller than 1. In one example, X is greater than or equal to 0.1 and less than or equal to 0.8. X may be greater than or equal to 0.1 and less than or equal to 0.65. As mentioned above, the second epitaxial layer 136 may cause a quantum-confined effect to be expressed. Improvement in the characteristics by the quantum-confined effect is easily seen in a case where the second epitaxial layer 136 is thin and the concentration of germanium in the second epitaxial layer 136 is high. In one example, the second epitaxial layer 136 is smaller in film thickness than the first epitaxial layer 135.

Next, as shown in portion (d) of Fig. 10, silicon (Si) is epitaxially grown on the second epitaxial layer 136 in the recessed portion 135c. This epitaxial growth is performed with the aforementioned mask kept provided. As a result of this, a third epitaxial layer 137 is formed over the second epitaxial layer 136. The third epitaxial layer 137 constitutes a cap layer. The thickness of the cap layer is for example greater than or equal to 1 nm and less than or equal to 2 nm. In a case where the cap layer is formed in the first peripheral region R2, there may be a difference in level with respect to the pixel region R1.

In the present embodiment, the pixel region R1 and the first peripheral region R2 are isolated from each other by a device isolation 220 such as an STI structure. Further, in the first peripheral region R2, an N-channel transistor and a P-channel transistor are isolated from each other by a device isolation 220 such as an STI structure. In the second configuration example too, a device isolation 220 such as an STI structure can be formed in a similar fashion. Portion (e) of Fig. 10 illustrates a structure in which a device isolation 220 is formed.

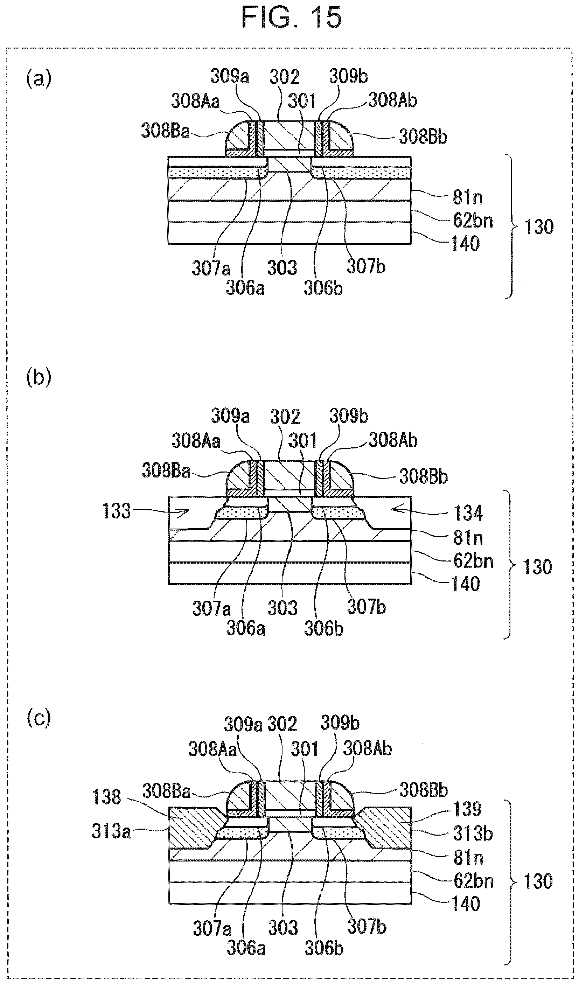

A device isolation 220 may be formed by any method. An STI structure serving as a device isolation 220 may be formed by an STI process. In a specific example of the present embodiment, the first epitaxial layer 135 is recessed after the structure shown in portion (d) of Fig. 10 has been obtained. As a result of this, a trench (groove) is formed. The trench can be formed, for example, by etching involving the use of a mask. After that, the trench is filled with a filler such as an oxide. This filling can be performed by chemical vapor deposition (CVD) or other processes. This way makes it possible to form an STI structure serving as a device isolation 220. In these respects, the same applies to not only a case where a first peripheral transistor 27 according to the first configuration example is manufactured according to Figs. 10 to 13 but also a case where a first peripheral transistor 27 according to the second configuration example is manufactured according to Fig. 15 or other drawings.

Further, a device isolation 220 may be formed at any timing. As mentioned above, an STI structure serving as a device isolation 220 may be formed by an STI process. In an example of this case, an STI structure is formed by an STI process after the structure shown in portion (a) of Fig. 10 has been obtained. After that, the region in which the second epitaxial layer 136 is to be formed, i.e. the portion 27r in which the first peripheral transistor is to be formed, is selectively etched. As a result of this, the recessed portion 135c shown in portion (b) of Fig. 10 is formed. After that, the second epitaxial layer 136 is formed by epitaxially growing SiGe. In another example an STI structure is formed by an STI process after the structure shown in portion (d) of Fig. 10 has been obtained. It should be noted that the STI structure may be shaped such that its width becomes narrower toward the bottom and its side surfaces are inclined at angles. The depth of the STI structure may be deeper than the bottom of the recessed portion 135c or may be deeper than the depth of the charge accumulation region Z of the pixel region R1.

In portion (e) of Fig. 10, the device isolation 220 includes a projecting portion projecting upward from an upper surface of the first epitaxial layer 135. Note, however, that the device isolation 220 may not include the projecting portion. In this respect, the same applies to not only a case where a first peripheral transistor 27 according to the first configuration example is manufactured but also the second configuration example.

In portion (e) of Fig. 10, the device isolation 220 is in contact with the second epitaxial layer 136 and the third epitaxial layer 137. Note, however, that the device isolation 220 may not be in contact with the second epitaxial layer 136 and the third epitaxial layer 137. In a case where a first peripheral transistor 27 according to the second configuration example is manufactured according to Fig. 15 or other drawings, the device isolation 220 may or may not be in contact with the fifth epitaxial layer 139.

The following further describes, with reference to Fig. 11 or other drawings, the method for manufacturing a first peripheral transistor 27 according to the first configuration example. Fig. 11 or other drawings may omit to illustrate the first epitaxial layer 135, the second epitaxial layer 136, the third epitaxial layer 137, or other layers. Further, Fig. 11 or other drawings intensively illustrate the portion 27r in which the first peripheral transistor 27 is to be formed.

After the formation of the structure of portion (d) of Fig, 10, as shown in portion (a) of Fig. 11, impurity ions are implanted into the semiconductor substrate 130. This ion implantation phosphorus (P) ion implantation involving an implantation energy of 1000 keV and an implantation dose amount of 3 × 10¹²/cm². This implantation results in the formation of an n-type injection layer 62bnA.

Next, as shown in portion (a) of Fig. 11, an n-type well impurity-implanted layer 304A is formed by implanting impurity ions into the semiconductor substrate 130. This ion implantation includes, for example, a first stage and a second stage. The first stage of ion implantation is phosphorus (P) ion implantation involving an implantation energy of 600 keV and an implantation dose amount of 5 × 10¹²/cm². The second stage of ion implantation is phosphorus (P) ion implantation involving an implantation energy of 260 keV and an implantation dose amount of 7 × 10¹²/cm². The first and second stages of ion implantation result in the formation of the n-type well impurity-implanted layer 304A.

After that, arsenic (As) ions are implanted into the semiconductor substrate 130 with an implantation energy of approximately 85 keV and in an implantation dose amount of approximately 5 × 10¹²/cm². As a result of this, an N-type channel impurity-implanted layer 303A is formed on top of the n-type well impurity-implanted layer 304A.

The ion implantation by which the n-type injection layer 62bnA, the n-type well impurity-implanted layer 304A, and the n-type channel impurity-implanted layer 303A are formed may be preceded by deposition of a silicon oxide film on a surface of the semiconductor substrate 130. The n-type injection layer 62bnA, the n-type well impurity-implanted layer 304A, and the n-type channel impurity-implanted layer 303A may be formed in any order.

Next, as shown in portion (b) of Fig. 11, the semiconductor substrate 130 thus ion-implanted is subjected to first rapid thermal processing (RTA) that raises the temperature to approximately to 850°C to 1050°C at a temperature rise rate higher than or equal to approximately 100°C/sec. e.g. approximately 200°C/sec, and keeps the peak temperature for a maximum of approximately ten seconds or does not keep the peak temperature. This first rapid thermal processing causes the N-type channel diffusion layer 303 and N-type wells, namely the n-type impurity region 81n and the n-type semiconductor layer 62bn, to be formed in the upper part of the semiconductor substrate 130. It should be noted that the rapid thermal processing that does not keep the peak temperature refers to thermal processing in which the thermal processing temperature drops at the same time as it reaches the peak temperature.

Next, as shown in portion (c) of Fig. 11, a gate insulator film 301 composed of silicon oxide with a film thickness of approximately 1.5 nm is selectively formed on top of the semiconductor substrate 130, and a gate electrode 302 composed of polysilicon with a film thickness of approximately 100 nm is selectively formed on top of the gate insulator film 301. Although the gate insulator film 301 is composed of silicon oxide here, the gate insulator film 301 may be a high-x insulator film composed of silicon oxynitride (SiON), hafnium oxide (HfOₓ), hafnium-silicon-oxynitride (HfSiON), or other substances. Further, instead of being composed of polysilicon, the gate electrode 302 may be composed of a metal gate, a film stack of polysilicon and a metal gate, silicide-topped polysilicon, or fully silicided polysilicon.

Next, as shown in portion (d) of Fig. 11, an insulator film composed of silicon oxide with a film thickness of approximately 8 nm is deposited, and then the offset spacers 309a and 309b are formed by anisotropic etching on both side surfaces of the gate electrode 302 and the gate insulator film 301 with a finish thickness of approximately 4 nm. Although the offset spacers 309a and 309b are composed of silicon oxide here, the offset spacers 309a and 309b may be high-x insulator films composed of silicon nitride (SiN), HfO₂, or other substances.

Next, as shown in portion (e) of Fig. 11, an N-type impurity, e.g. phosphorus (P) ions, is implanted into the semiconductor substrate 130 with an implantation energy of approximately 40 keV and in an implantation dose amount of approximately 2 × 10¹³/cm² with the offset spacer 309a and 309b and the gate electrode 302 as masks. Then, N-type pocket impurity-implanted layers 307Aa and 307Ab are formed by angularly implanting an N-type impurity, e.g. arsenic (As) ions, with an implantation energy of approximately 80 keV and in an implantation dose amount of approximately 1 × 10¹³/cm². Implanting arsenic, which is heavy in mass number, first causes implantation damage that brings about an effect of suppressing a channeling tail. Note, however, that the P ions and the As ions may be implanted in any order.

In this example, both the P ions and the As ions are implanted into the n-type pocket impurity-implanted layers 307Aa and 307Ab. Note, however, that only either the P ions or the As ions may be implanted into the n-type pocket impurity-implanted layers 307Aa and 307Ab.

Next, as shown in portion (a) Fig. 12, amorphous layers 310a and 310b are selectively formed in the semiconductor substrate 130 by implanting germanium (Ge) ions into the semiconductor substrate 130 with an implantation energy of approximately 10 keV and in an implantation dose amount of approximately 5 × 10¹⁴/cm² with the offset spacer 309a and 309b and the gate electrode 302 as masks.

Although the amorphous layers 310a and 310b are formed of germanium here, they may be formed of silicon (Si), argon (Ar), krypton (Kr), xenon (Xe), carbon (C), or other substances.

Next, as shown in portion (b) of Fig. 12, with the amorphous layers 310a and 310b formed, carbon-implanted layers 311Aa and 311Ab are formed by implanting carbon (C) ions into the semiconductor substrate 130 with an implantation energy of approximately 5 keV and in an implantation dose amount of approximately 1 × 10¹⁵/cm² with the offset spacer 309a and 309b and the gate electrode 302 as masks. It should be noted that the carbon ions need only be implanted, for example, with the implantation energy falling within a range of 1 keV to 10 keV and with the implantation dose amount falling within a range of 1 × 10¹⁴/cm² to 3 × 10¹⁵/cm². At this point in time, molecular ions of carbon-containing molecules such as C₅H₅ or C₇H₇ may be used instead of the carbon ions. Further, nitrogen ions, fluorine ions, or other ions may be used instead of the carbon ions, which are impurity ions for use in the prevention of diffusion. Further, in a case where carbon or carbon-containing molecular ions are used instead of germanium in the formation of the amorphous layers 310a and 3 10b, the step of forming the amorphous layers 310a and 310b and the step of forming the carbon-implanted layers 311Aa and 311Ab may be executed simultaneously. Further, the semiconductor substrate 130 may be amorphized during pocket implantation by using ions with a comparatively large mass number, such as antimony (Sb), in n-type pocket impurity implantation.

Next, as shown in portion (c) of Fig. 12, first p-type impurity-implanted layers 306Aa and 306Ab are formed on top of the carbon-implanted layers 311Aa and 311Ab by implanting a p-type impurity, e.g. boron (B) ions, into the semiconductor substrate 130 with an implantation energy of approximately 0.5 keV and in an implantation dose amount of approximately 8 × 10¹⁴/cm² with the offset spacer 309a and 309b and the gate electrode 302 as masks. Instead of boron, boron difluoride (BF₂), boron clusters such as B₁₈Hₓ or B₁₀Hₓ, or indium (In) may be used.

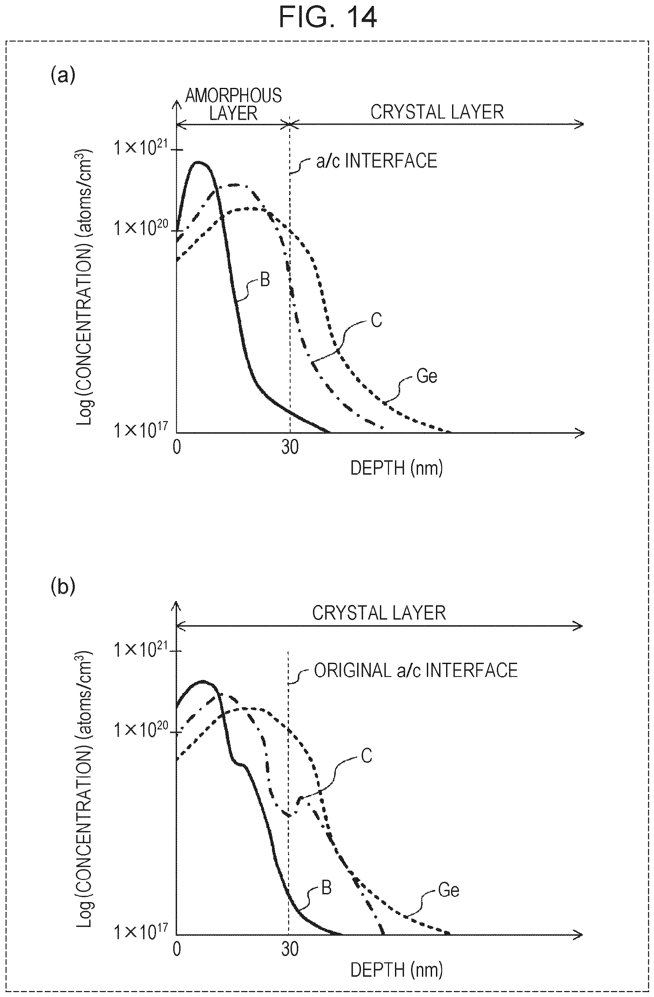

Fig. 14 illustrates graphs showing impurity concentration profiles in regions along a straight line passing through the extension formation regions according to Figs. 5A and 5B and extending in a direction parallel with the depth of the semiconductor substrate 130. The extension formation regions here are regions in which the extension diffusion layers 306a and 306b are to be formed or have been formed. Portion (a) Fig. 14 shows, on a log scale, concentration distributions (impurity profiles) of impurities (boron (B), carbon (C), and germanium (Ge)) immediately after boron ion implantation in a direction parallel with the depth of the semiconductor substrate 130B. As shown in portion (a) of Fig. 14, the amorphous layers 310a and 310b are approximately 30 nm deep under the condition of implantation of germanium according to the present manufacturing method example.

Next, the semiconductor substrate 130 is subjected to second rapid thermal processing that heats the substrate to a temperature of 1200°C to 1350°C, for example, by laser annealing and keeps the substrate near the peak temperature for approximately 1 ms. As shown in portion (d) of Fig. 12, this second rapid thermal processing causes the first extension diffusion layers 306a and 306b and the first pocket diffusion layers 307a and 307b, which are n-type pocket diffusion layers, to be formed in regions in the semiconductor substrate 130 lateral to the gate electrode 302, respectively. The first extension diffusion layers 306a and 306 are diffusion layers having boron ions diffused therein and have comparatively shallow junction planes. The first pocket diffusion layers 307a and 307b are diffusion layers having diffused therein phosphorus ions and arsenic ions contained in the n-type pocket impurity-implanted layers 307Aa and 307Ab. Although laser annealing is used in the second rapid thermal processing, which is on the millisecond time scale, here, a so-called millisecond annealing (MSA) method such as flash lamp annealing may be used. Furthermore, the second rapid thermal processing may involve the use of annealing that heats the semiconductor substrate 130 to a temperature of approximately 850°C to 1050°C at a temperature rise rate of approximately 200°C/sec and keeps the peak temperature for a maximum of approximately ten seconds or does not keep the peak temperature, e.g. low-temperature spike-RTA.

Portion (b) of Fig. 14 shows, on a log scale, concentrations distributions of impurities (B, C, and Ge) in the first extension diffusion layers 306a and 306b, which are p-type extension high-concentration diffusion layers formed by the second rapid thermal processing, in a direction parallel with the depth of the semiconductor substrate 130. After the second rapid thermal processing has been executed, the amorphous layers 310a and 310b, formed during germanium ion implantation, recover to crystal layers. Boron is diffused to have a peak at a slightly greater depth than it does immediately after ion implantation. Carbon has a first peak composed of a carbon cluster near a concentration peak position during ion implantation, and also has a segregated second peak near the original amorphous/crystal (a/c) interface. Germanium has almost the same concentration distribution as it does immediately after ion implantation.

The concept "pre-amorphization" is explained here. Let it be assumed that amorphization of a certain region in a semiconductor substrate and implantation into that region of an impurity having a polarity, i.e. a conductivity type, (e.g. implantation of B ions or other ions) are executed. In this case, it is conceivable that the amorphization and the impurity implantation may be executed in this order. In this case, the amorphization may be referred to as "pre-amorphization". Doing ion implantation after amorphizing a substrate causes channeling during the ion implantation to be suppressed, so that a shallow implantation distribution may be formed. Specifically, an implantation distribution whose so-called tailing is small may be formed. Then, executing annealing later effects solid-phase epitaxial regrowth by which an amorphous layer recovers to a crystal layer, bringing about a high activation rate of an impurity and a shallow junction depth. In the present manufacturing method example, it can be said that pre-amorphization preceding B ion implantation for forming the first extension diffusion layers 306a and 306b is done.

Next, a first insulator film composed of silicon oxide with a film thickness of approximately 10 nm and a second insulator film composed of silicon nitride with a film thickness of approximately 40 nm are sequentially deposited all over the surface of the semiconductor substrate 130 including the offset spacers 309a and 309b and the gate electrode 302, for example, by a chemical vapor deposition (CVD) method. After that, the first and second insulator films thus deposited are subjected to anisotropic etching, whereby as shown in portion (a) of Fig. 13, the first side walls 308Aa and 308Ab are formed from the first insulator film and the second side walls 308Ba and 308Bb are formed from the second insulator film over side surfaces of the gate electrode 302 in a direction parallel with a gate length. Note here that the second side walls 308Ba and 308Bb may be composed of silicon oxide instead of silicon nitride or, furthermore, may be formed by a film stack composed of silicon oxide and silicon nitride.

Next, as shown in portion (b) of Fig. 13, second p-type impurity-implanted layers 313Aa and 313Ab are formed by implanting a p-type impurity, i.e. boron ions, into the semiconductor substrate 130 with an implantation energy of approximately 3 keV and in an implantation dose amount of approximately 3 × 10¹⁵/cm² with the gate electrode 302, the offset spacers 309a and 309b, the first side walls 308Aa and 308Ab, and the second side walls 308Ba and 308Bb as masks.

Next, as shown in portion (c) of Fig. 13, the semiconductor substrate 130 is subjected to third rapid thermal processing that heats the substrate to a temperature of 1200°C to 1350°C, for example, by laser annealing and keeps the substrate near the peak temperature for approximately 1 ms. This third rapid thermal processing causes the p-type source diffusion layer 313a and the p-type drain diffusion layer 313b, which are p-type high-concentration impurity diffused layers, to be formed in regions in the semiconductor substrate 130 lateral to the first side walls 308Aa and 308Ab and the second side walls 308Ba and 308Bb. The p-type source diffusion layer 313a and the p-type drain diffusion layer 313b are diffusion layers having boron ions diffused therein, are connected to the first extension diffusion layers 306a and 306b, and have deeper junction planes than the first extension diffusion layers 306a and 306b. Although laser annealing is used in the millisecond rapid thermal processing here, a so-called millisecond annealing (MSA) method such as flash lamp annealing may be used. Further, the third rapid thermal processing may involve the use of annealing that raises the temperature to approximately 850°C to 1050°C at a temperature rise rate of approximately 200°C/sec to 250°C/sec and keeps the peak temperature for a maximum of approximately ten seconds or does not keep the peak temperature, e.g. spike-RTA.

The second rapid thermal processing, which is shown in portion (d) of Fig. 12, may be omitted. In that case, the third rapid thermal processing also serves as the second rapid thermal processing.

Thus, according to the present manufacturing method example, before ion implantation for use in the formation of extension diffusion layers is executed with low energy in the step of forming the first p-type impurity-implanted layers 306Aa and 306Ab as shown in portion (c) of Fig. 12, the semiconductor substrate 130 is amorphized by germanium in the step shown in portion (a) Fig, 12 and then carbon is implanted as an impurity for use in the prevention of diffusion in the step shown in portion (b) of Fig. 12. Carbon has an effect of suppressing transient enhanced diffusion (TED) of impurity atoms. Carbon is effective in the formation of the respective shallow diffusion layers of a p-type field-effect transistor (pFET) and an n-type field-effect transistor (nFET), as carbon greatly suppresses the diffusion of boron and phosphorus.

As mentioned above, in the p-type first extension diffusion layers 306a and 306b, indium (In) may be diffused instead of or in combination with boron (B). Further, in a case where n-type first extension diffusion layers 306a and 306b are employed, phosphorus may be diffused. Carbon is effective in the formation of the respective shallow diffusion layers of a p-type field-effect transistor (pFET) and an n-type field-effect transistor (nFET), as carbon greatly suppresses the diffusion of boron and phosphorus.

Co-implanting carbon into the regions of formation of the first extension diffusion layers 306a and 306b, carbon may eliminate enhanced point defects in the semiconductor substrate 130 during heat treatment. This may reduce enhanced point defects introduced by ion implantation. This is advantageous from the point of view of suppressing TED of impurities to keep the junction depth of each diffusion layer shallow. This action is useful especially in the case of impurities such as boron and phosphorus.

It can be understood from the foregoing description that implanting carbon makes it possible to form low-resistance first extension diffusion layers 306a and 306b with shallow junctions, reduced junction leaks, and suppressed increases in value of resistance due to dose loss.

As noted above, heat treatment for heating the pixel region R1 is executed, and the first peripheral region R2 may be heated too by that heat treatment. However, even in a case where such heat treatment is executed, a diffusion-suppressing effect based on carbon implantation and an associated effect are brought about.

In one specific example, an interlayer film is deposited in both the pixel region R1 and the first peripheral region R2 after the activation thermal processing of portion (c) of Fig. 13. The interlayer film is for example an NSG (non-doped silicate glass) film. Next, an opening is formed in the interlayer film in the pixel region R1. After the formation of the opening, implantation of, for example, a impurity region that constitutes the charge accumulation region Z may be executed in the pixel region R1. Next, open plug portions are embedded in the pixel region R1 by depositing polysilicon so that the opening is filled. The polysilicon may be doped with phosphorus. Next, the pixel region R1, including the plug portions, is subjected to heat treatment. This heat treatment is executed, for example, for approximately ten minutes at 700°C to 850°C. This heat treatment causes the first peripheral region R2 to be heated too. However, in the first peripheral region R2, the diffusion-suppressing effect based on carbon implantation suppresses the redistribution of the impurity, making it possible to maintain the shallow junction.

Even with attention focused only on the manufacture of the first peripheral transistor 27 of the first peripheral region R2, the diffusion-suppressing effect based on carbon implantation is effective. Furthermore, as noted above, even in a case where the first peripheral region R2 is heated by an additional step of heat treatment for heating the pixel region R1, the diffusion-suppressing effect based on carbon implantation may be exerted.

It should be noted that only phosphorus (P) may be used in the first pocket diffusion layers 307a and 307b, which are N-type pocket diffusion layers. Using phosphorus is more effective in preventing the diffusion of carbon ions than using arsenic (As).

Amorphization may occur during implantation of arsenic for the first pocket diffusion layers 307a and 307b. For example, such a phenomenon tends to occur in a case where the implantation dose amount of arsenic is larger than or equal to 5 × 10¹³/cm².

### [Method for Manufacturing First Peripheral Transistor according to Second Configuration Example]

The following describes, with reference to Fig. 15, a method for manufacturing a first peripheral transistor 27 according to the second configuration example shown in Figs. 6A and 6B. Fig. 15 illustrates cross-sectional views showing the method for manufacturing a first peripheral transistor 27 according to the second configuration example. A description of configurations that the second configuration example has in common with the first configuration example may be omitted.

In a case where a first peripheral transistor 27 according to the second configuration example is manufactured, as described with reference to portion (a) of Fig. 10, silicon (Si) is epitaxially grown over a supporting substrate 140. As a result of this, a first epitaxial layer 135 is formed over the supporting substrate 140. Note, however, that the subsequent steps described with reference to portions (b) to (d) of Fig. 10 are omitted. That is, the formation of a recessed portion 135c, the formation of a second epitaxial layer 136, and the formation of a third epitaxial layer 137 are not performed. On the structure in which the first epitaxial layer 135 is formed over the supporting substrate 140, the steps described with reference to portion (a) of Fig. 11 to portion (a) of Fig. 13 are executed. As a result of this, a structure shown in portion (a) of Fig. 15 is obtained.

In the structure shown in portion (a) of Fig. 15, the first epitaxial layer 135 includes the N-type channel diffusion layer 303, the first extension diffusion layers 306a and 306b, and the first pocket diffusion layers 307a and 307b. The first side walls 308Aa and 308Ab, and the second side walls 308Ba and 308Bb are provided over the first epitaxial layer 135.

Next, as shown in portion (b) of Fig. 15, regions of the first epitaxial layer 135 lateral to the first side walls 308Aa and 308Ab, and the second side walls 308Ba and 308Bb are recessed, whereby a first recessed portion 133 and a second recessed portion 134 are formed. Specifically, the first recessed portion 133 and the second recessed portion 134 are formed by anisotropic etching or other processes. More specifically, the first recessed portion 133 and the second recessed portion 134 are formed by anisotropic etching or other processes with the gate electrode 302, the offset spacers 309a and 309b, the first side walls 308Aa and 308Ab, and the second side walls 308Ba and 308Bb as masks.

Next, as shown in portion (c) of Fig. 15, silicon germanium (SiGe) is subjected to in-situ-dope epitaxial growth in the first recessed portion 133 and the second recessed portion 134. In this example, the in-situ-dope epitaxial growth involves the use of boron as an impurity. As a result of this, a fourth epitaxial layer 138 is formed over the first recessed portion 133. Further, the p-type source diffusion layer 313a is formed of the fourth epitaxial layer 138. A fifth epitaxial layer 139 is formed over the second recessed portion 134. Further, the p-type drain diffusion layer 313b is formed of the fifth epitaxial layer 139.

The carbon-implanted layers 311 shown in Fig. 6B may be formed at any timing. This timing may precedes the formation of the first recessed portion 133 and the second recessed portion 134 shown in portion (b) of Fig. 15 or may follow the formation of the first recessed portion 133 and the second recessed portion 134.

As mentioned above with reference to Fig. 6D, the fourth epitaxial layer 138 has an embedded portion 138e and a raised portion 138r. The fifth epitaxial layer 139 has an embedded portion 139e and a raised portion 139r. The embedded portion 138e and the embedded portion 139e constitute an eSiGe (embedded SiGe) layer. The raised portion 138r and the raised portion 139r constitute an rSiGe (raised SiGe) layer.

When silicon germanium of the fourth epitaxial layer 138 is denoted by Si₁₋ₓGeₓ, X is larger than 0 and smaller than 1. In one example, X is greater than or equal to 0.1 and less than or equal to 0.8. In one specific example, X is greater than or equal to 0.1 and less than or equal to 0.65.

When silicon germanium of the fifth epitaxial layer 139 is denoted by Si₁₋ₓGeₓ, X is larger than 0 and smaller than 1. In one example, X is greater than or equal to 0.1 and less than or equal to 0.8. In one specific example, X is greater than or equal to 0.1 and less than or equal to 0.65.

In this example, a first combination of the embedded portion 138e and the raised portion 138r and a second combination of the embedded portion 139e and the raised portion 139r are formed. The N-type channel diffusion layer 303 is pushed in from the first combination and the second combination. This causes a compression strain on the N-type channel diffusion layer 303. The compression strain brings about improvement in hole mobility. This may improve the driving force of the first peripheral transistor 27 and increase the speed of operation of the first peripheral transistor 27.

The raised portion 138r and the raised portion 139r may not be formed. In this case, N-type channel diffusion layer 303 is pushed in from the embedded portion 138e and the embedded portion 139e. This causes a compression strain on the N-type channel diffusion layer 303.

The embedded portion 138e and the embedded portion 139e may not be formed. In this case, the N-type channel diffusion layer 303 suffers from a compression strain based on the difference in lattice constant between a SiGe layer constituting the raised portion 138r and the raised portion 139r and a Si layer constituting the first epitaxial layer 135.

As can be understood from the foregoing description, in the first configuration example, the N-type channel diffusion layer 303 has a cSiGe layer. In the second configuration example, the p-type source diffusion layer 313a is formed of at least one selected from the group consisting of eSiGe and rSiGe, and the p-type drain diffusion layer 313b is formed of at least one selected from the group consisting of eSiGe and rSiGe.

The first configuration example and the second configuration example may be combined. Specifically, the N-type -channel diffusion layer 303 may have a cSiGe layer, the p-type source diffusion layer 313a may be formed of at least one selected from the group consisting of eSiGe and rSiGe, and the p-type drain diffusion layer 313b may be formed of at least one selected from the group consisting of eSiGe and rSiGe.

A transistor according to the present disclosure and a method for manufacturing the same can achieve reductions in junction depth and resistance of an extension diffusion layer along with miniaturization, and are effective in a MIS transistor having high driving force and a method for manufacturing the same.

### (Transistors of Pixel Region R1 and First Peripheral Region R2)

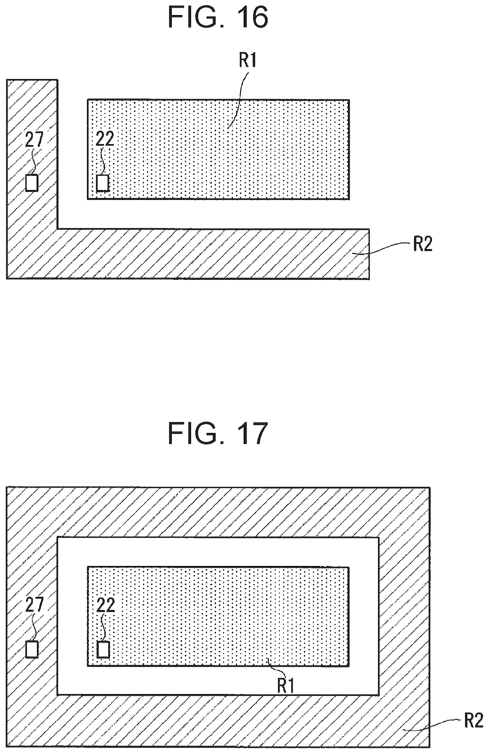

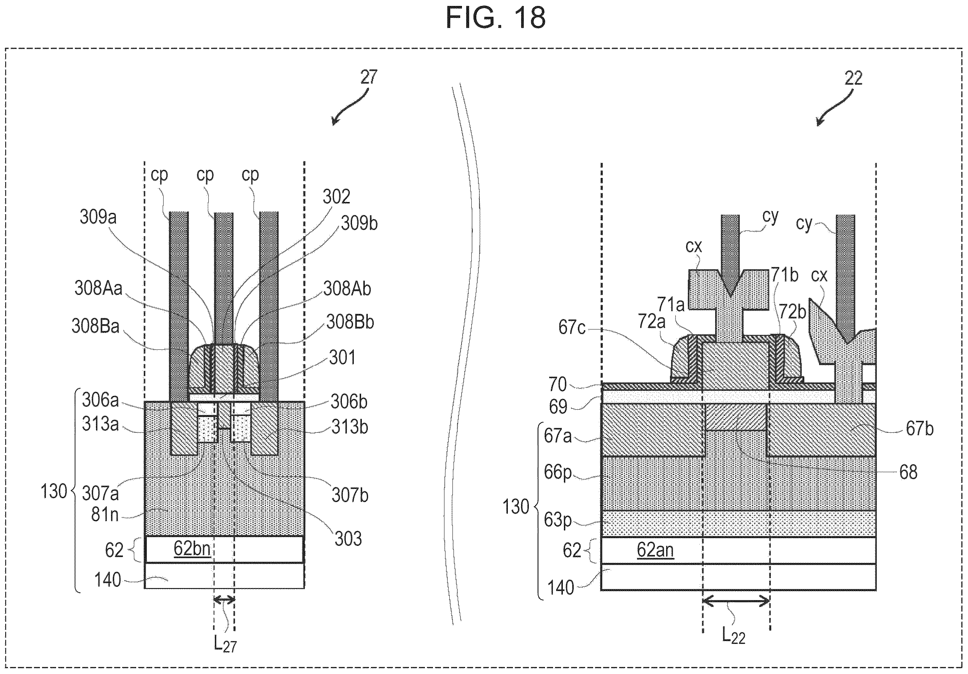

The following further describes the transistors of the pixel region R1 and the first peripheral region R2 with reference to Figs. 16 to 27. Figs. 16, 17, 19, 20, 21, 22, 24, and 25 are schematic plan views illustrating transistors of pixel regions and transistors of peripheral regions. Figs. 18, 23, 26, and 27 illustrate schematic cross-sectional views showing transistors of pixel regions and transistors of peripheral regions. It should be noted that Figs. 16 to 27 omit to illustrate the blocking regions 200A and 200B.

In the following, the previously-used terms are sometimes replaced by different terms. For example, one of the p-type source diffusion layer 313a and the p-type drain diffusion layer 313b is sometimes referred to as "source", and the other as "drain". The N-type channel diffusion layer 303 is sometimes referred to as "channel region". Note, however, that the following source may be referred to as "source diffusion layer", the drain as "drain diffusion layer", and the channel region as "channel diffusion layer". It should be noted that the channel region may include part or the whole of a pocket diffusion layer.

In the following, the source of the first peripheral transistor 27 is sometimes referred to as "first source". The drain of the first peripheral transistor 27 is sometimes referred to as "first drain". The channel region of the first peripheral transistor 27 is sometimes referred to as "first channel region".

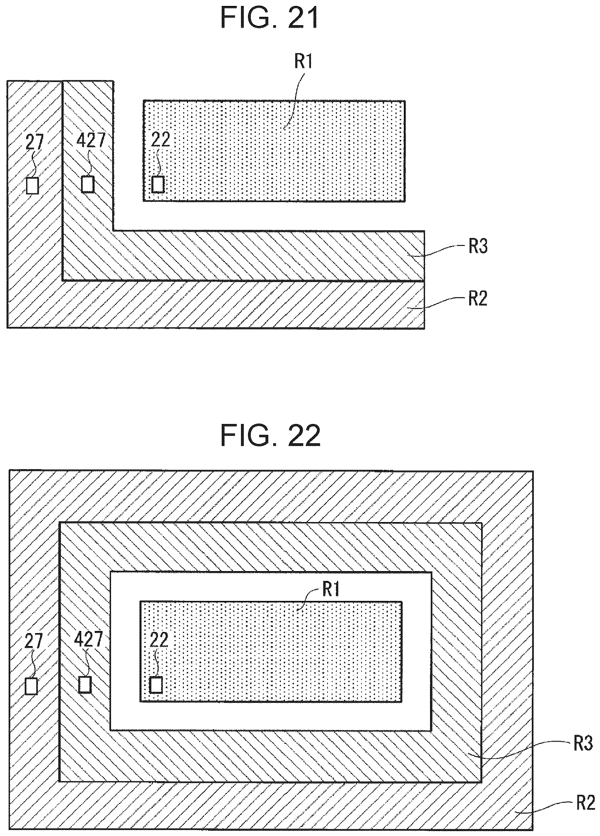

As shown in Figs. 21 and 22, the imaging device may include a second peripheral region R3. In each of the examples shown in Figs. 21 and 22, the second peripheral region R3 is located between the pixel region R1 and the first peripheral region R2 in a plan view.

One semiconductor substrate 130 may spread over both the pixel region R1 and the first peripheral region R2, or the pixel region R1 may be constituted using one semiconductor substrate and the first peripheral region R2 may be constituted using another semiconductor substrate. One semiconductor substrate 130 may spread astride three regions, namely the pixel region R1, the first peripheral region R2, and the second peripheral region R3, or the pixel region R1 may be constituted using one semiconductor substrate, the first peripheral region R2 may be constituted using another semiconductor substrate, and the second peripheral region R3 may be constituted using still another semiconductor substrate. One semiconductor substrate 130 may spread astride the pixel region R1 and the first peripheral region R2, and the second peripheral region R3 may be constituted using another semiconductor substrate. Further, the pixel region R1 may be constituted using one semiconductor substrate, and one semiconductor substrate 130 may spread astride the first peripheral region R2 and the second peripheral region R3. Thus, the imaging device may have at least one semiconductor substrate.

In the following, the terms "pixel substrate portion", "first peripheral substrate portion", and "second peripheral substrate portion" are sometimes used. The term "pixel substrate portion" refers to a portion of at least one semiconductor substrate 130 that belongs to the pixel region R1. The term "first peripheral substrate portion" refers to a portion of at least one semiconductor substrate 130 that belongs to the first peripheral region R2. The term "second peripheral substrate portion" refers to a portion of at least one semiconductor substrate 130 that belongs to the second peripheral region R3.

The pixel substrate portion may be referred to specifically as "pixel semiconductor substrate portion". The first peripheral substrate portion may be referred to specifically as "first semiconductor substrate portion". The second peripheral substrate portion may be referred to specifically as "second semiconductor substrate portion".

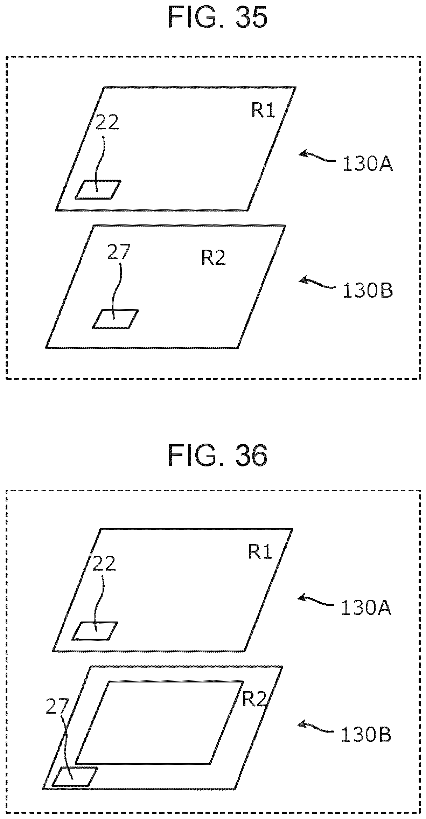

The term "pixel transistor" is described. A pixel transistor is a transistor that the pixel region R1 has. For example, an amplifying transistor 22, an address transistor 24, and a reset transistor 26 may fall under the category of pixel transistors. Figs 16 to 33 illustrate an amplifying transistor 22 as a pixel transistor. Further, the following describes a case where a pixel transistor is an amplifying transistor 22. Note, however, that unless otherwise noted, the term "amplifying transistor 22" can be read as "pixel transistor, "address transistor 24", or "reset transistor 26" in the following description. Elements, such as a source and a drain, that a transistor has and elements, such as wires, associated with a transistor may be read as appropriate. In these respects, the same applies to Figs. 35 to 48B.

The gate insulator film of a pixel transistor may be referred to as "pixel gate insulator film". The gate insulator film of a first peripheral transistor may be referred to as "first peripheral gate insulator film". The gate insulator film of a second peripheral transistor may be referred to as "second peripheral gate insulator film".

Fig. 16 schematically shows an amplifying transistor 22 in the pixel region R1 and a first peripheral transistor 27 in the first peripheral region R2 in a case where the configuration of Fig. 1 is adopted. Fig. 17 schematically shows an amplifying transistor 22 in the pixel region R1 and a first peripheral transistor 27 in the first peripheral region R2 in a case where the configuration of Fig. 4 is adopted.

In each of the examples shown in Figs. 16 and 17, the first peripheral region R2 is located outside the pixel region R1. Specifically, the first peripheral region R2 is located outside the pixel region R1 in a plan view.

The first peripheral region R2 may be provided with elements such as an image signal processor (ISP) and a memory. In the first peripheral region R2, elements such as an ISP and a memory may be stacked in multiple layers.

Fig. 18 shows configurations that the amplifying transistor 22 in the pixel region R1 and the first peripheral transistor 27 in the first peripheral region R2 may have in each of the examples shown in Figs. 16 and 17. In the example shown in Fig. 18, the amplifying transistor 22 is an N-channel MOSFET, and the first peripheral transistor 27 is a P-channel MOSFET. Note, however, that as mentioned above, these transistors are not limited to particular conductivity types. In this respect, the same applies to the after-mentioned second peripheral transistors 427, 727, and 827.

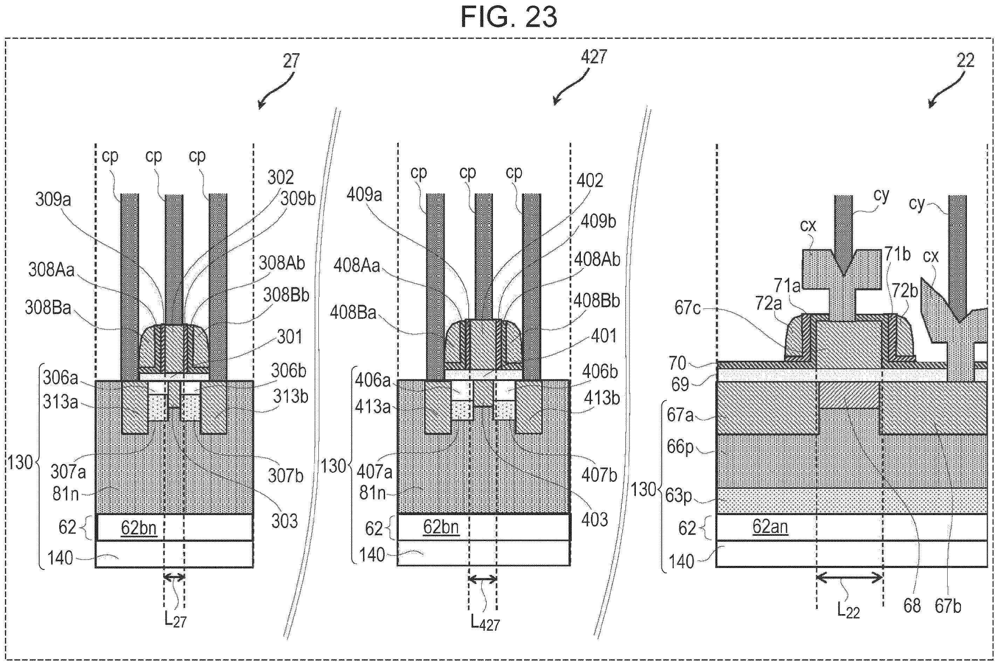

In the example shown in Fig. 18, the first peripheral transistor 27 is similar to that described with reference to Figs. 5A and 5B. Fig. 18 omits to illustrate the first epitaxial layer 135, the second epitaxial layer 136, and the third epitaxial layer 137. Note, however, that in the example shown in Fig. 18, another transistor may be employed instead of the first peripheral transistor 27 of Figs. 5A and 5B. For example, the transistor described with reference to Figs. 6A to 6D may be employed. Further, the transistor according to the modification described with reference to Fig. 7, 8, or 9 may be employed. In these respects, the same applies to the examples shown in Figs. 23, 26, and 27 or other drawings.

In the example shown in Fig. 18, a contact plug cp is connected to the p-type source diffusion layer 313a, which serves as the first source of the first peripheral transistor 27. A contact plug cp is connected to the p-type drain diffusion layer 313b, which serves as the first drain of the first peripheral transistor 27. A contact plug cp is connected to the gate electrode 302 of the first peripheral transistor 27.

In one example, the contact plugs cp are metal plugs. Examples of metal that the contact plugs cp may contain include tungsten and copper.

In the example shown in Fig. 18, the amplifying transistor 22 has a source 67a, a drain 67b, and a gate electrode 67c. The source 67a is an n-type impurity region. The drain 67b is an n-type impurity region. The gate electrode 67c is made, for example, of a polysilicon material.

A channel region 68 is formed between the source 67a and the drain 67b. The channel region 68 is an n-type impurity region.

A gate insulator film 69 is formed between the gate electrode 67c and the pixel substrate portion. Specifically, the gate insulator film 69 is an oxide film. In one example, the gate insulator film 69 contains silicon oxide, and in one specific example, the gate insulator film 69 contains silicon dioxide.

An offset spacer 70 is formed over the gate electrode 67c and the gate insulator film 69. In one example, the offset spacer 70 contains silicon oxide, and in one specific example, the offset spacer 70 contains silicon dioxide.

A first side wall 71a is formed on a portion of the offset spacer 70 beside the source 67a. In the example shown in Fig. 18, the first side wall 71a has an L-shaped cross-section. A second side wall 72a is formed on an outer side of the first side wall 71a.

A first side wall 71b is formed on a portion of the offset spacer 70 beside the drain 67b. In the example shown in Fig. 18, the first side wall 71b has an L-shaped cross-section. A second side wall 72b is formed on an outer side of the first side wall 71b.

In one example, the first side wall 71a contains silicon oxide, and in one specific example, the first side wall 71a contains silicon dioxide. In this respect, the same applies to the first side wall 71b. In one example, the second side wall 72a has a stacked structure including a plurality of insulating layers, and in one specific example, the second side wall 72a includes a silicon dioxide layer and a silicon nitride layer. In this respect, the same applies to the second side wall 72b.

The offset spacer 70 has a through-hole formed over the gate electrode 67c. A contact plug cx is connected to the gate electrode 67c via the through-hole. The gate insulator film 69 and the offset spacer 70 have through-holes formed over the drain 67b. A contact plug cx is connected to the drain 67b via the through-holes.

The contact plugs cx are for example polysilicon plugs. The contact plugs cx may be doped with an impurity such as phosphorus for higher electric conductivity.

It should be noted that an embodiment in which a contact plug cx is connected to the source 67a may be adopted. Specifically, the gate insulator film 69 and the offset spacer 70 have through-holes formed over the source 67a, and a contact plug cx is connected to the source 67a via the through-holes.

The contact plug cx connected to the gate electrode 67c is connected to a plug cy. The contact plug cx connected to the drain 67b is connected to a plug cy. In a case where a contact plug cx connected to the source 67a is present, the contact plug cx may be connected to a plug cy.

In one example, the plugs cy are metal plugs. Examples of metal that the contact plugs cy may contain include tungsten and copper.

As can be understood from the description with reference to Figs. 1 to 18, an imaging device according to the present embodiment includes a pixel region R1 and a first peripheral region R2. The pixel region R1 has a pixel substrate portion. The first peripheral region R2 has a first peripheral substrate portion. Signals are transmitted between the pixel region R1 and the first peripheral region R2. Specifically, the first peripheral region R2 is located outside the pixel region R1. More specifically, the first peripheral region R2 is located outside the pixel region R1 in a plan view.

The pixel region R1 has an amplifying transistor 22. The amplifying transistor 22 is provided in the pixel substrate portion. The first peripheral region R2 has a first peripheral transistor 27. The first peripheral transistor 27 is provided in the first peripheral substrate portion. In one example, the first peripheral transistor 27 is a logic transistor. The first peripheral transistor 27 may be a planar transistor, or may be a three-dimensional structural transistor. A first example of a three-dimensional structural transistor is a FinFET (fin field-effect transistor). A second example of a three-dimensional structural transistor is a GAA (gate all around) such as a nanowire FET. A third example of a three-dimensional structural transistor is a nanosheet FET.

In the present embodiment, the amplifying transistor 22 outputs a signal voltage corresponding to signal charge obtained by photoelectric conversion. The photoelectric conversion is carried out in a photoelectric conversion layer 12. Specifically, there are provided a path that leads the signal charge from the photoelectric conversion layer 12 to a charge accumulation region Z and a path that leads the signal charge from the charge accumulation region Z to a gate electrode 67c of the amplifying transistor 22. In the example shown in Fig. 3, the charge accumulation region Z corresponds to an impurity region 60n. As mentioned above, the charge accumulation region Z is included in a charge accumulation node FD.

As shown in Fig. 18, in the present embodiment, the gate length L₂₇ of the first peripheral transistor 27 is shorter than the gate length L₂₂ of the amplifying transistor 22.

The ratio L₂₇/L₂₂ of the gate length L₂₇ of the first peripheral transistor 27 to the gate length L₂₂ of the amplifying transistor 22 is for example lower than or equal to 0.8, or may be lower than or equal to 0.34. This ratio is for example higher than or equal to 0.01, or may be higher than or equal to 0.05.

The term "gate length" here refers to a dimension of a gate electrode in a direction from a source to a drain or from the drain to the source. The term "gate width" refers to a dimension of a gate electrode in a direction orthogonal to a direction parallel with a gate length in a plan view. The direction orthogonal to a direction parallel with a gate length in a plan view may also be referred to as "depth direction".

In the present embodiment, the gate insulator film 301 of the first peripheral transistor 27 is thinner than the gate insulator film 69 of the amplifying transistor 22.

The ratio T₃₀₁/T₆₉ of the thickness T₃₀₁ of the gate insulator film 301 of the first peripheral transistor 27 to the thickness T₆₉ of the gate insulator film 69 of the amplifying transistor 22 is for example lower than or equal to 0.7, or may be lower than or equal to 0.36. This ratio is for example higher than or equal to 0.1, or may be higher than or equal to 0.2.

In the present embodiment, the first peripheral transistor 27 has the p-type source diffusion layer 313a, which serves as the first source, the p-type drain diffusion layer 313b, which serves as the first drain, and the N-type channel diffusion layer 303, which serves as the first channel region, within the first peripheral substrate portion.

The first channel region is located between the first source and the first drain. Further, the first channel region is located in a region including an area under the gate of the first peripheral transistor 27. The term "area under the gate of the first peripheral transistor 27" refers to a portion of a path of charge between the first source and the first drain that overlaps the gate electrode 302 in a plan view.

In the present embodiment, the first peripheral transistor 27 has a first strain-introducing layer within the first peripheral substrate portion. The first strain-introducing layer brings a strain to the N-type channel diffusion layer 303, which serves as the first channel region. The strain brings about improvement in the carrier mobility of the first channel region. This configuration is suitable to improving the performance of an imaging device. The strain that the first strain-introducing layer brings to the first channel region may be a compression strain or may be a tensile strain.

For example, the first peripheral substrate portion has a first foundation layer. The first foundation layer is adjacent to the first strain-introducing layer. The first foundation layer is a foundation of the first strain-introducing layer. The lattice constant of a crystal lattice of the first strain-introducing layer and the lattice constant of a crystal lattice of the first foundation layer are different from each other. The first channel region has a strain attributed to this difference. This strain brigs about improvement in the carrier mobility of the first channel region. In a typical example, the first foundation layer is a single-crystal layer of silicon.

In one example, the first foundation layer is the first epitaxial layer 135. In another example, the first foundation layer is the supporting substrate 140. In still another example, the first foundation layer is a well in the first peripheral substrate portion. This well may or may not be one that the first peripheral substrate portion and the pixel substrate portion share with each other.

Specifically, the first strain-introducing layer and the first foundation layer may be epitaxial layers. Further, the first strain-introducing layer may be thinner than the first foundation layer. A configuration in which the first strain-introducing layer is thin is expected to express a quantum-confined effect.

For example, the first strain-introducing layer is a crystal layer. Specifically, in the crystal layer, a crystal lattice is constituted by atoms or molecules in the layer being regularly and periodically arrayed.

For example, the first strain-introducing layer is a crystal layer of silicon germanium (SiGe), a crystal layer of germanium (Ge), a crystal layer of a Group III-V compound, a crystal layer of silicon carbide (SiC), a crystal layer of transition metal dichalcogenide (TMD), or a crystal layer of carbon nanotubes (CNTs). Examples of Group III-V compounds include InGaAs, InP, GaAs, InAs, InSb, InGaSb, and AlGaSb.

Examples of the first strain-introducing layer in a case where the first peripheral transistor 27 is a P-channel transistor include a crystal layer of silicon germanium, a crystal layer of germanium, a crystal layer of transition metal dichalcogenide, a crystal layer of carbon nanotubes, and a crystal layer of a Group III-V compound. Examples of the first strain-introducing layer in a case where the first peripheral transistor 27 is an N-channel transistor include a crystal layer of silicon carbide, a crystal layer of transition metal dichalcogenide, and a crystal layer of carbon nanotubes.

In one specific example, the first strain-introducing layer is a crystal layer of Si₁₋ₓGeₓ. X is larger than 0 and smaller than 1. X may be greater than or equal to 0.1 and less than or equal to 0.8. X may be greater than or equal to 0.1 and less than or equal to 0.65.

In the present embodiment, the first strain-introducing layer is a single-crystal layer. Further, the first strain-introducing layer is an epitaxial layer.

In the present embodiment, the conductivity type of the first peripheral transistor 27 is different from the conductivity type of the amplifying transistor 22.

In the first peripheral transistor 27 according to the first configuration example, the N-type channel diffusion layer 303, which serves as the first channel region, includes a first strain-introducing layer.

In one specific example, the first peripheral transistor 27 according to the first configuration example has the configuration described with reference to Figs. 5A and 5B. The first strain-introducing layer is constituted using the second epitaxial layer 136. In the first channel region, an interface between the first epitaxial layer 135 and the second epitaxial layer 136 is formed. The first epitaxial layer 135 and the second epitaxial layer 136 are different in lattice constant from each other. This causes a strain on the first channel region. The strain brings about improvement in carrier mobility. This may improve the driving force of the first peripheral transistor 27 and increase the speed of operation of the first peripheral transistor 27. This brings about improvement in the characteristics of the first peripheral transistor 27. Further, this is advantageous from the point of view of reducing the area of the first peripheral region R2.

In the first peripheral transistor 27 according to the second configuration example, the p-type source diffusion layer 313a, which serves as the first source, includes a first strain-introducing layer. The p-type drain diffusion layer 313b, which serves as the first drain, includes a first strain-introducing layer. That is, the first peripheral transistor 27 includes a plurality of the first strain-introducing layers. The first strain-introducing layer included in the first source and the first strain-introducing layer included in the first drain are different from each other.

In one specific example, the first peripheral transistor 27 according to the second configuration example has the configuration described with reference to Figs. 6A to 6D. The first strain-introducing layer included in the first source is constituted using the fourth epitaxial layer 138. The first strain-introducing layer included in the first drain is constituted using the fifth epitaxial layer 139. The N-type channel diffusion layer 303, which serves as the first channel region, is pushed in from the first source and the first drain. This causes a strain on the first channel region. The strain brings about improvement in carrier mobility. This may improve the driving force of the first peripheral transistor 27 and increase the speed of operation of the first peripheral transistor 27. This brings about improvement in the characteristics of the first peripheral transistor 27. Further, this is advantageous from the point of view of reducing the area of the first peripheral region R2.

In one example, the first peripheral substrate portion has the supporting substrate 140. The first peripheral transistor 27 has a first cap layer within the first peripheral substrate portion. The supporting substrate 140, the first strain-introducing layer, and the first cap layer are arranged in an order from lower to upper parts of the first peripheral transistor 27. The first cap layer includes an upper surface of the first peripheral substrate portion. The concentration of a conductive impurity of the first cap layer is lower than the concentration of a conductive impurity of the supporting substrate 140. This configuration is suitable to improving the performance of an imaging device. The first cap layer may correspond to the aforementioned third epitaxial layer 137.

In the first configuration example and the second configuration example, in a case where the first peripheral transistor 27 is a P-channel transistor, the carrier mobility in the first channel region may be improved by applying a compression strain to the first channel region. In a case where the first peripheral transistor 27 is an N-channel transistor, the carrier mobility of the first channel region may be improved by applying a tensile strain to the first channel region.

According to a first definition, the phrase "concentration of the conductive impurity" in the expression "the concentration of the conductive impurity of the first cap layer is lower than the concentration of the conductive impurity of the supporting substrate 140" is a maximum value of concentration. According to a second definition, the phrase "concentration of the conductive impurity" in this expression is an average concentration. In the aforementioned example, a case where it can be said on the basis of at least either the first definition or the second definition that "the concentration of the conductive impurity of the first cap layer is lower than the concentration of the conductive impurity of the supporting substrate 140" is treated as a case where "the concentration of the conductive impurity in the first cap layer is lower than the concentration of the conductive impurity in the supporting substrate 140".

The first cap layer may be the third epitaxial layer 137 described with reference to Figs. 5A and 5B. The first cap layer may be a single-crystal layer. The first cap layer may be a non-doped epitaxial layer. Note here that the term "non-doped" means that the concentration of an impurity is lower than 5 × 10¹⁶ atoms/cm³.

In one example, the first peripheral transistor 27 has a first specific layer. The first specific layer is located within the first peripheral substrate portion.

Note here that at least one type of impurity that suppresses transient enhanced diffusion of a conductive impurity is defined as "diffusion-suppressing species". In the present embodiment, the first specific layer contains a diffusion-suppressing species. This configuration is suitable to improving the performance of an imaging device. Specifically, this configuration is suitable to improving the performance of the imaging device in consideration of the presence of the first peripheral transistor 27 in the first peripheral region R2. The diffusion-suppressing species may contain at least one selected from the group consisting of carbon, nitrogen, and fluorine.

Note here that at least one type of impurity that induces amorphization of a region into which the at least one type of impurity has been implanted is defined as "amorphizing species". In the present embodiment, the first specific layer contains an amorphizing species. This configuration is suitable to improving the performance of an imaging device. Specifically, this configuration is suitable to improving the performance of the imaging device in consideration of the presence of the first peripheral transistor 27 in the first peripheral region R2. The amorphizing species may contain at least one selected from the group consisting of germanium, silicon, and argon. The amorphizing species may be a trace of pre-amorphization that may enhance the diffusion-suppressing action on the conductive impurity by an impurity exemplified by carbon.

In one example, at least either the first source or the first drain may include the first specific layer.

In one example, the first channel region may include the first specific layer.

In one example, the first peripheral transistor 27 has first extension diffusion layers 306a and 306b. The first extension diffusion layers 306a and 306b are adjacent to the first source or the first drain. The first extension diffusion layers 306a and 306b are shallower than the first source and the first drain. The first extension diffusion layers 306a and 306b include the first specific layer.

The expression "an extension layer and a source are adjacent to each other" specifically means that the extension diffusion layer and the source are connected to each other. The same applies to similar expressions such as the expression "an extension diffusion layer and a drain are adjacent to each other", the expression "a pocket diffusion layer and a source are adjacent to each other", and the expression "a pocket diffusion layer and a drain are adjacent to each other", each of which specifically means that those elements are connected to each other.

The sentence "the first extension diffusion layers 306a and 306b are shallower than the first source and the first drain" means that the deepest portions of the first extension diffusion layers 306a and 306b are at a shallower depth than the deepest portions of the first source and the first drain in a direction parallel with the depth of the first peripheral substrate portion. In this context, the word "shallow" can also be referred to as "shallow injunction depth". Boundaries of an extension diffusion layer, a source, and a drain are junctions. A junction is a place where the concentration of an n-type impurity and the concentration of a p-type impurity are equal to each other.

The expression "the first extension diffusion layers 306a and 306b include the first specific layer" is intended to encompass an embodiment in which the first specific layer falls within the first extension diffusion layers 306a and 306b and an embodiment in which the first specific layer protrudes from the first extension diffusion layers 306a and 306b. The same applies to similar expressions such as the expression "the first pocket diffusion layers 307a and 307b include the first specific layer".

In the illustrated example, the first peripheral transistor 27 has the first extension diffusion layer 306a and the first extension diffusion layer 306b. The first extension diffusion layer 306a is adjacent to the first source. The first extension diffusion layer 306a is shallower than the first source and the first drain. The first extension diffusion layer 306b is adjacent to the first drain. The first extension diffusion layer 306b is shallower than the first source and the first drain. The first extension diffusion layer 306a and the first extension diffusion layer 306b may include the first specific layer.

In one example, the first peripheral transistor 27 has the first pocket diffusion layers 307a and 307b. The first pocket diffusion layers 307a and 307b are adjacent to the first source or the first drain. The first pocket diffusion layers 307a and 307b may include the first specific layer.

In the illustrated example, the first peripheral transistor 27 has the first pocket diffusion layer 307a and the first pocket diffusion layer 307b. The first pocket diffusion layer 307a is adjacent to the first source. The first pocket diffusion layer 307b is adjacent to the first drain. The first pocket diffusion layer 307a and the first pocket diffusion layer 307b may include the first specific layer.

Only one selected from among the first channel region, the first source, the first drain, the first extension diffusion layers, and the first pocket diffusion layers may include the first specific layer. Specifically, only one selected from among the first channel region, the first source, the first drain, the first extension diffusion layer 306a, the first extension diffusion layer 306b, the first pocket diffusion layer 307a, and the first pocket diffusion layer 307b may include the first specific layer.

Two or more selected from among the first channel region, the first source, the first drain, the first extension diffusion layers, and the first pocket diffusion layers may include the first specific layer. Specifically, two or more selected from among the first channel region, the first source, the first drain, the first extension diffusion layer 306a, the first extension diffusion layer 306b, the first pocket diffusion layer 307a, and the first pocket diffusion layer 307b may include the first specific layer. In a case where these selected two or more include the first specific layer, these may include the same or different types of first specific layer. For example, the diffusion-suppressing species of the first source may be carbon, and the diffusion-suppressing species of the first extension diffusion layers 306a and 306b may be nitrogen and fluorine. Further, in this case, these may include the same or different conductivity types of conductive impurity. For example, either the first source or the first pocket diffusion layers 307a and 307b may contain boron whose conductivity type is a p type, and the other may contain phosphorus whose conductivity type is an n type.

As can be understood from the foregoing description, the imaging device may have one or more first specific layers.

Examples of the position of a first specific layer are further described.

As mentioned above, in the first configuration example, the first channel region includes a first strain-introducing layer. In one specific example of the first configuration example, at least one selected from among a configuration (a) and a configuration (b) holds.

In the configuration (a), the first pocket diffusion layers 307a and 307b include the first specific layer. In the configuration (b), regions between the first pocket diffusion layers 307a and 307b and the first strain-introducing layer include the first specific layer.

According to the configuration (a) and/or the configuration (b), possible diffusion of a conductive impurity by TED in directions from the first pocket diffusion layers 307a and 307b toward the first channel region can be suppressed. It should be noted that the regions between the first pocket diffusion layers 307a and 307b and the first strain-introducing layer are for example the first extension diffusion layers 306a and 306b. Specific examples of regions in which the first specific layer may be distributed in the configuration (a) and the configuration (b) are regions that are similar to the regions of the carbon-implanted layers 311 of Fig. 5B.

As mentioned above, in the second configuration example, the first source includes a first strain-introducing layer. The first drain includes a first strain-introducing layer. In one specific example of the second configuration example, the first peripheral substrate portion has a first foundation layer. At least one selected from among a configuration (c) and a configuration (d) holds.

In the configuration (c), there is a first interface between the first foundation layer and the first strain-introducing layer included in the first source. A conductive impurity of the first source spreads in a first region of the first foundation layer astride the first interface. The first region includes the first specific layer.

In the configuration (d), there is a second interface between the first foundation layer and the first strain-introducing layer included in the first drain. A conductive impurity of the first drain spreads in a second region of the first foundation layer astride the second interface. In the configuration (d), the second region includes the first specific layer.

According to the configuration (c), even in a situation where a conductive impurity spreads in the first region of the first foundation layer astride the first interface from the first strain-introducing layer included in the first source, diffusion of the conductive impurity by TED in the first foundation layer can be suppressed. According to the configuration (d), even in a situation where a conductive impurity spreads in the second region of the first foundation layer astride the second interface from the first strain-introducing layer included in the first drain, diffusion of the conductive impurity by TED in the first foundation layer can be suppressed. This may suppress the short channel effect and reduce deterioration of the performance of the first peripheral transistor 27. Specific examples of regions in which the first specific layer may be distributed in the configuration (c) and the configuration (d) are regions that are similar to the regions of the carbon-implanted layers 311 of Fig. 6B.

The following describes an example of a situation in which a technique involving the use of a first specific layer may contribute to such improvement in performance as that noted above.

In the process of manufacturing the imaging device, heat treatment may be executed. The heat treatment may reduce detects in the pixel substrate portion in the pixel region R1. Reducing defects may reduce dark current in the imaging device. Meanwhile, in the first peripheral region R2, the necessity to reduce defects is not necessarily great. On the contrary, in the first peripheral region R2, there is a case where it is necessary to reduce deterioration in performance of the first peripheral transistor 27 attributed to the diffusion of the conductive impurity entailed by the heat treatment. The deterioration in performance is for example an undesirable change in threshold voltage of the first peripheral transistor 27.

In particular, in the present embodiment, the first peripheral transistor 27 includes at least either a first feature or a second feature. The first feature is such a feature that the gate length L₂₇ of the first peripheral transistor 27 is shorter than the gate length L₂₂ of the amplifying transistor 22. The second feature is such a feature that the gate insulator film 301 of the first peripheral transistor 27 is thinner than the gate insulator film 69 of the amplifying transistor 22. In a case where the first peripheral transistor 27 includes at least either the first feature or the second feature, the performance of the first peripheral transistor 27 is susceptible to diffusion redistribution of the conductive impurity due to thermal processing.

Specifically, let thought be given to a first example in which the first specific layer is included in the first extension diffusion layers 306a and 306b and the gate length L₂₇ of the first peripheral transistor 27 is shorter than the gate length L₂₂ of the amplifying transistor 22. In the process of manufacturing the imaging device, heat treatment may be executed. The heat treatment may reduce detects in the pixel substrate portion in the pixel region R1. Reducing defects may reduce dark current in the imaging device. Meanwhile, in a case where L₂₇ < L₂₂, the heating more easily exert a short channel effect in the first peripheral transistor 27 than in the amplifying transistor 22. The short channel effect may change the threshold voltage of a transistor from a desired value and invite a decrease in performance of the transistor. Thus, the heat treatment may bring about an advantage in that dark current is reduced in the pixel region R1 and, on the other hand, bring about an disadvantage in that the short channel effect becomes obvious in the first peripheral region R2.

In this respect, in the first example, the first extension diffusion layers 306a and 306b contain the conductive impurity and the diffusion-suppressing species. The diffusion-suppressing species may contribute to the suppression of the diffusion of the conductive impurity. This diffusion-suppressing action may suppress the short channel effect in the first peripheral transistor 27. This makes it possible to, while enjoying the aforementioned advantage called "dark-current reduction", mitigate the aforementioned disadvantage called "short channel effect".

As noted above, in the first example, the diffusion-suppressing action expressed in the first extension diffusion layers 306a and 306b suppresses the short channel effect of the first peripheral transistor 27 attributed to thermal processing. This means that a margin of a thermal budget of thermal processing becomes wider than in the absence of the diffusion-suppressing action. Therefore, increasing the duration, temperature, or other conditions of thermal processing makes it possible to reduce dark current in the pixel region R1 without making the short channel effect obvious in the first peripheral transistor 27.

Let thought be given to a second example in which the first specific layer is included in at least either the first source or the first drain and the gate length L₂₇ of the first peripheral transistor 27 is shorter than the gate length L₂₂ of the amplifying transistor 22. In the second example too, as in the case of the first example, increasing the duration, temperature, or other conditions of thermal processing makes it possible to reduce dark current in the pixel region R1 without making the short channel effect obvious in the first peripheral transistor 27.

Let thought be given to a third example in which the first specific layer is included in the first pocket diffusion layers 307a and 307b and the gate length L₂₇ of the first peripheral transistor 27 is shorter than the gate length L₂₂ of the amplifying transistor 22. In the third example, variations in the threshold voltage of the first peripheral transistor 27 may be reduced by the diffusion-suppressing action expressed in the first pocket diffusion layers 307a and 307b. For this reason, according to the third example, as in the case of the first example, increasing the duration, temperature, or other conditions of thermal processing makes it possible to reduce dark current in the pixel region R1 without making the variations in the threshold voltage of the first peripheral transistor 27 obvious.

Let thought be given to a fourth example in which the first specific layer is included in the first channel region and the gate length L₂₇ of the first peripheral transistor 27 is shorter than the gate length L₂₂ of the amplifying transistor 22. In the fourth example too, as in the case of the first example, increasing the duration, temperature, or other conditions of thermal processing makes it possible to reduce dark current in the pixel region R1 without making the short channel effect obvious in the first peripheral transistor 27.

As mentioned above, the semiconductor substrate 130 may be a substrate having a semiconductor layer provided on a surface thereof by epitaxial growth. The same applies to the pixel substrate portion, the first peripheral substrate portion, and the second peripheral substrate portion. In a epitaxial layer, unintended inclusion of carbon is easily reduced. This may contribute to reduction of dark current in the pixel region R1. This also makes it easy to make a difference in concentration of the diffusion-suppressing species, such as carbon, between the pixel region R1 and the first peripheral region R2.

As mentioned above, the semiconductor substrate 130 may be a p-type silicon substrate. Note, however, that the semiconductor substrate 130 may be an n-type silicon substrate. The same applies to the pixel substrate portion, the first peripheral substrate portion, and the second peripheral substrate portion.

In one example, the photoelectric conversion layer 12 is stacked over the pixel substrate portion. In a typical example, in a case where a pixel region R1 having such a configuration is fabricated, such thermal processing as noted above is executed. For this reason, an imaging device including a pixel region R1 having this configuration may enjoy the effect of reducing dark current while reducing the deterioration in performance of the first peripheral transistor 27. It should be noted that the concept "the photoelectric conversion layer 12 is stacked over the pixel substrate portion" encompasses an embodiment in which an element such as an insulating layer is interposed between the photoelectric conversion layer 12 and the pixel substrate portion. It can also be said that the photoelectric conversion layer 12 is supported by the pixel substrate portion.

In one example, the pixel substrate portion and the first peripheral substrate portion are included in a single semiconductor substrate 130. In an imaging device having such a configuration, the first peripheral region R2 is easily heated by heat treatment for heating the pixel region R1. An imaging device having such a configuration easily enjoys the effect of reducing dark current while reducing the deterioration in performance of the first peripheral transistor 27. Typically, in an imaging device having such a configuration, the first peripheral region R2 is heated simultaneously during heat treatment for heating the pixel region R1.

The photoelectric conversion layer 12 may be a panchromatic film. Alternatively, the photoelectric conversion layer 12 may be a film, such as an orthochromatic film, that does not have sensitivity to light in a certain range of wavelengths.

The first source, the first drain, and the first extension diffusion layers 306a and 306b may have a conductive impurity of a first conductivity type. On the other hand, the first pocket diffusion layers 307a and 307b and the first channel region may have a conductive impurity of a second conductivity type.

In one specific example, the first peripheral transistor 27 is a logic transistor. The first peripheral transistor 27 can perform a digital operation. In such a first peripheral transistor 27, priority may be placed on speed. In order for a transistor to operate at high speed, it is advantageous for the transistor to be a fine transistor. Further, from the point of view of securing the transistor high driving force too, it is advantageous for the transistor to be a fine transistor. In this respect, in this specific example, the gate length L₂₇ of the first peripheral transistor 27 is shorter than the gate length L₂₂ of the amplifying transistor 22. Further, the gate insulator film 301 of the first peripheral transistor 27 is thinner than the gate insulator film 69 of the amplifying transistor 22. From the point of view of causing the first peripheral transistor 27 to operate at high speed and with high driving force, it may be advantageous for the gate length L₂₇ to be short and for the gate insulator film 301 to be thin. This advantage brought by the gate length L₂₇ being short and the gate insulator film 301 being thin may be exerted, for example, in a case where the first peripheral transistor 27 is a planar transistor. Further, the first peripheral transistor 27 of this specific example is located, for example, between a controller and a pixel driver.

The first peripheral transistor 27 performs a digital operation, for example, in the following manner. That is, a signal from the pixel region R1 is amplified, for example, via a load cell, a column amplifier, or other devices. The signal thus amplified is converted by an analog-digital (AD) converter. The first peripheral transistor 27 receives the digital signal thus obtained and performs a digital operation.

In one example, the first specific layer contains germanium. As can be understood from the foregoing description, in the process of manufacturing the first peripheral transistor 27, germanium may pre-amorphize the inside of the first peripheral substrate portion. In a pre-amorphized region, the diffusion-suppressing action on the conductive impurity by an impurity exemplified by carbon is easily enhanced. In this example, germanium may be a trace of pre-amorphization that may enhance the diffusion-suppressing action on the conductive impurity by an impurity exemplified by carbon.

The first specific layer may contain silicon, argon, krypton, or xenon instead of or in addition to germanium. More generally, the first specific layer may contain at least one element selected from the group consisting of germanium, silicon, argon, krypton, and xenon. These elements may be traces of pre-amorphization that may enhance the diffusion-suppressing action on the conductive impurity by an impurity exemplified by carbon.

In one example, the first peripheral transistor 27 includes an end-of-range (EOR) defect. At least part of the first specific layer is located above the EOR defect and overlaps the EOR detect in a plan view. In this context, the phrase "above the EOR defect" means a side, as seen from the EOR defect, of a surface of the first peripheral substrate portion over which the gate electrode 302 is provided. As noted above, in a pre-amorphized region in the first peripheral substrate portion, the diffusion-suppressing action on the conductive impurity by an impurity exemplified by carbon is easily enhanced. As can be understood from the foregoing description, in a case where in the process of manufacturing the first peripheral transistor 27, thermal processing is executed with the first peripheral substrate portion in an amorphized state, an EOR defect may be formed in a region directly below the amorphous/crystal (a/c) interface before the thermal processing. In this example, the EOR defect may be a trace of pre-amorphization that may enhance the diffusion-suppressing action on the conductive impurity by an impurity exemplified by carbon. The first specific layer in its entirety may be located above the EOR defect and overlaps the EOR defect in a plan view.

In one example, the first peripheral transistor 27 includes a first segregated portion in which the diffusion-suppressing species is segregated in a direction parallel with the depth of the first peripheral substrate portion. At least part of the first specific layer is located above the first segregated portion and overlaps the first segregated portion in a plan view. As noted above, in a pre-amorphized region in the first peripheral substrate portion, the diffusion-suppressing action on the conductive impurity by an impurity exemplified by carbon is easily enhanced. In a case where in the process of manufacturing the first peripheral transistor 27, thermal processing is executed with the first peripheral substrate portion in an amorphized state, a first segregated portion may be formed in a region directly below the amorphous/crystal (a/c) interface before the thermal processing. In this example, the first segregated portion may be a trace of pre-amorphization that may enhance the diffusion-suppressing action on the conductive impurity by an impurity exemplified by carbon. The first specific layer in its entirety may be located above the first segregated portion and overlaps the segregated portion in a plan view. In the expression "first segregated portion in which the diffusion-suppressing species is segregated", the word "segregated" means that the diffusion-suppressing species unevenly distributed, and is not intended to limit the process of forming the first segregated portion.

The first segregated portion is described with reference to a concentration profile serving as a relationship of the concentration of the diffusion-suppressing species with a depth in the first peripheral substrate portion. In a case where the first segregated portion is present, the concentration in the concentration profile takes on a minimal value at a first depth substantially corresponding to the depth of the amorphous/crystal (a/c) interface before thermal processing. The concentration in the concentration profile takes on a maximal value at a second depth that is deeper than the first depth. The first segregated portion refers to a portion of the first peripheral substrate portion that is deeper than the first depth and in which the concentration of the diffusion-suppressing species is higher than the minimal value. In the profile of carbon shown in portion (b) Fig. 14, the legend "ORIGINAL a/c INTERFACE" substantially corresponds to the first depth, and an upwardly-sticking portion directly below the legend "ORIGINAL a/c INTERFACE" corresponds to the first segregated portion.

In the present embodiment, the pixel region R1 includes a charge accumulation region Z. In the charge accumulation region Z, charge generated by photoelectric conversion is accumulated. The charge accumulation region Z is an impurity region. In the example shown in Fig. 3, the charge accumulation region Z corresponds to the impurity region 60n. Specifically, photoelectric conversion is carried out in the photoelectric converter 10, and the charge thus generated is sent to the charge accumulation region Z via a plug cy and a contact plug cx and accumulated in the charge accumulation region Z.

In one example, the first segregated portion is shallower than the charge accumulation region Z. The clause "the first segregated portion is shallower than the charge accumulation region Z" means that the deepest portion of the first segregated portion is at a shallower depth than the deepest portion of the charge accumulation region Z in a direction parallel with the depth of the pixel substrate portion or the first peripheral substrate portion.

In one example, the concentration of carbon in the first specific layer is higher than the concentration of carbon in the charge accumulation region Z. Carbon in the first specific layer may suppress the diffusion of the conductive impurity. Meanwhile, the presence of carbon in the charge accumulation region Z may cause dark current. Therefore, only a high-performance imaging device can have such a feature that the concentration of carbon in the first specific layer is higher than the concentration of carbon in the charge accumulation region Z. In the expression "the concentration of carbon in the first specific layer is higher than the concentration of carbon in the charge accumulation region Z", the concentration of carbon in the charge accumulation region Z may be zero, or may be higher than zero.

Note here that a boundary of the charge accumulation region Z is a junction. As mentioned above, a junction is a place where the concentration of an n-type impurity and the concentration of a p-type impurity are equal to each other.

According to a first definition, the phrase "concentration of carbon" in the expression "the concentration of carbon in the first specific layer is higher than the concentration of carbon in the charge accumulation region Z" is a maximum value of concentration. According to a second definition, the phrase "concentration of carbon" in this expression is an average concentration. In the aforementioned example, a case where it can be said on the basis of at least either the first definition or the second definition that "the concentration of carbon in the first specific layer is higher than the concentration of carbon in the charge accumulation region Z" is treated as a case where "the concentration of carbon in the first specific layer is higher than the concentration of carbon in the charge accumulation region Z".

Let thought be given to a case where the diffusion-suppressing species is carbon. The ratio C2/C1 of the concentration C2 of carbon in the first specific layer to the concentration C1 of carbon in the charge accumulation region Z is for example higher than or equal to 1 × 10⁵. This ratio is for example lower than or equal to 1 × 10¹¹.

Let thought be given to a case where the diffusion-suppressing species is carbon and the first specific layer is included in a first extension diffusion layer. The concentration of the conductive impurity in the first extension diffusion layer is for example higher than or equal to 1 × 10¹⁷ atoms/cm³. The concentration of carbon in the first extension diffusion layer is for example higher than or equal to 1 × 10¹⁷ atoms/cm³. The concentration of the conductive impurity in the first extension diffusion layer is for example lower than or equal to 1 × 10²² atoms/cm³. The concentration of carbon in the first extension diffusion layer is for example lower than or equal to 1 × 10²² atoms/cm³. These descriptions may be applied to both the first extension diffusion layers 306a and 306b.

In one example, the concentration of carbon in the charge accumulation region Z is substantially zero. The clause "the concentration of carbon in the charge accumulation region Z is substantially zero" here means, for example, that the concentration of carbon in the charge accumulation region Z is lower than 5 × 10¹⁶ atoms/cm³. Intentionally-given carbon does not need to be present in the charge accumulation region Z. The concentration of carbon in the charge accumulation region Z may be 0 atoms/cm³.

In one example, the concentration of the diffusion-suppressing species in the first specific layer is for example higher than or equal to 5 × 10¹⁶ atoms/cm³. The ratio of the concentration of the diffusion-suppressing species in the first specific layer to the concentration of the diffusion-suppressing species in the charge accumulation region Z is for example higher than or equal to 1 × 10⁵. This ratio is for example lower than or equal to 1 × 10¹¹.

In the present embodiment, the amplifying transistor 22 has a source 67a, a drain 67b, and a channel region 68 within the first peripheral substrate portion.

The channel region 68 is located between the source 67a and the drain 67b. Further, the channel region 68 is located in a region including an area under the gate of the amplifying transistor 22. The term "area under the gate of the amplifying transistor 22" refers to a portion of a path of charge between the source 67a and the drain 67b that overlaps the gate electrode 67c in a plan view.

In one example, the concentration of carbon in the first specific layer is higher than the concentration of carbon in the channel region 68. This configuration is advantageous from the point of view of reducing dark current. In the expression "the concentration of carbon in the first specific layer is higher than the concentration of carbon in the channel region 68", the concentration of carbon in the channel region 68 may be zero, or may be higher than zero.

According to a first definition, the phrase "concentration of carbon" in the expression "the concentration of carbon in the first specific layer is higher than the concentration of carbon in the channel region 68" is a maximum value of concentration. According to a second definition, the phrase "concentration of carbon" in this expression is an average concentration. In the aforementioned example, a case where it can be said on the basis of at least either the first definition or the second definition that "the concentration of carbon in the first specific layer is higher than the concentration of carbon in the channel region 68" is treated as a case where "the concentration of carbon in the first specific layer is higher than the concentration of carbon in the channel region 68".

The ratio of the concentration of the diffusion-suppressing species in the first specific layer to the concentration of the diffusion-suppressing species in the channel region 68 is for example higher than or equal to 1 × 10⁵. This ratio is for example lower than or equal to 1 × 10¹¹.

In one example, the amplifying transistor 22 has a pixel specific layer. The pixel specific layer is located within the pixel substrate portion. The pixel specific layer contains a conductive impurity.

The conductive impurity of the pixel specific layer and the conductive impurity of the first specific layer may be identical or different in composition to or from each other.

In one example, at least either the source 67a or the drain 67b of the amplifying transistor 22 includes the pixel specific layer.

In one example, the channel region 68 may include the pixel specific layer.

In one example, the amplifying transistor 22 does not have an extension diffusion layer.

Incidentally, the gate electrode 302 of the first peripheral transistor 27 may be made, for example, of phosphorus-doped polysilicon. In that case, however, phosphorus may exude to the first peripheral substrate portion when the first peripheral region R2 is heated by heat treatment for heating the pixel region R1. In this respect, an imaging device according to one example has a high-x metal gate constructed in the first peripheral transistor 27. This makes it possible to reduce or avoid the exudation of the impurity from the gate electrode 302 to the first peripheral substrate portion. This may contribute to the suppression of the short channel effect in the first peripheral transistor 27. Specifically, the high-κ metal gate can be constructed by the gate electrode 302, which is made of metal, and the gate insulator film 301, which is made of a high-x material. The term "high-x material" refers to a material having a higher dielectric constant than silicon dioxide. Examples of high-κ materials include hafnium (Hf), zirconium (Zr), and aluminum (Al). High-κ materials are also referred to as "high-dielectric-constant materials".

The first peripheral region R2 may include one or more first peripheral transistors 27.

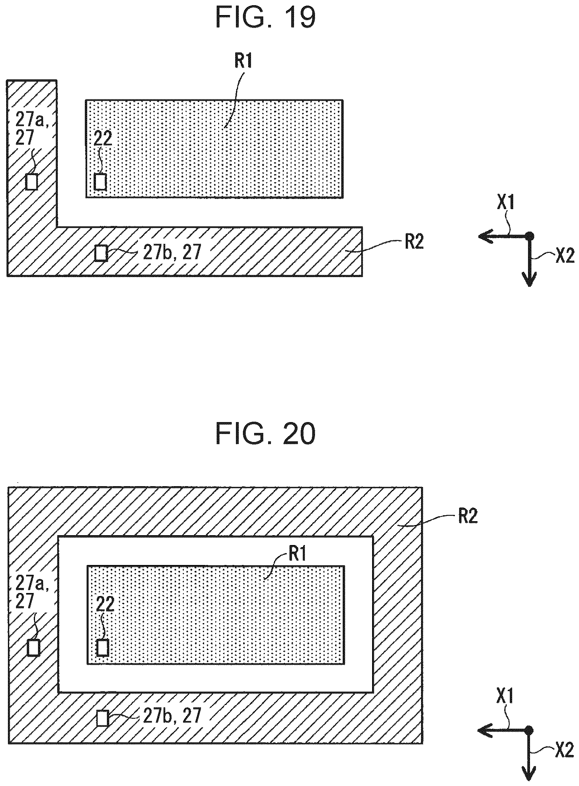

Fig. 19 schematically shows an amplifying transistor 22 in the pixel region R1 and a plurality of the first peripheral transistors 27 in the first peripheral region R2 in a case where the configuration of Fig. 1 is adopted. Fig. 20 schematically shows an amplifying transistor 22 in the pixel region R1 and a plurality of the first peripheral transistors 27 in the first peripheral region R2 in a case where the configuration of Fig. 4 is adopted.

In each of the examples shown in Figs. 19 and 20, a plurality of the first peripheral transistors 27 are present in the first peripheral region R2. The plurality of first peripheral transistors 27 include a first direction transistor 27a and a second direction transistor 27b. The first direction transistor 27a is located in a first direction X1 from the pixel region R1 in a plan view. The second direction transistor 27b is located in a second direction X2 from the pixel region R1 in a plan view. It should be noted that the expression "a plurality of the first peripheral transistors 27 are present" is not intended to mean that those transistors are completely identical. The same applies to the after-mentioned "two first peripheral transistors".

The first direction X1 and the second direction X2 are different from each other. In each of the examples shown in Figs. 19 and 20, the first direction X1 and the second direction X2 are orthogonal to each other.

As shown in Figs. 21 and 22, the imaging device may include a second peripheral region R3. Transmission of signals between the first peripheral region R2 and the pixel region R1 is done via the second peripheral region R3. In each of the examples shown in Figs. 21 and 22, the second peripheral region R3 is located between the pixel region R1 and the first peripheral region R2 in a plan view. Specifically, the second peripheral region R3 is located outside the pixel region R1. More specifically, the second peripheral region R3 is located outside the pixel region R1 in a plan view.

In each of the examples shown in Figs. 21 and 22, the second peripheral region R3 has a second peripheral transistor 427. The second peripheral transistor 427 is provided in the second peripheral substrate portion. In one example, the second peripheral transistor 427 is a logic transistor. The second peripheral transistor 427 may be a planar transistor, or may be a three-dimensional structural transistor. A first example of a three-dimensional structural transistor is a FinFET (fin field-effect transistor). A second example of a three-dimensional structural transistor is a GAA (gate all around) such as a nanowire FET. A third example of a three-dimensional structural transistor is a nanosheet FET.

In the example shown in Fig. 21, the first peripheral region R2 and the second peripheral region R3 are L-shaped in a plan view. In the example shown in Fig. 22, the first peripheral region R2 surrounds the second peripheral region R3 in a plan view, and the second peripheral region R3 surrounds the pixel region R1 in a plan view.

Fig. 23 shows a configuration that the second peripheral transistor 427 in the second peripheral region R3 may have in each of the examples shown in Figs. 21 and 22. In the example shown in Fig. 23, the second peripheral transistor 427 is a P-channel MOSFET.

In the example shown in Fig. 23, the second peripheral transistor 427 of the second peripheral region R3 have similarities to the first peripheral transistor 27 of the first peripheral region R2. Specifically, as is the case with the first peripheral transistor 27, the second peripheral transistor 427 is a MIS transistor. As is the case with the first peripheral transistor 27, the second peripheral transistor 427 includes a gate electrode 402, a second source 413a, a second drain 413b, second extension diffusion layers 406a and 406b, second pocket diffusion layers 407a and 407b, a second channel layer 403, a gate insulator film 401, offset spacers 409a and 409b, first side walls 408Aa and 408Ab, and second side walls 408Ba and 408Bb. As for these constituent elements, the description of the first peripheral transistor 27 can be invoked in the description of the second peripheral transistor 427, provided no contradiction arises.

In one example, the second peripheral transistor 427 has a second specific layer. The second specific layer is located within the second peripheral substrate portion. The second specific layer contains a conductive impurity.

The conductive impurity of the second specific layer and the conductive impurity of the first specific layer may be identical or different in composition to or from each other.

The second specific layer may contain a diffusion-suppressing species. The diffusion-suppressing species that the second specific layer has may be the same as or different from the diffusion-suppressing species that the first specific layer has. For example, the diffusion-suppressing species of the first specific layer may be carbon, and the diffusion-suppressing species of the second specific layer may be nitrogen and fluorine.

In one example, the second peripheral transistor 427 has the second source 413a and the second drain 413b. At least either the second source 413a or the second drain 413b includes the second specific layer.

In the present embodiment, the second peripheral transistor 427 incudes a second source 413a, a second drain 413b, and a second channel region 403 within the second peripheral substrate portion.

The second channel region 403 is located between the second source 413a and the second drain 413b. Further, the second channel region 403 is located in a region including an area under the gate of the second peripheral transistor 427. The term "area under the gate of the second peripheral transistor 427" refers to a portion of a path of charge between the second source 413a and the second drain 413b that overlaps the gate electrode 402 in a plan view.

In the present embodiment, the second peripheral transistor 427 has a second strain-introducing layer within the second peripheral substrate portion. The second strain-introducing layer brings a strain to the second channel region 403. The strain brings about improvement in the carrier mobility of the second channel region 403. This configuration is suitable to improving the performance of an imaging device. The strain that the second strain-introducing layer brings to the second channel region 403 may be a compression strain or may be a tensile strain.

In the present embodiment, the second strain-introducing layer is a crystal layer. Specifically, in the crystal layer, a crystal lattice is constituted by atoms or molecules in the layer being regularly and periodically arrayed.

For example, the second strain-introducing layer is a crystal layer of silicon germanium (SiGe), a crystal layer of germanium (Ge), a crystal layer of a Group III-V compound, a crystal layer of silicon carbide (SiC), a crystal layer of transition metal dichalcogenide (TMD), or a crystal layer of carbon nanotubes (CNTs). Examples of Group III-V compounds include InGaAs, InP, GaAs, InAs, InSb, InGaSb, and AlGaSb.

Examples of the first strain-introducing layer in a case where the second peripheral transistor 427 is a P-channel transistor include a crystal layer of silicon germanium, a crystal layer of germanium, a crystal layer of transition metal dichalcogenide, a crystal layer of carbon nanotubes, and a crystal layer of a Group III-V compound. Examples of the first strain-introducing layer in a case where the second peripheral transistor 427 is an N-channel transistor include a crystal layer of silicon carbide, a crystal layer of transition metal dichalcogenide, and a crystal layer of carbon nanotubes.

In one specific example, the second strain-introducing layer is a crystal layer of Si₁₋ₓGeₓ. X is greater than or equal to 0.1 and less than or equal to 0.85. X may be greater than or equal to 0.1 and less than or equal to 0.65.

In the present embodiment, the second strain-introducing layer is a single-crystal layer. Further, the second strain-introducing layer is an epitaxial layer.

In one example, the first strain-introducing layer and the second strain-introducing layer are crystal layers. In this example, a material of the crystal layer that constitutes the first strain-introducing layer and a material of the crystal layer that constitutes the second strain-introducing layer may be the same as or different from each other. In one specific example, both the first strain-introducing layer and the second strain-introducing layer are silicon-germanium crystal layers. In another specific example, the first strain-introducing layer is a silicon-germanium crystal layer, and the second strain-introducing layer is a germanium crystal layer.

For example, the second peripheral substrate portion has a second foundation layer. The second foundation layer is adjacent to the second strain-introducing layer. The second foundation layer is a foundation of the second strain-introducing layer. The lattice constant of a crystal lattice of the second strain-introducing layer and the lattice constant of a crystal lattice of the second foundation layer are different from each other. The second channel region 403 has a strain attributed to this difference. This strain brigs about improvement in the carrier mobility of the second channel region 403. In a typical example, the second foundation layer is a single-crystal layer of silicon.

In one example, the second foundation layer is the first epitaxial layer 135. In another example, the second foundation layer is the supporting substrate 140. In still another example, the second foundation layer is a well in the second peripheral substrate portion. This well may or may not be one that the second peripheral substrate portion and the first peripheral substrate portion share with each other. This well may or may not be one that the second peripheral substrate portion and the pixel substrate portion share with each other.

Specifically, the second strain-introducing layer and the second foundation layer may be epitaxial layers. Further, the second strain-introducing layer may be thinner than the second foundation layer. A configuration in which the second strain-introducing layer is thin is expected to express a quantum-confined effect.

In the present embodiment, the second strain-introducing layer is a single-crystal layer. Further, the second strain-introducing layer is an epitaxial layer.

In the present embodiment, the conductivity type of the second peripheral transistor 427 is different from the conductivity type of the amplifying transistor 22.

At least one selected from the group consisting of the second channel region 403, the second source 413a, and the second drain 413b may include the second strain-introducing layer.

In the second peripheral transistor 427 according to the first configuration example, the second channel region 403 includes a second strain-introducing layer.

In one specific example, the second peripheral transistor 427 according to the first configuration example has the configuration described with reference to Figs. 5A and 5B.

In the second peripheral transistor 427 according to the second configuration example, the second source 413a includes a second strain-introducing layer. The second drain 413b includes a second strain-introducing layer. That is, the second peripheral transistor 427 includes a plurality of the second strain-introducing layers. The second strain-introducing layer included in the second source 413a and the second strain-introducing layer included in the second drain 413b are different from each other.

In one specific example, the second peripheral transistor 427 according to the second configuration example has the configuration described with reference to Figs. 6A to 6D.

In one example, the second peripheral substrate portion has the supporting substrate 140. The second peripheral transistor 427 has a second cap layer within the second peripheral substrate portion. The supporting substrate 140, the second strain-introducing layer, and the second cap layer are arranged in an order from lower to upper parts of the second peripheral transistor 427. The second cap layer includes an upper surface of the second peripheral substrate portion. The concentration of a conductive impurity of the second cap layer is lower than the concentration of a conductive impurity of the supporting substrate 140.

The second cap layer may be an epitaxial layer that is similar to the third epitaxial layer 137 described with reference to Figs. 5A and 5B. The second cap layer may be a single-crystal layer. The second cap layer may be a non-doped epitaxial layer.

In one example, the second channel region 403 may include the second specific layer.

In one example, the second peripheral transistor 427 has second extension diffusion layers 406a and 406b. The second extension diffusion layers 406a and 406b are adjacent to the second source 413a or the second drain 413b. The second extension diffusion layers 406a and 406b are shallower than the second source 413a and the second drain 413b. The second extension diffusion layers 406a and 406b may include the second specific layer.

The sentence "a second extension diffusion layer is shallower than the second source 413a and the second drain 413b" means that the deepest portion of the second extension diffusion layer is at a shallower depth than the deepest portions of the second source 413a and the second drain 413b in a direction parallel with the depth of the second peripheral substrate portion. In this context, the word "shallow" can also be referred to as "shallow injunction depth".

In the illustrated example, the second peripheral transistor 427 has the second extension diffusion layer 406a and the second extension diffusion layer 406b. The second extension diffusion layer 406a is adjacent to the second source 413a. The second extension diffusion layer 406a is shallower than the second source 413a and the second drain 413b. The second extension diffusion layer 406b is adjacent to the second drain 413b. The second extension diffusion layer 406b is shallower than the second source 413a and the second drain 413b. The second extension diffusion layer 406a and the second extension diffusion layer 406b may include the second specific layer.

In one example, the second peripheral transistor 427 has second pocket diffusion layers 407a and 407b. The second pocket diffusion layers 407a and 407b are adjacent to the second source 413a or the second drain 413b. The second pocket diffusion layers 407a and 407b may include the second specific layer.

In the illustrated example, the second peripheral transistor 427 has the second pocket diffusion layer 407a and the second pocket diffusion layer 407b. The second pocket diffusion layer 407a is adjacent to the second source 413a. The second pocket diffusion layer 407b is adjacent to the second drain 413b. The second pocket diffusion layer 407a and the second pocket diffusion layer 407b may include the second specific layer.

Only one selected from among the second channel region 403, the second source 413a, the second drain 413b, the second extension diffusion layer, and the second pocket diffusion layers may include the second specific layer. Specifically, only one selected from among the second channel region 403, the second source 413a, the second drain 413b, the second extension diffusion layer 406a, the second extension diffusion layer 406b, the second pocket diffusion layer 407a, and the second pocket diffusion layer 407b may include the second specific layer.

Two or more selected from among the second channel region 403, the second source 413a, the second drain 413b, the second extension diffusion layer, and the second pocket diffusion layers may include the second specific layer. Specifically, two or more selected from among the second channel region 403, the second source 413a, the second drain 413b, the second extension diffusion layer 406a, the second extension diffusion layer 406b, the second pocket diffusion layer 407a, and the second pocket diffusion layer 407b may include the second specific layer. In a case where these selected two or more include the second specific layer, these may include the same or different types of diffusion-suppressing species. For example, the diffusion-suppressing species of the second source 413a may be carbon, and the diffusion-suppressing species of the second extension diffusion layers 406a and 406b may be nitrogen and fluorine. Further, in this case, these may include the same or different conductivity types of conductive impurity. For example, either the second source 413a or the second pocket diffusion layers 407a and 407b may contain boron whose conductivity type is a p type, and the other may contain phosphorus whose conductivity type is an n type.

As can be understood from the foregoing description, the imaging device may have one second specific layer or may have a plurality of second specific layers.

Examples of the position of a second specific layer are further described.

In the first configuration example, the second channel region 403 includes a second strain-introducing layer. In one specific example of the first configuration example, at least one selected from among a configuration (A) and a configuration (B) holds.

In the configuration (A), the second pocket diffusion layers 407a and 407b include the second specific layer. In the configuration (B), regions between the second pocket diffusion layers 407a and 407b and the second strain-introducing layer include the second specific layer.

According to the configuration (A) and/or the configuration (B), possible diffusion of a conductive impurity by TED in directions from the second pocket diffusion layers 407a and 407b toward the second channel region 403 can be suppressed. It should be noted that the regions between the second pocket diffusion layers 407a and 407b and the second strain-introducing layer are for example the second extension diffusion layers 406a and 406b. Specific examples of regions in which the second specific layer may be distributed in the configuration (A) and the configuration (B) are regions that are similar to the regions of the carbon-implanted layers 311 of Fig. 5B.

In the second configuration example, the second source 413a includes a second strain-introducing layer. The second drain 413b includes a second strain-introducing layer. In one specific example of the second configuration example, the second peripheral substrate portion has a second foundation layer. At least one selected from among a configuration (C) and a configuration (D) holds.

In the configuration (C), there is a third interface between the second foundation layer and the second strain-introducing layer included in the second source 413a. A conductive impurity of the second source 413a spreads in a third region of the second foundation layer astride the third interface. The third region includes the second specific layer.

In the configuration (D), there is a fourth interface between the second foundation layer and the second strain-introducing layer included in the second drain 413b. In the configuration (D), a conductive impurity of the second drain 413b spreads in a fourth region of the second foundation layer astride the fourth interface. In the configuration (D), the fourth region includes the second specific layer.

According to the configuration (C), even in a situation where a conductive impurity spreads in the third region of the second foundation layer astride the third interface from the second strain-introducing layer included in the second source 413a, diffusion of the conductive impurity by TED in the second foundation layer can be suppressed. According to the configuration (D), even in a situation where a conductive impurity spreads in the fourth region of the second foundation layer astride the fourth interface from the second strain-introducing layer included in the second drain 413b, diffusion of the conductive impurity by TED in the second foundation layer can be suppressed. This may suppress the short channel effect and reduce deterioration of the performance of the first peripheral transistor 27. Specific examples of regions in which the second specific layer may be distributed in the configuration (C) and the configuration (D) are regions that are similar to the regions of the carbon-implanted layers 311 of Fig. 6B.

In one example, the concentration of the conductive impurity in the second extension diffusion layer is lower than the concentration of the conductive impurity in the first extension diffusion layer. The second extension diffusion layer is deeper than the first extension diffusion layer. As mentioned above, the first extension diffusion layer is the first extension diffusion layer 306a or the first extension diffusion layer 306b. Further, the second extension diffusion layer is the second extension diffusion layer 406a or the second extension diffusion layer 406b.

The sentence "the second extension diffusion layer is deeper than the first extension diffusion layer" means that the deepest portion of the second extension diffusion layer is at a greater depth than the deepest portion of the first extension diffusion layer in a direction parallel with the depth of the first peripheral substrate portion or the second peripheral substrate portion. In this context, the word "deep" can also be referred to as "great in junction depth".

According to a first definition, the phrase "concentration of the conductive impurity" in the expression "the concentration of the conductive impurity in the second extension diffusion layer is lower than the concentration of the conductive impurity in the first extension diffusion layer" is a maximum value of concentration. According to a second definition, the phrase "concentration of the conductive impurity" in this expression is an average concentration. In the aforementioned example, a case where it can be said on the basis of at least either the first definition or the second definition that "the concentration of the conductive impurity in the second extension diffusion layer is lower than the concentration of the conductive impurity in the first extension diffusion layer" is treated as a case where "the concentration of the conductive impurity in the second extension diffusion layer is lower than the concentration of the conductive impurity in the first extension diffusion layer". Further, in this expression, the type of the conductive impurity in the first extension diffusion layer and the type of the conductive impurity in the second extension diffusion layer may be the same as or different from each other. For example, the conductive impurity in the first extension diffusion layer may be boron, and the conductive impurity in the second extension diffusion layer may be indium.

In the illustrated example, the second peripheral transistor 427 has the second extension diffusion layer 406a and the second extension diffusion layer 406b. The second extension diffusion layer 406a is adjacent to the second source 413a. The second extension diffusion layer 406a is shallower than the second source 413a and the second drain 413b. The second extension diffusion layer 406a has a conductive impurity. The second extension diffusion layer 406b is adjacent to the second drain 413b. The second extension diffusion layer 406b is shallower than the second source 413a and the second drain 413b. The second extension diffusion layer 406b has a conductive impurity. The concentration of the conductive impurity in the second extension diffusion layer 406a is lower than the concentration of the conductive impurity in the first extension diffusion layer 306a. The second extension diffusion layer 406a is deeper than the first extension diffusion layer 306a. The concentration of the conductive impurity in the second extension diffusion layer 406b is lower than the concentration of the conductive impurity in the first extension diffusion layer 306b. The second extension diffusion layer 406b is deeper than the first extension diffusion layer 306b.

In one example, the gate length L₂₇ of the first peripheral transistor 27 is shorter than the gate length L₄₂₇ of the second peripheral transistor 427. In terms of miniaturization of the first peripheral transistor 27 and from the point of view of causing the first peripheral transistor 27 to operate at high speed, it is advantageous for the gate length L₂₇ of the first peripheral transistor 27 to be short. In one specific example, the second peripheral transistor 427 is included in an analog processor, and the first peripheral transistor 27 is included in a digital processor. In this specific example, employing the first peripheral transistor 27 and the second peripheral transistor 427 with different gate lengths allows the digital processor to achieve digital processing making use of the high-speed operation of the first peripheral transistor 27, whose gate length L₂₇ is short. Since the first peripheral transistor 27 is finer, the speeding up of digital processing in the digital processing becomes possible. Meanwhile, since the gate length L₄₂₇ is relatively long, variations in the threshold voltage of the second peripheral transistor 427 may be reduced. This makes it also possible to improve the analog characteristics of the second peripheral transistor 427 in the analog processor.

The ratio L₂₇/L₄₂₇ of the gate length L₂₇ of the first peripheral transistor 27 to the gate length L₄₂₇ of the second peripheral transistor 427 is for example lower than or equal to 0.8, or may be lower than or equal to 0.34. This ratio is for example higher than or equal to 0.01, or may be higher than or equal to 0.05.

In one example, the gate length L₂₂ of the amplifying transistor 22 is longer than the gate length L₄₂₇ of the second peripheral transistor 427. In terms of improvement in the characteristics of the amplifying transistor 22, it may be advantageous for the gate length L₂₂ of the amplifying transistor 22 to be long. In one specific example, the amplifying transistor 22 is included in the analog processor. In this specific example, the gate length L₂₂ is increased, and variations in the threshold voltage of the amplifying transistor 22 are reduced, so that it is easy to improve a Pelgrom coefficient. This allows the analog processor to achieve analog processing making use of the favorable analog characteristics of the amplifying transistor 22 based on this ease of improvement.

The ratio L₄₂₇/L₂₂ of the gate length L₄₂₇ of the second peripheral transistor 427 to the gate length L₂₂ of the amplifying transistor 22 is for example lower than or equal to 0.95, or may be lower than or equal to 0.9. This ratio is for example higher than or equal to 0.1, or may be higher than or equal to 0.36.

In one example, the gate insulator film 301 of the first peripheral transistor 27 is thinner than the gate insulator film 401 of the second peripheral transistor 427. In terms of miniaturization of the first peripheral transistor 27 and from the point of view of causing the first peripheral transistor 27 to operate at high speed, it is advantageous for the gate insulator film 301 of the first peripheral transistor 27 to be thin. In one specific example, the second peripheral transistor 427 is included in the analog processor, and the first peripheral transistor 27 is included in the digital processor. In this specific example, employing the first peripheral transistor 27 and the second peripheral transistor 427 with different insulator film thicknesses allows the digital processor to achieve digital processing making use of the high-speed operation of the first peripheral transistor 27, whose gate insulator film 301 is thin. Since the first peripheral transistor 27 is finer, the speeding up of digital processing in the digital processing becomes possible. Meanwhile, since the gate insulator film 401 is relatively thick, variations in the threshold voltage of the second peripheral transistor 427 may be reduced. This makes it also possible to improve the analog characteristics of the second peripheral transistor 427 in the analog processor.

The ratio T₃₀₁/T₄₀₁ of the thickness T₃₀₁ of the gate insulator film 301 of the first peripheral transistor 27 to the thickness T₄₀₁ of the gate insulator film 401 of the second peripheral transistor 427 is for example lower than or equal to 0.7, or may be lower than or equal to 0.36. This ratio is for example higher than or equal to 0.1, or may be higher than or equal to 0.22.

In one example, the gate insulator film 69 of the amplifying transistor 22 is thicker than the gate insulator film 401 of the second peripheral transistor 427. In terms of improvement in the characteristics of the amplifying transistor 22, it may be advantageous for the gate insulator film 69 of the amplifying transistor 22 to be thick. In one specific example, the amplifying transistor 22 is included in the analog processor. In this specific example, the gate insulator film 69 is thickened, and variations in the threshold voltage of the amplifying transistor 22 are reduced, so that it is easy to improve a Pelgrom coefficient. This allows the analog processor to achieve analog processing making use of the favorable analog characteristics of the amplifying transistor 22 based on this ease of improvement.

The ratio T₄₀₁/T₆₉ of the thickness T₄₀₁ of the gate insulator film 401 of the second peripheral transistor 427 to the thickness T₆₉ of the gate insulator film 69 of the amplifying transistor 22 is for example lower than 1. This ratio is for example higher than or equal to 0.68.

In one specific example, the second peripheral transistor 427 is a logic transistor. The second peripheral transistor 427 can perform an analog operation in a state of being incorporated in a pixel driver, a load cell, a column amplifier, a comparator, or other devices. In the analog operation, it may be advantageous for a dynamic range to be wide. In order to secure a wide dynamic range, it is advantageous for a transistor to have a high operating voltage and a wide voltage range. For example, in the case of a pixel voltage of approximately 3 V to 3.5 V, it may be advantageous for the operating voltage to be 3.3 V. In this respect, in this specific example, the gate length L₄₂₇ of the second peripheral transistor 427 is longer than the gate length L₂₇ of the first peripheral transistor 27. The gate insulator film 401 of the second peripheral transistor 427 is thicker than the gate insulator film 301 of the first peripheral transistor 27. From the point of view of raising the operating voltage of the second peripheral transistor 427, it is advantageous from the gate length L₄₂₇ to be long and for the gate insulator film 401 to be thick. In the aforementioned context, the operating voltage is the drain voltage of a transistor when the transistor is on. The pixel voltage is the voltage of a charge accumulation node in a pixel.

In this specific example, the operating voltage of the second peripheral transistor 427 is higher than the operating voltage of the first peripheral transistor 27. The operating voltage of the second peripheral transistor 427 is for example 3.3 V. The operating voltage of the first peripheral transistor 27 is for example 1.2 V.

In this specific example, variations in the threshold voltage of the second peripheral transistor 427 are small, as the second peripheral transistor 427 is longer in gate length and greater in gate insulator film thickness than the first peripheral transistor 27. Small variations in threshold voltage are a favorable feature. Further, in this specific example, the threshold voltage of the second peripheral transistor 427 is higher than the threshold voltage of the first peripheral transistor 27. The threshold voltage of the second peripheral transistor 427 is for example approximately 0.5 V. The threshold voltage of the first peripheral transistor 27 is for example approximately 0.3 V.

In one example, the concentration of the diffusion-suppressing species in the first specific layer is higher than the concentration of the diffusion-suppressing species in the second specific layer. In the expression "the concentration of the diffusion-suppressing species in the first specific layer is higher than the concentration of the diffusion-suppressing species in the second specific layer", the concentration of the diffusion-suppressing species in the second specific layer may be zero, or may be higher than zero.

According to a first definition, the phrase "concentration of the specific layer" in the expression "the concentration of the diffusion-suppressing species in the first specific layer is higher than the concentration of the diffusion-suppressing species in the second specific layer" is a maximum value of concentration. According to a second definition, the phrase "concentration of the diffusion-suppressing species" in this expression is an average concentration. In the aforementioned example, a case where it can be said on the basis of at least either the first definition or the second definition that "the concentration of the diffusion-suppressing species in the first specific layer is higher than the concentration of the diffusion-suppressing species in the second specific layer" is treated as a case where "the concentration of the diffusion-suppressing species in the first specific layer is higher than the concentration of the diffusion-suppressing species in the second specific layer". Further, in this example, the type of the diffusion-suppressing species in the first specific layer and the type of the diffusion-suppressing species in the second specific layer may be the same as or different from each other. For example, the diffusion-suppressing species in the first specific layer may be carbon, and the diffusion-suppressing species in the second specific layer may be nitrogen and fluorine.

The concentration of carbon in the first specific layer may be higher than the concentration of carbon in the second specific layer. The concentration of nitrogen in the first specific layer may be higher than the concentration of nitrogen in the second specific layer. The concentration of fluorine in the first specific layer may be higher than the concentration of fluorine in the second specific layer. The concentration of germanium in the first specific layer may be higher than the concentration of germanium in the second specific layer. The concentration of silicon in the first specific layer may be higher than the concentration of silicon in the second specific layer. The concentration of argon in the first specific layer may be higher than the concentration of argon in the second specific layer.

In one example, the concentration of carbon in the second specific layer is higher than the concentration of carbon in the channel region 68 of the amplifying transistor 22. In the expression "the concentration of carbon in the second specific layer is higher than the concentration of carbon in the channel region 68 of the amplifying transistor 22", the concentration of carbon in the channel region 68 of the amplifying transistor 22 may be zero, or may be higher than zero.

The concentration of the diffusion-suppressing species in the second specific layer is for example higher than or equal to 5 × 10¹⁶ atoms/cm³. The ratio of the concentration of the diffusion-suppressing species in the second specific layer to the concentration of the diffusion-suppressing species in the charge accumulation region Z is for example higher than or equal to 1 × 10⁵. This ratio is for example lower than or equal to 1 × 10¹¹.

According to a first definition, the phrase "concentration of carbon" in the expression "the concentration of carbon in the second specific layer is higher than the concentration of carbon in the channel region 68 of the amplifying transistor 22" is a maximum value of concentration. According to a second definition, the phrase "concentration of carbon" in this expression is an average concentration. In the aforementioned example, a case where it can be said on the basis of at least either the first definition or the second definition that "the concentration of carbon in the second specific layer is higher than the concentration of carbon in the channel region 68 of the amplifying transistor 22" is treated as a case where "the concentration of carbon in the second specific layer is higher than the concentration of carbon in the channel region 68 of the amplifying transistor 22".

The ratio of the concentration of the diffusion-suppressing species in the second specific layer to the concentration of the diffusion-suppressing species in the channel region 68 is for example higher than or equal to 1 × 10⁵. This ratio is for example lower than or equal to 1 × 10¹¹.

In one example, the second extension diffusion layer contains nitrogen.

In the illustrated example, the second extension diffusion layer 406a contains nitrogen. The second extension diffusion layer 406b contains nitrogen.

The nitrogen of the second extension diffusion layer may be derived from ion implantation of nitrogen (N) ions, or may be derived from implantation of nitrogen molecules N₂. In the illustrated example, the nitrogen of the second extension diffusion layer 406a may be derived from ion implantation of nitrogen (N) ions, or may be derived from implantation of nitrogen molecules N₂. The nitrogen of the second extension diffusion layer 406b may be derived from ion implantation of nitrogen (N) ions, or may be derived from implantation of nitrogen molecules N₂. The same applies to the carbon in the first extension diffusion layers 306a and 306b in that the carbon may be derived from ion implantation.

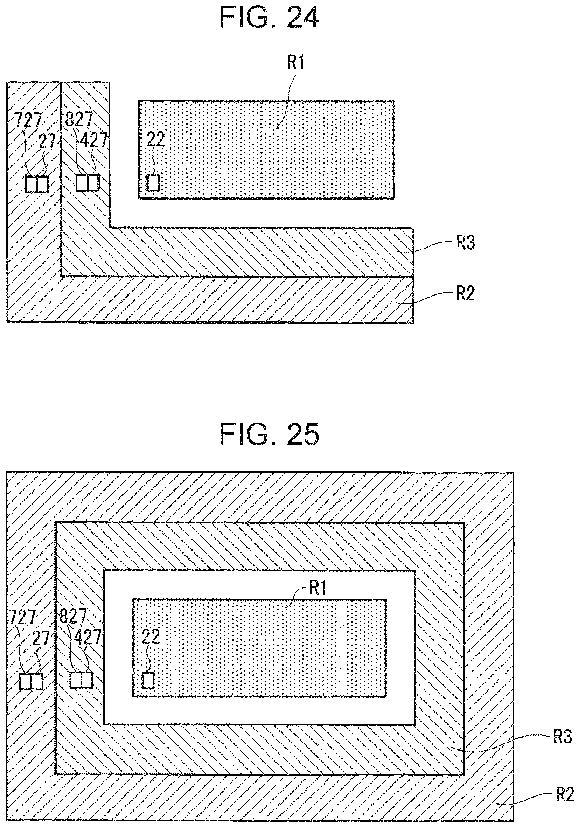

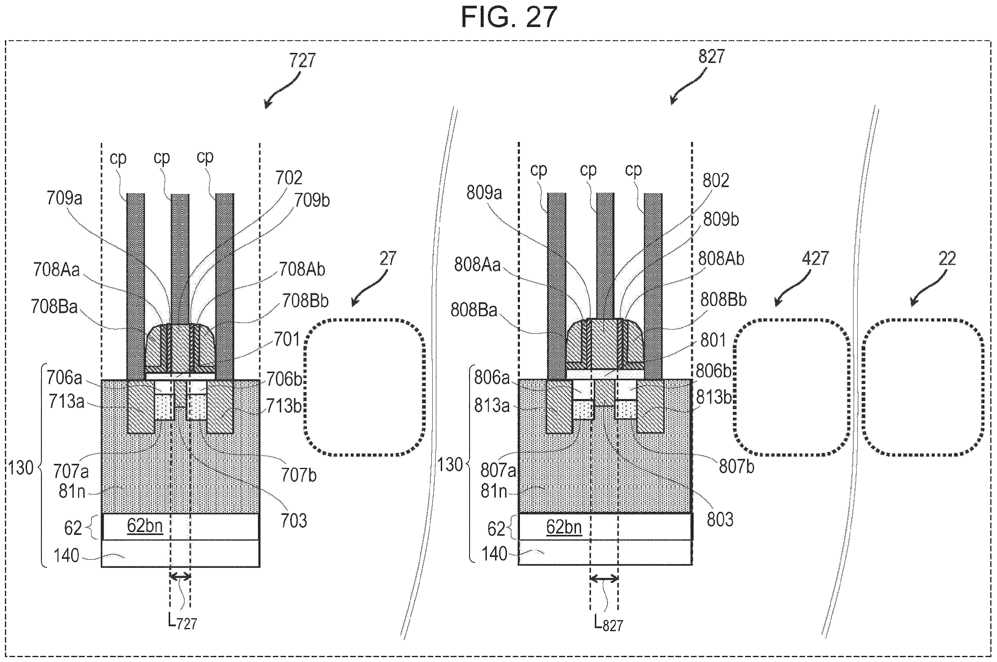

Of course, a transistor other than the transistors shown in Figs. 21 to 23 may be provided. In each of the examples shown in Figs. 24 to 27, the first peripheral region R2 has a first peripheral transistor 27 and a first peripheral transistor 727. A device isolation 220 is disposed between the first peripheral transistor 27 and the first peripheral transistor 727. The second peripheral region R3 has a second peripheral transistor 427 and a second peripheral transistor 827. The device isolation 220 is disposed between the second peripheral transistor 427 and the second peripheral transistor 827. It should be noted that Fig. 27 simplistically illustrates the first peripheral transistor 27, the second peripheral transistor 427, and the amplifying transistor 22 and omits to illustrate the device isolation 220.

In each of the examples shown in Figs. 24 to 27, the first peripheral transistor 727 has similarities to the first peripheral transistor 27. Specifically, as is the case with the first peripheral transistor 27, the first peripheral transistor 727 is a MIS transistor. As is the case with the first peripheral transistor 27, the first peripheral transistor 727 includes a gate electrode 702, a second source 713a, a second drain 713b, extension diffusion layers 706a and 706b, pocket diffusion layers 707a and 707b, a channel region 703, a gate insulator film 701, offset spacers 709a and 709b, first side walls 708Aa and 708Ab, and second side walls 708Ba and 708Bb.

Note, however, that the first peripheral transistor 27 and the first peripheral transistor 727 are opposite in polarity to each other. Specifically, the first peripheral transistor 27 is a P-channel transistor, and the first peripheral transistor 727 is an N-channel transistor. The p-type source diffusion layer 313a, which serves as the first source, is of a p type, and the source 713a is of an n type. The p-type drain diffusion layer 313b, which serves as the first drain, is of a p type, and the source 713b is of an n type. The first extension diffusion layer 306a is of a p type, and the extension diffusion layer 706a is of an n type. The first extension diffusion layer 306b is of a p type, and the extension diffusion layer 706b is of an n type. The first pocket diffusion layer 307a is of an n type, and the pocket diffusion layer 707a is of a p type. The first pocket diffusion layer 307b is of an n type, and the pocket diffusion layer 707b is of a p type. The N-type channel diffusion layer 303, which serves as the first channel region, is of an n type, and the channel region 703 is of a p type. In Fig. 27, the first peripheral transistor 727 includes the n-type impurity region 81n, which is an n-type well.

In the following, the ordinal numeral "first" may be added to the constituent elements of the first peripheral transistor 727. For example, the source 713a may be referred to as "first source". Further, the drain 713b may be referred to as "first drain".

In the illustrated example, the device isolation 220 is an STI structure. The STI structure has a trench (groove) and a filler filling the trench. The filler is for example an oxide. The depth of the trench is for example approximately 500 nm. The STI structure may be formed in the semiconductor substrate 130 by an STI process.

In the illustrated example, the first peripheral region R2 has two first peripheral transistors 27 and 727 and a device isolation 220 that is an STI structure. The device isolation 220, which is the STI structure, provides device isolation of the two first peripheral transistors 27 and 727 from each other. The device isolation 220, which is the STI structure, has a trench.

In the illustrated example, a range of distribution of the diffusion-suppressing species in the first specific layer of at least either of the two first peripheral transistors 27 and 727 is shallower than the bottom of the trench. In this context, the phrase "range of distribution of the diffusion-suppressing species" refers to a region in which the concentration of the diffusion-suppressing species is higher than or equal to 5 × 10¹⁶ atoms/cm³. The same applies to a range of distribution of carbon or other substances. The term "bottom of the trench" means the deepest portion of the trench in a direction parallel with the depth of the first peripheral substrate portion.

A range of distribution of carbon in the first specific layer of at least either of the two first peripheral transistors 27 and 727 may be shallower than the bottom of the trench. A range of distribution of nitrogen in the first specific layer of at least either of the two first peripheral transistors 27 and 727 may be shallower than the bottom of the trench. A range of distribution of fluorine in the first specific layer of at least either of the two first peripheral transistors 27 and 727 may be shallower than the bottom of the trench.

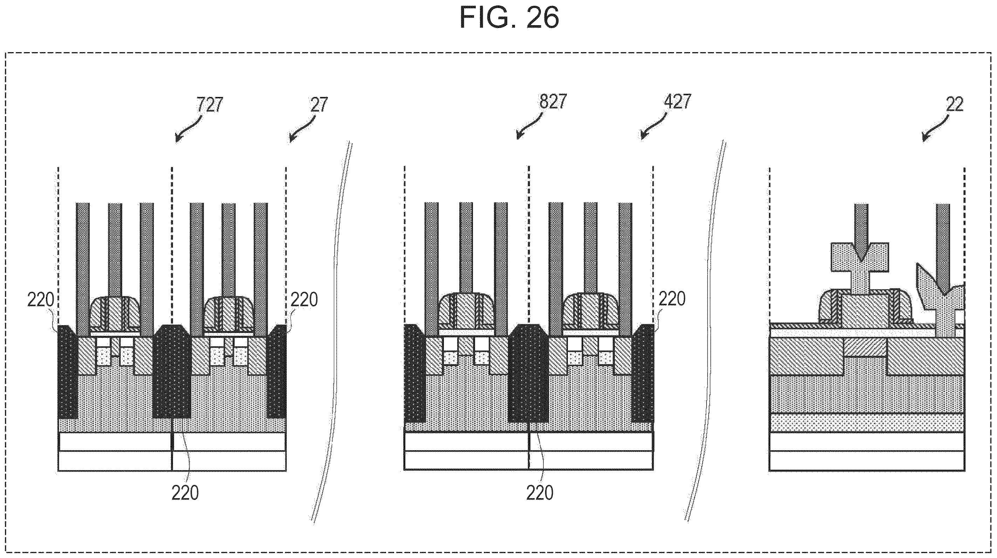

Specifically, the two first peripheral transistors 27 and 727 are opposite in polarity to each other. In a plan view, the device isolation 220, which is the STI structure, is disposed between the two first peripheral transistors 27 and 727 and, more specifically, on a segment connecting the two first peripheral transistors 27 and 727 with each other. As illustrated in Fig. 26, the STI structure may project upward from a portion of the first peripheral substrate portion that is present around the STI structure.

It should be noted that the device isolation 220 may be an implantation isolation region.

In each of the examples shown in Figs. 24 to 27, the second peripheral transistor 827 has similarities to the second peripheral transistor 427. Specifically, as is the case with the second peripheral transistor 427, the second peripheral transistor 827 is a MIS transistor. As is the case with the second peripheral transistor 427, the second peripheral transistor 827 includes a gate electrode 802, a source 813a, a drain 813b, extension diffusion layers 806a and 806b, pocket diffusion layers 807a and 807b, a channel region 803, a gate insulator film 801, offset spacers 809a and 809b, first side walls 808Aa and 808Ab, and second side walls 808Ba and 808Bb.

Note, however, that the second peripheral transistor 427 and the second peripheral transistor 827 are opposite in polarity to each other. Specifically, the second peripheral transistor 427 is a P-channel transistor, and the second peripheral transistor 827 is an N-channel transistor. The second source 413a is of a p type, and the source 813a is of an n type. The second drain 413b is of a p type, and the drain 813b is of an n type. The second extension diffusion layer 406a is of a p type, and the extension diffusion layer 806a is of an n type. The second extension diffusion layer 406b is of a p type, and the extension diffusion layer 806b is of an n type. The second pocket diffusion layer 407a is of an n type, and the pocket diffusion layer 807a is of a p type. The first pocket diffusion layer 407b is of an n type, and the pocket diffusion layer 807b is of a p type. The second channel diffusion layer 403 is of an n type, and the channel region 803 is of a p type.

The ordinal numeral "second" may be added to the constituent elements of the second peripheral transistor 427. For example, the source 813a may be referred to as "second source". Further, the drain 813b may be referred to as "second drain".

Let it be emphatically said that the second peripheral region R3 is not essential. Of course, the second peripheral transistors 427 and 827 are not essential. Further, in the first peripheral region R2, at least either of the first peripheral transistors 27 and 727 may be used in analog processing. In one specific example, in the first peripheral region R2, one first peripheral transistor is used in digital processing, and another first peripheral transistor is used in analog processing.

The description of the first peripheral transistor 27 and elements thereof can be invoked in the description of the first peripheral transistor 727 and elements thereof, provided no contradiction arises. The description of the second peripheral transistor 427 and elements thereof can be invoked in the description of the second peripheral transistor 827 and elements thereof, provided no contradiction arises. The description of a relationship among the first peripheral transistor 27, the second peripheral transistor 427, and the amplifying transistor 22 can be invoked in the description of a relationship among the first peripheral transistor 727, the second peripheral transistor 827, and the amplifying transistor 22, provided no contradiction arises.

For example, the gate length L₇₂₇ of the first peripheral transistor 727 may be shorter than the gate length L₂₂ of the amplifying transistor 22. The gate length L₇₂₇ of the first peripheral transistor 727 may be shorter than the gate length L₈₂₇ of the second peripheral transistor 827. The gate length L₈₂₇ of the second peripheral transistor 827 may be shorter than the gate length L₂₂ of the amplifying transistor 22. The extension diffusion layer 706a may be shallower than the source 713a and the drain 713b. The extension diffusion layer 706b may be shallower than the source 713a and the drain 713b. The extension diffusion layer 806a may be shallower than the source 813a and the drain 813b. The extension diffusion layer 806b may be shallower than the source 813a and the drain 813b. The extension diffusion layer 706a may contain a conductive impurity and a diffusion-suppressing species. The extension diffusion layer 706b may contain a conductive impurity and a diffusion-suppressing species. The extension diffusion layer 806a may contain nitrogen. The nitrogen of the extension diffusion layer 806a may be derived from ion implantation of nitrogen (N) ions, or may be derived from implantation of nitrogen molecules N₂. The extension diffusion layer 806b may contain nitrogen. The nitrogen of the extension diffusion layer 806b may be derived from ion implantation of nitrogen (N) ions, or may be derived from implantation of nitrogen molecules N₂.

As can be understood from the foregoing description, in the imaging device, at least either the extension diffusion layer 806a or the extension diffusion layer 806b of the second peripheral transistor 827, which is an N-channel transistor, may contain nitrogen. This nitrogen affects not only the distribution of impurities in the second peripheral substrate portion but also the interface characteristics of the gate insulator film of the second peripheral transistor 827, thereby bringing about improvement in the reliability of the imaging device. At least either the extension diffusion layer 806a or the extension diffusion layer 806b that contains the aforementioned nitrogen may be a so-called LDD diffusion layer.

In an example in which at least either the extension diffusion layer 806a or the extension diffusion layer 806b of the second peripheral transistor 827, which is an N-channel transistor, contains nitrogen, the second extension diffusion layer 706a of the second peripheral transistor 727, which is a P-channel transistor, may or may not contain nitrogen. In this example, the second extension diffusion layer 706b of the second peripheral transistor 727, which is a P-channel transistor, may or may not contain nitrogen.

In one example, in a plan view, the amplifying transistor 22, the second peripheral transistor 427, the second peripheral transistor 827, the first peripheral transistor 27, and the first peripheral transistor 727 are arranged in this order. In another example, in a plan view, the amplifying transistor 22, the second peripheral transistor 827, the second peripheral transistor 427, the first peripheral transistor 727, and the first peripheral transistor 27 are arranged in this order. In a plan view, the amplifying transistor 22, the second peripheral transistor 427, the second peripheral transistor 827, the first peripheral transistor 727, and the first peripheral transistor 27 may be arranged in this order. In a plan view, the amplifying transistor 22, the second peripheral transistor 827, the second peripheral transistor 427, the first peripheral transistor 27, and the first peripheral transistor 727 may be arranged in this order.

The matters described with reference to Figs. 24 to 27 can be applied to the examples shown in Figs. 16 to 20, provided no contradiction arises.

The foregoing description has taken a front-side illumination (FSI) imaging device as an example. Note, however, that the foregoing description is also applicable to a back-side illumination (BSI) imaging device.

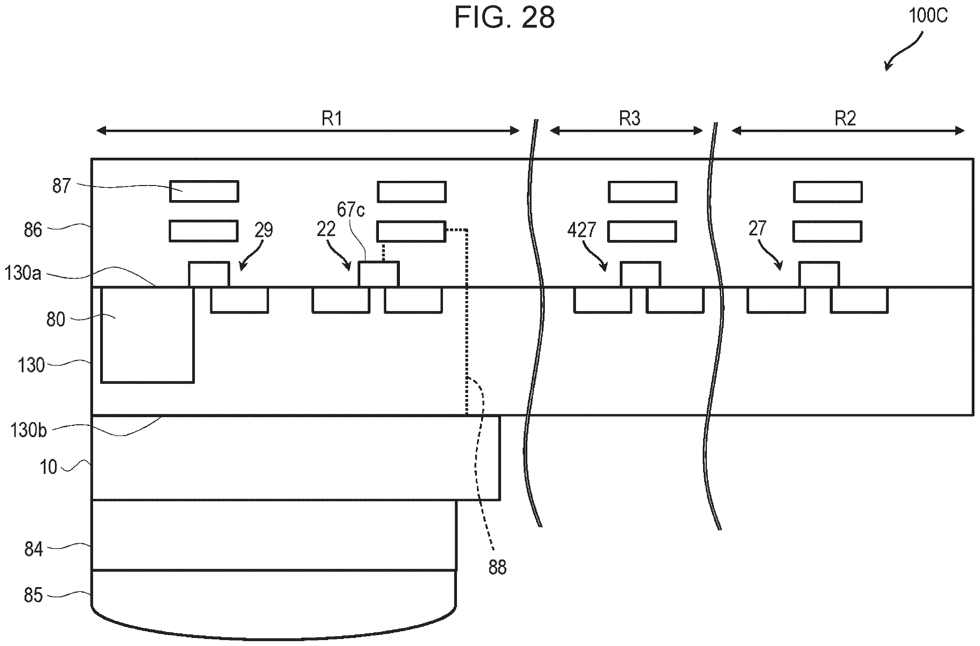

Fig. 28 is a schematic view of a back-side illumination imaging device 100C according to one example.

In the imaging device 100C shown in Fig. 28, the semiconductor substrate 130 has a front surface 130a and a back surface 130b. The back surface 130b is a surface on which light falls. The front surface 130a is a surface opposite to the surface on which light falls.

On the back surface 130b, a photoelectric converter 10 is stacked. On the photoelectric converter 10, a color filter 84 is stacked. On the color filter 84, an on-chip lens 85 is stacked. In a typical example, the semiconductor substrate 130 and the photoelectric converter 10 are joined to each other by joining the photoelectric converter 10 to the back surface 130b with the back surface 130b polished. The color filter 84 and the on-chip lens 85 may be omitted. At least either between the photoelectric converter 10 and the color filter 84 or between the color filter 84 and the on-chip lens 85, an interlayer insulator film intended for planarization, protection, or other purposes may be provided.

On the front surface 130a, a wiring layer 86 is stacked. The wiring layer 86 has a plurality of wires 87 provided inside an insulator. The plurality of wires 87 are used for electrical connections to the amplifying transistor 22, the first peripheral transistor 27, and the second peripheral transistor 427. For example, a wire 87 constitutes part of an electrical pathway 88 electrically connecting the pixel electrode 11 of the photoelectric converter 10 to the gate electrode 67c of the amplifying transistor 22. Specifically, in this example, the electrical pathway 88 includes a through-silicon via (TSV) provided in the semiconductor substrate 130. Fig. 28 omits to illustrate the through-silicon via. In Fig. 28, the dotted line representing the electrical pathway 88 is schematic, and is not intended to limit the position or other features of the electrical pathway 88. Instead of the TSV connection, a Cu-Cu connection may be employed.

Although not illustrated in detail in Fig. 28, the amplifying transistor 22, the first peripheral transistor 27, and the second peripheral transistor 427 may have the features described with reference to Figs. 1 to 27. The same applies to other elements such as the photoelectric converter 10. Specifically, in this example, the first peripheral transistor 27 and the second peripheral transistor 427 include sources, drains, extension diffusion layers, pocket diffusion layers, or other elements. The semiconductor substrate 130 includes a supporting substrate 140.

The imaging device 100C further includes a photodiode 80 and a transfer transistor 29. The photodiode 80 and the transfer transistor 29 are provided in the semiconductor substrate 130. Specifically, the pixel region R1 has the photodiode 80 provided in the pixel substrate portion. As mentioned above, the term "pixel substrate portion" refers to a portion of at least one semiconductor substrate 130 located in the pixel region R1.

As is the case with the photoelectric converter 10, the photodiode 80 falls under the category of photoelectric converters. The photodiode 80 generates signal charge through photoelectric conversion. The transfer transistor 29 transfers this signal charge to a charge accumulation region (not illustrated).

According to the back-side illumination configuration shown in Fig. 28, the irradiation of the photodiode 80 with light from the on-chip lens 85 and the color filter 84 is not prevented by a wire 87 of the wiring layer 86. This enables the photodiode 80 to carry out efficient photoelectric conversion.

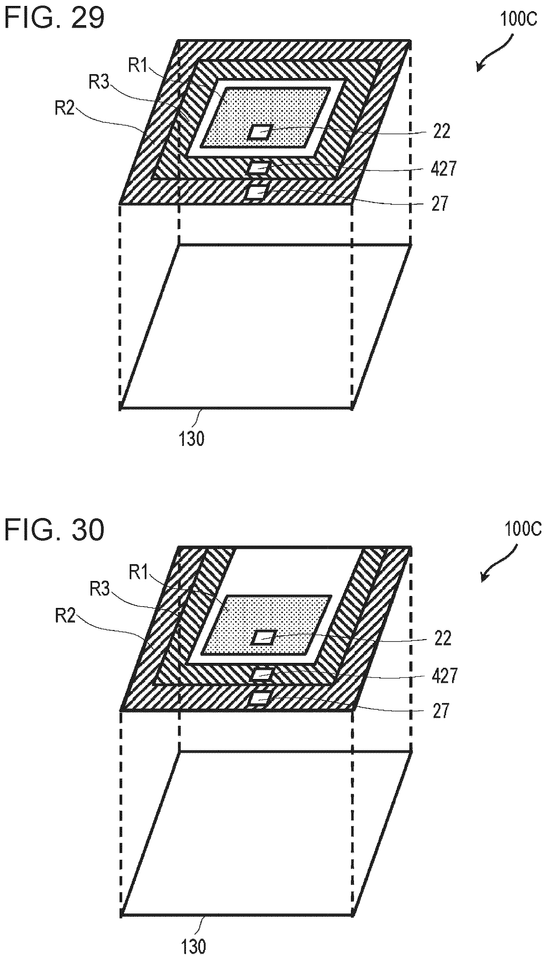

Figs. 29 to 32 are schematic views showing shapes that the pixel region R1, first peripheral region R2, and second peripheral region R3 of the imaging device 100C shown in Fig. 28 may take.

In the example shown in Fig. 29, the second peripheral region R3 surrounds the pixel region R1 in a plan view. The first peripheral region R2 surrounds the second peripheral region R3 in a plan view. Specifically, in the example shown in Fig. 29, the second peripheral region R3 exhibits a square shape outside the pixel region R1 in a plan view. The first peripheral region R2 exhibits a square shape outside the second peripheral region R3 in a plan view.

In the example shown in Fig. 30, the second peripheral region R3 exhibits a U-shape outside the pixel region R1 in a plan view. The first peripheral region R2 exhibits a U-shape outside the second peripheral region R3 in a plan view.

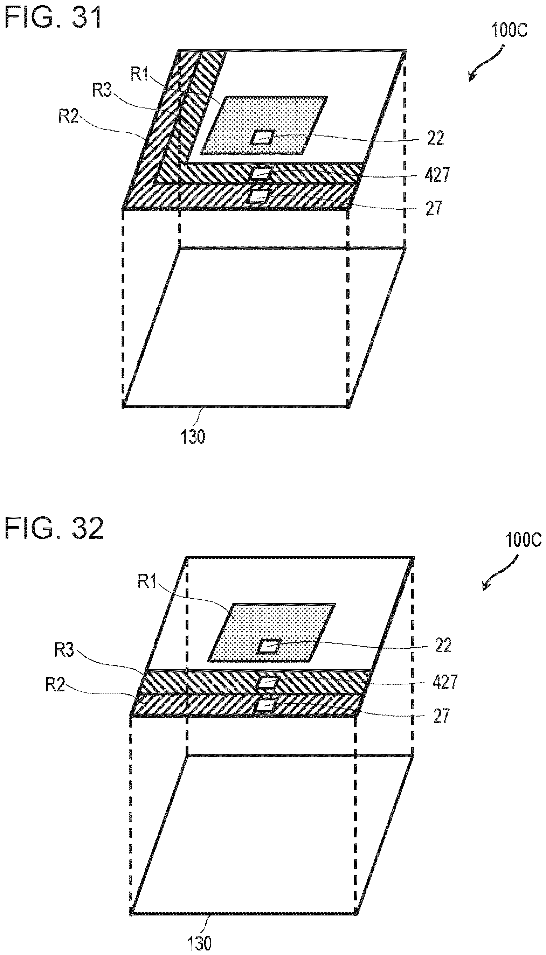

In the example shown in Fig. 31, the second peripheral region R3 exhibits an L-shape outside the pixel region R1 in a plan view. The first peripheral region R2 exhibits an L-shape outside the second peripheral region R3 in a plan view.

In the example shown in Fig. 32, the second peripheral region R3 extends straight outside the pixel region R1 in a plan view. The first peripheral region R2 extends straight outside the second peripheral region R3 in a plan view.

The shapes of the pixel region R1, the first peripheral region R2, and the second peripheral region R3 shown in Figs. 29 to 32 are also applicable to the imaging device 100C shown in Fig. 28. Further, these shapes are also applicable to the imaging devices 100A and 100B shown in Figs. 1 to 27.

The foregoing description has taken, as an example, an imaging device including a single semiconductor substrate. Note, however, that the foregoing description is also applicable to a so-called chip stack imaging device in which a plurality of semiconductor substrates are stacked on top of each other. The chip stack imaging device may also be referred to as "stacked chip imaging device".

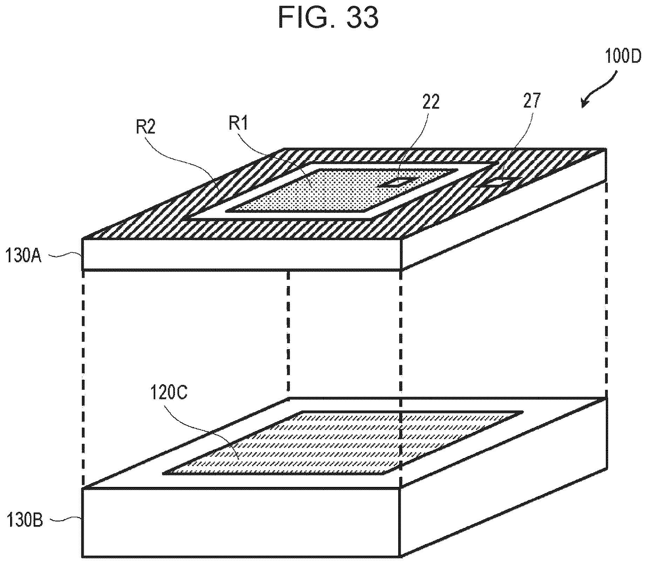

Fig. 33 is a schematic view of a chip stack imaging device 100D according to one example.

In the imaging device 100D shown in Fig. 33, a semiconductor substrate 130A and a semiconductor substrate 130B are stacked on top of each other. The semiconductor substrate 130A is provided with a pixel region R1 and a first peripheral region R2. The semiconductor substrate 130B is provided with a peripheral circuit 120C. The peripheral circuit 120C may include some or all of circuits that are equivalent to the peripheral circuit 120A or the peripheral circuit 120B.

Although not illustrated, at least either a TSV connection or a Cu-Cu connection may be utilized as an electrical connection between a device provided in the semiconductor substrate 130A and a device provided in the semiconductor substrate 130B.

The pixel region R1 has an amplifying transistor 22. The first peripheral region R2 has a first peripheral transistor 27.

In one example, in the imaging device 100D, the first peripheral transistor 27 is a load transistor. The pixel region R1 is connected to the load transistor via a vertical signal line 35. Specifically, the amplifying transistor 22 is connected to the load transistor via the vertical signal line 35.

In one specific example, the aforementioned load transistor functions as a constant current source. A constant current determined by the load transistor flows through the amplifying transistor 22, the vertical signal line 35, and the load transistor in this order. The amplifying transistor 22 and the load transistor form a source follower. For this reason, a voltage corresponding to the gate voltage of the amplifying transistor 22, i.e. the voltage of a charge accumulation region Z, appears in the vertical signal line 35. This state continues as long as the address transistor 24 is on. The load transistor may be included in the load circuit 45 shown in Fig. 2. It should be noted that the load transistor may also be referred to as "load cell transistor".

In the imaging device 100D, the first peripheral transistor 27 may be included in at least either a comparator or a driver.

In the example shown in Fig. 33, the first peripheral transistor 27 may or may not be included in the peripheral circuit 120C. In the example shown in Fig. 33, a second peripheral region R3 may be provided outside the first peripheral region R2.

In each of the examples shown in Figs. 28 to 33 too, the first peripheral transistor 27 includes a strain-introducing layer. This brings a strain to the first channel region 303, bringing about improvement in the mobility of the N-type channel diffusion layer 303, which serves as the first channel region. Further, the first specific layer contains a diffusion-suppressing species. This brings about a diffusion-suppressing action. This may reduce dark current in the pixel region R1 while reducing the deterioration in performance of the first peripheral transistor 27 attributed to thermal processing.

In each of the examples shown in Figs. 28 to 33, the pixel region R1, the first peripheral region R2, and the second peripheral region R3 may have the features described with reference to Figs. 1 to 27. For example, the pixel region R1 may include an address transistor 24, a reset transistor 26, or other devices in addition to the amplifying transistor 22. The first peripheral region R2 may include a first peripheral transistor 727 in addition to the first peripheral transistor 27. The second peripheral region R3 may include a second peripheral transistor 827 in addition to the second peripheral transistor 427.

The following describes another embodiment. Elements that are common to the embodiment already described and the embodiment to be described later are given the same reference signs, and a description of the elements may be omitted. The description of one embodiment can be applied to the other embodiment, provided no technical contradiction arises. One embodiment may be combined with the other embodiment, provided no technical contradiction arises.

### (Embodiment 2)

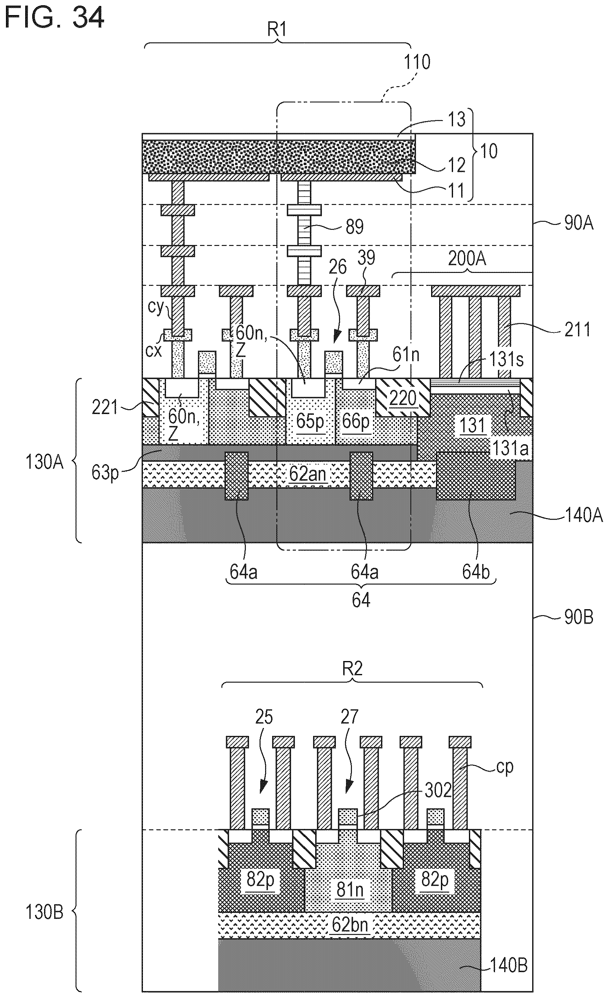

The following describes Embodiment 2 of the present disclosure with reference to Figs. 34 to 48B. In Embodiment 2, the semiconductor substrate 130 is denoted by "semiconductor substrate 130A". The supporting substrate 140 is denoted by "supporting substrate 140A".

In Embodiment 2, any part or the whole of the peripheral circuit 120A is formed in the semiconductor substrate 130B. The peripheral circuit 120A is located in a first peripheral region R2 provided in the semiconductor substrate 130B. The semiconductor substrate 130A and the semiconductor substrate 130B are stacked on top of each other.

Fig. 34 is a schematic cross-sectional view showing a pixel region R1, a first peripheral region R2, and a blocking region. This is a cross-section of two representative ones of the plurality of pixels 110. The semiconductor substrates 130A and the semiconductor substrate 130B are stacked on top of each other. Specifically, the semiconductor substrates 130A and the semiconductor substrate 130B are stacked with an insulating part 90B, which is an interlayer insulating layer, sandwiched therebetween.

The semiconductor substrate 130B may have features that are similar to features that the semiconductor substrate 130A may have. The same applies to the after-mentioned semiconductor substrate 130C.

The semiconductor substrate 130B has a supporting substrate 140B. The supporting substrate 140B may have features that are similar to features that the supporting substrate 140A may have. For example, as in the case of the supporting substrate 140A, each of the impurity layers and impurity regions located above the supporting substrate 140B is formed by ion implantation of an impurity into an epitaxial layer obtained by epitaxial growth over the supporting substrate 140B. In these respects, the same applies to a supporting substrate of the semiconductor substrate 130C. The following takes a p-type silicon substrate as an example of the supporting substrate 140B.

### (Transistors of Pixel Regions and Peripheral Regions)

The following further describes transistors of pixel regions and transistors of peripheral regions with reference to Figs. 35 to 42. Figs. 35, 36, 37, 38, 39, 40, 41, and 42 are schematic perspective views illustrating transistors of pixel regions and transistors of peripheral regions. It should be noted that Figs. 35 to 42 omit to illustrate the blocking regions 200A and 200B.

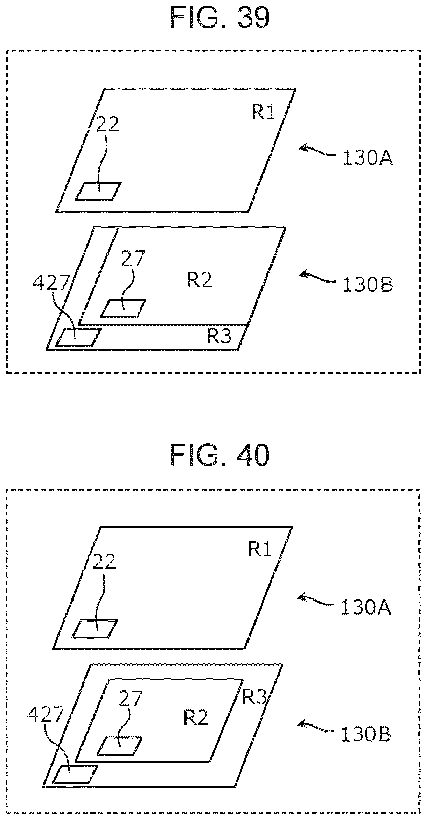

As shown in Figs. 39 and 40, the imaging device may include a second peripheral region R3.

The pixel region R1 may be constituted using one semiconductor substrate, and the first peripheral region R2 may be constituted using another semiconductor substrate. The pixel region R1 may be constituted using one semiconductor substrate, the first peripheral region R2 may be constituted using another semiconductor substrate, and the second peripheral region R3 may be constituted using still another semiconductor substrate. The pixel region R1 may be constituted using one semiconductor substrate, and the first peripheral region R2 and the second peripheral region R3 may be constituted using another semiconductor substrate. The pixel region R1 and the second peripheral region R3 may be constituted using one semiconductor substrate, and the first peripheral region R2 may be constituted using another semiconductor substrate. Thus, in the present embodiment, the imaging device may have a plurality of semiconductor substrates.

In the following, the terms "pixel substrate portion", "first peripheral substrate portion", and "second peripheral substrate portion" are sometimes used. The pixel substrate portion may be a portion of a plurality of semiconductor substrates included in the pixel region R1. The first peripheral substrate portion may be a portion of a plurality of semiconductor substrates included in the first peripheral region R2. The second peripheral substrate portion may be a portion of a plurality of semiconductor substrates included in the second peripheral region R3.

The pixel substrate portion may be included in one semiconductor substrate, the first peripheral substrate portion may be included in another semiconductor substrate, and the second peripheral substrate portion may be included in still another semiconductor substrate. The pixel substrate portion may be included in one semiconductor substrate, and the first peripheral substrate portion and the second peripheral substrate portion may be included in another semiconductor substrate. The pixel substrate portion and the second peripheral substrate portion may be included in one semiconductor substrate, and the first peripheral substrate portion may be included in another semiconductor substrate.

In each of the examples shown in Figs. 35 and 36, the first peripheral region R2 and the pixel region R1 are stacked on top of each other. The pixel region R1 is constituted using the semiconductor substrate 130A. The first peripheral region R2 is constituted using the semiconductor substrate 130B.

Fig. 35 schematically shows an amplifying transistor 22 in the pixel region R1 and a first peripheral transistor 27 in the first peripheral region R2 in a case where the first peripheral region R2 is in the shape of a rectangle in a plan view. Fig. 36 schematically shows an amplifying transistor 22 in the pixel region R1 and a first peripheral transistor 27 in the first peripheral region R2 in a case where the first peripheral region R2 is in the shape of a frame in a plan view. Specifically, in Fig. 36, the first peripheral region R2 is in the shape of a square in a plan view. The first peripheral region R2 may be in the shape of letter L or in the shape of letter U in a plan view.

As can be understood from the description with reference to Figs. 34 to 36, an imaging device according to the present embodiment includes a pixel region R1 and a first peripheral region R2. The pixel region R1 has a pixel substrate portion. The first peripheral region R2 has a first peripheral substrate portion. The pixel substrate portion and the first peripheral substrate portion are stacked on top of each other. The expression "the pixel substrate portion and the first peripheral substrate portion are stacked on top of each other" is intended to encompass both an embodiment in which an inclusion is interposed between the pixel substrate portion and the first peripheral substrate portion and an embodiment in which no inclusion is interposed between the pixel substrate portion and the first peripheral substrate portion. Typically, the pixel substrate portion and the first peripheral substrate portion are stacked with an insulating part sandwiched therebetween. The insulating part may correspond to the insulating layer 90B which is an interlayer insulating layer, of Fig. 34.

The following describes an example of a situation in Embodiment 2 where a technique involving the use of a first specific layer may contribute to such improvement in performance as that noted above.

In the imaging device of the present embodiment, the pixel substrate portion included in the pixel region R1 and the first peripheral substrate portion included in the first peripheral region R2 are stacked on top of each other. In the process of manufacturing an imaging device, the first peripheral region R2 may be heated for the following reasons. First, the first peripheral region R2 may be heated by heat that is supplied in forming the first peripheral region R2. Second, in a case where the first peripheral region R2 and the pixel region R1 are separately formed and then those regions are joined to each other, the first peripheral region R2 may be heated by heating for the joining. Third, in a case where the pixel region R1 is subjected to heat treatment after a stacked structure including the first peripheral region R2 and the pixel region R1 has been formed, the first peripheral region R2 may be heated too by the heat treatment. Heating the first peripheral transistor 27 of the first peripheral region R2 may cause diffusion of a conductive impurity. The diffusion of the conductive impurity may cause deterioration in performance of the first peripheral transistor 27. The deterioration in performance of the first peripheral transistor 27 may cause deterioration in performance of the imaging device as a whole. However, in one example of the present embodiment, the first specific layer contains the diffusion-suppressing species. The diffusion-suppressing species may contribute to the suppression of the diffusion of the conductive impurity. This diffusion-suppressing action may reduce the deterioration in performance of the first peripheral transistor 27.

The heat treatment stated as the third reason why the first peripheral region R2 may be heated is further described. The heat treatment may reduce defects in the pixel substrate portion in the pixel region R1. Reducing defects may reduce dark current in the imaging device. Meanwhile, in the first peripheral region R2, the necessity to reduce defects is not necessarily great. On the contrary, in the first peripheral region R2, there is a case where it is necessary to reduce deterioration in performance of the first peripheral transistor 27 attributed to the diffusion of the conductive impurity entailed by the heat treatment. The deterioration in performance is for example an undesirable change in threshold voltage of the first peripheral transistor 27.

In one example, the pixel region R1 has t the photoelectric conversion layer 12. The photoelectric conversion layer 12, the pixel substrate portion, and the first peripheral substrate portion are stacked on top of each other. In a typical example, in a case where a pixel region R1 having such a configuration is fabricated, such heat treatment as noted above is executed. For this reason, an imaging device including a pixel region R1 having this configuration may enjoy the effect of reducing dark current while reducing the deterioration in performance of the first peripheral transistor 27.

In one example, a method for manufacturing the imaging device includes, in this order, the step of fabricating a stacked structure including the pixel substrate portion and the first peripheral substrate portion and the step of heating the pixel substrate portion in the stacked structure. In such a manufacturing method, heating of the pixel substrate portion may cause the first peripheral substrate portion to be heated too. In this case, the effect of reducing dark current while reducing the deterioration in performance of the first peripheral transistor 27 can be enjoyed. In one specific example, the second step involves thermal processing for recovery of various crystal defects and defect levels in the pixel substrate portion, particularly the vicinity of a charge accumulation portion. Such heating intended for the pixel substrate portion may cause the first peripheral substrate portion to be heated too. The imaging device may also be manufactured by another manufacturing method.

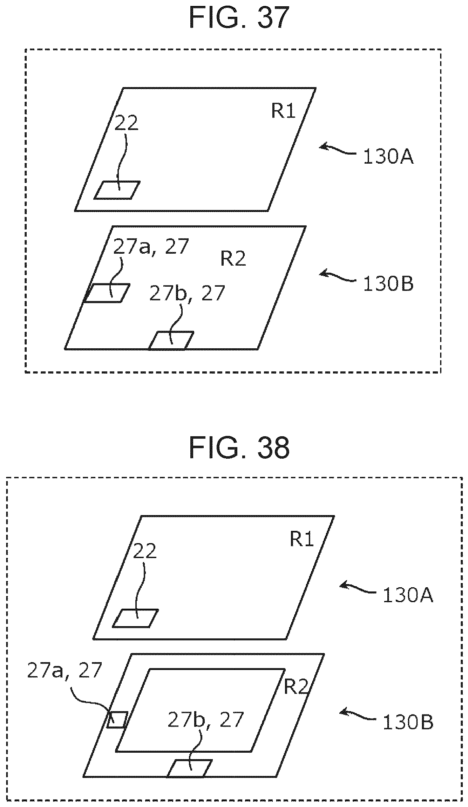

In each of the examples shown in Figs. 37 and 38, there are a plurality of first peripheral transistors 27 in the first peripheral region R2. The first peripheral region R2 and the pixel region R1 are stacked on top of each other. The pixel region R1 is constituted using the semiconductor substrate 130A. The first peripheral region R2 is constituted using the semiconductor substrate 130B.

Fig. 37 schematically shows an amplifying transistor 22 in the pixel region R1 and a plurality of first peripheral transistors 27 in the first peripheral region R2 in a case where the first peripheral region R2 is in the shape of a rectangle in a plan view. Fig. 38 schematically shows an amplifying transistor 22 in the pixel region R1 and a plurality of first peripheral transistors 27 in the first peripheral region R2 in a case where the first peripheral region R2 is in the shape of a frame in a plan view. Specifically, in Fig. 38, the first peripheral region R2 is in the shape of a square in a plan view. The first peripheral region R2 may be in the shape of letter L or in the shape of letter U in a plan view.

In each of the examples shown in Figs. 37 and 38, a plurality of the first peripheral transistors 27 are present in the first peripheral region R2. The plurality of first peripheral transistors 27 include a first direction transistor 27a and a second direction transistor 27b.

As shown in Figs. 39 and 40, the imaging device may include a second peripheral region R3. The second peripheral region R3 has a second peripheral transistor 427.

In each of the examples shown in Figs. 39 and 40, the first peripheral region R2 and the pixel region R1 are stacked on top of each other. The second peripheral region R3 and the pixel region R1 are stacked on top of each other. The pixel region R1 is constituted using the semiconductor substrate 130A. The first peripheral region R2 and the second peripheral region R3 are constituted using the semiconductor substrate 130B. In a plan view, the second peripheral region R3 is located outside the first peripheral region R2. In the example shown in Fig. 39, the second peripheral region R3 is in the shape of letter L in a plan view. In the example shown in Fig. 40, the second peripheral region R3 is in the shape of a frame in a plan view and surrounds the first peripheral region R2. Specifically, in Fig. 40, the second peripheral region R3 is in the shape of a square in a plan view. The second peripheral region R3 may be in the shape of letter U in a plan view.

As can be understood from the foregoing description, the imaging device according to each of the examples shown in Figs. 39 and 40 includes a second peripheral region R3. The second peripheral region R3 has a second peripheral substrate portion and a second peripheral transistor 427. The second peripheral transistor 427 is provided in the second peripheral substrate portion. The first peripheral substrate portion and the second peripheral substrate portion are included in the semiconductor substrate 130B. In each of the examples shown in Figs. 39 and 40, the second peripheral region R3 is located outside the first peripheral region R2.

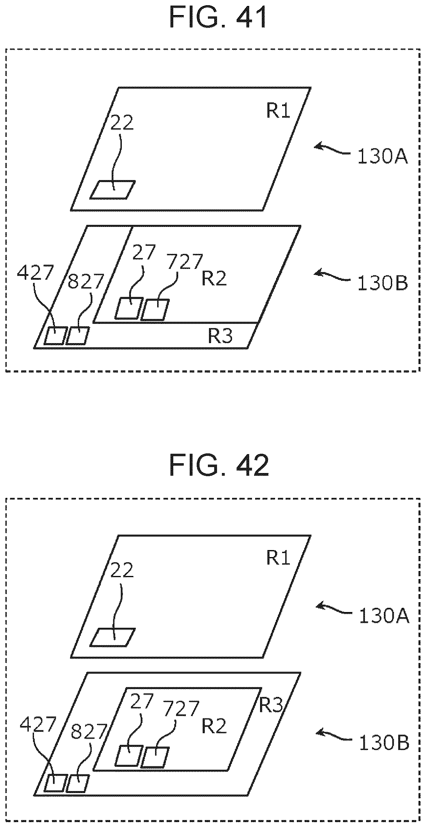

Of course, a transistor other than the transistors shown in Figs. 39 and 40 may be provided. In each of the examples shown in Figs. 41 and 42, the first peripheral region R2 has a first peripheral transistor 27 and a first peripheral transistor 727. A device isolation 220 is disposed between the first peripheral transistor 27 and the first peripheral transistor 727. The second peripheral region R3 has a second peripheral transistor 427 and a second peripheral transistor 827.

In a plan view, the second peripheral region R3 is located outside the first peripheral region R2. In the example shown in Fig. 41, the second peripheral region R3 is in the shape of letter L in a plan view. In the example shown in Fig. 42, the second peripheral region R3 is in the shape of a frame in a plan view and surrounds the first peripheral region R2. Specifically, in Fig. 42, the second peripheral region R3 is in the shape of a square in a plan view. The second peripheral region R3 may be in the shape of letter U in a plan view.

The device isolation 220 is disposed between the second peripheral transistor 427 and the second peripheral transistor 827.

The matters described with reference to Figs. 41 and 42 can be applied to the examples shown in Figs. 35 to 38, provided no contradiction arises.

The foregoing description has taken a front-side illumination imaging device as an example. Note, however, that the foregoing description is also applicable to a back-side illumination imaging device.

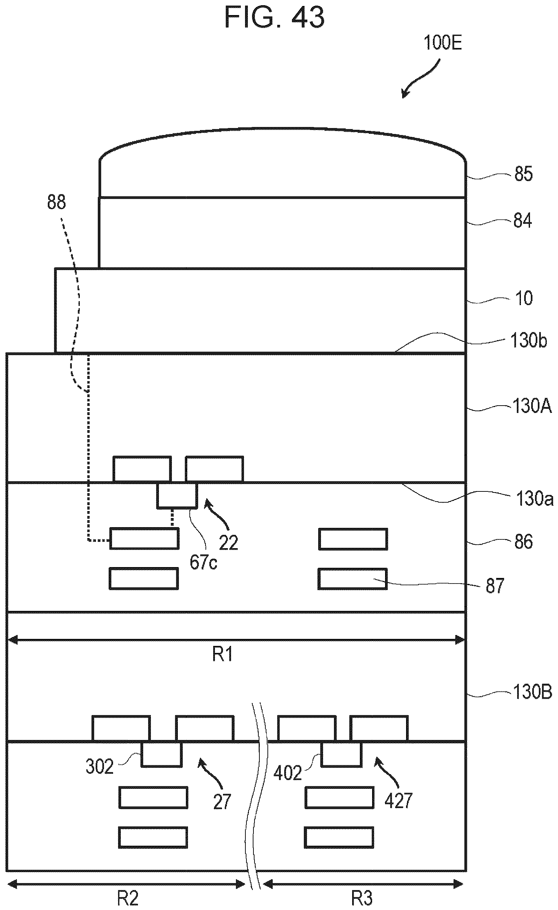

Fig. 43 is a schematic view of a back-side illumination imaging device 100E according to one example.

In the imaging device 100E shown in Fig. 43, the semiconductor substrate 130A has a front surface 130a and a back surface 130b. The back surface 130b is a surface on which light falls. The front surface 130a is a surface opposite to the surface on which light falls.

On the back surface 130b, a photoelectric converter 10 is stacked. On the photoelectric converter 10, a color filter 84 is stacked. On the color filter 84, an on-chip lens 85 is stacked. In a typical example, the semiconductor substrate 130A and the photoelectric converter 10 are joined to each other by joining the photoelectric converter 10 to the back surface 130b with the back surface 130b polished. The color filter 84 and the on-chip lens 85 may be omitted. Further, at least either between the photoelectric converter 10 and the color filter 84 or between the color filter 84 and the on-chip lens 85, an interlayer insulator film intended for planarization, protection, or other purposes may be provided.

On the front surface 130a, a wiring layer 86 is stacked. The wiring layer 86 has a plurality of wires 87 provided inside an insulator. The plurality of wires 87 are used for electrical connections to the amplifying transistor 22, the first peripheral transistor 27, and the second peripheral transistor 427. For example, a wire 87 constitutes part of an electrical pathway 88 electrically connecting the pixel electrode 11 of the photoelectric converter 10 to the gate electrode 67c of the amplifying transistor 22. Specifically, in this example, the electrical pathway 88 includes a through-silicon via (TSV) provided in the semiconductor substrate 130A. Fig. 43 omits to illustrate the through-silicon via. In Fig. 43, the dotted line representing the electrical pathway 88 is schematic, and is not intended to limit the position or other features of the electrical pathway 88. Instead of the TSV connection, a Cu-Cu connection may be employed.

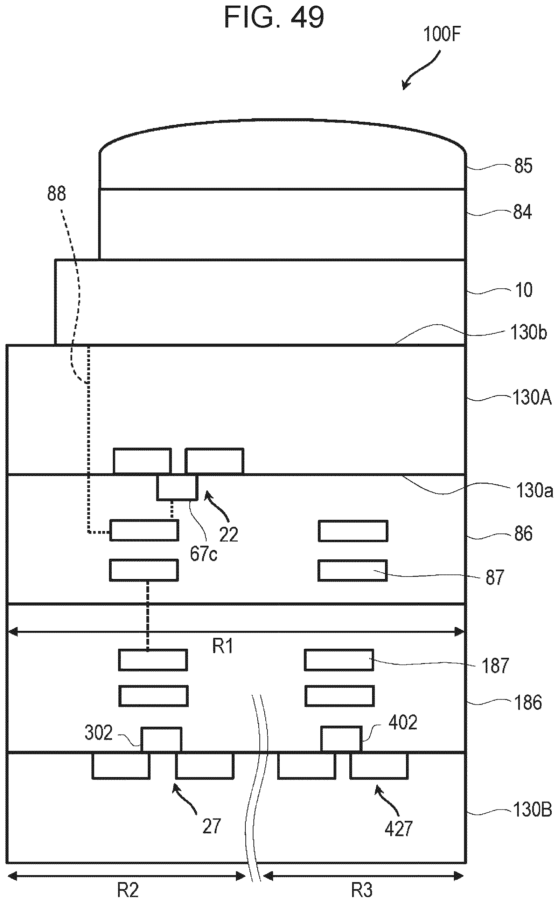

Fig. 49 is a schematic view of a back-side illumination imaging device 100F according to another example.

In the imaging device 100F shown in Fig. 49, the semiconductor substrate 130A has a front surface 130a and a back surface 130b. The back surface 130b is a surface on which light falls. The front surface 130a is a surface opposite to the surface on which light falls.

As in the case of the imaging device 100E shown in Fig. 43, on the back surface 130b, a photoelectric converter 10 is stacked. On the photoelectric converter 10, a color filter 84 is stacked. On the color filter 84, an on-chip lens 85 is stacked. In a typical example, the semiconductor substrate 130A and the photoelectric converter 10 are joined to each other by joining the photoelectric converter 10 to the back surface 130b with the back surface 130b polished. The color filter 84 and the on-chip lens 85 may be omitted. Further, at least either between the photoelectric converter 10 and the color filter 84 or between the color filter 84 and the on-chip lens 85, an interlayer insulator film intended for planarization, protection, or other purposes may be provided.

On the front surface 130a, a wiring layer 86 is stacked. The wiring layer 86 has a plurality of wires 87 provided inside an insulator. The plurality of wires 87 are used for electrical connections to the amplifying transistor 22, the first peripheral transistor 27, and the second peripheral transistor 427. For example, a wire 87 constitutes part of an electrical pathway 88 electrically connecting the pixel electrode 11 of the photoelectric converter 10 to the gate electrode 67c of the amplifying transistor 22. Specifically, in this example, the electrical pathway 88 includes a through-silicon via (TSV) provided in the semiconductor substrate 130A. Fig. 49 omits to illustrate the through-silicon via. In Fig. 49, the dotted line representing the electrical pathway 88 is schematic, and is not intended to limit the position or other features of the electrical pathway 88. Instead of the TSV connection, a Cu-Cu connection may be employed.

In the imaging device 100F, the wiring layer 86, a wiring layer 186, and the semiconductor substrate 130B are stacked in this order. The wiring layer 186 has a plurality of wires 187 provided inside an insulator. The wiring layer 86 and the wiring layer 186 are electrically connected to each other. The electrical connection between the wiring layer 86 and the wiring layer 186 may be a Cu-Cu connection or may be a TSV connection.

Although not illustrated in detail in Fig. 43 and 49, the amplifying transistor 22, the first peripheral transistor 27, and the second peripheral transistor 427 may have the features described earlier. The same applies to other elements such as the photoelectric converter 10. Specifically, in this example, the first peripheral transistor 27 and the second peripheral transistor 427 include sources, drains, extension diffusion layers, pocket diffusion layers, or other elements. The semiconductor substrate 130A includes a supporting substrate 140A. The semiconductor substrate 130B includes a supporting substrate 140B.

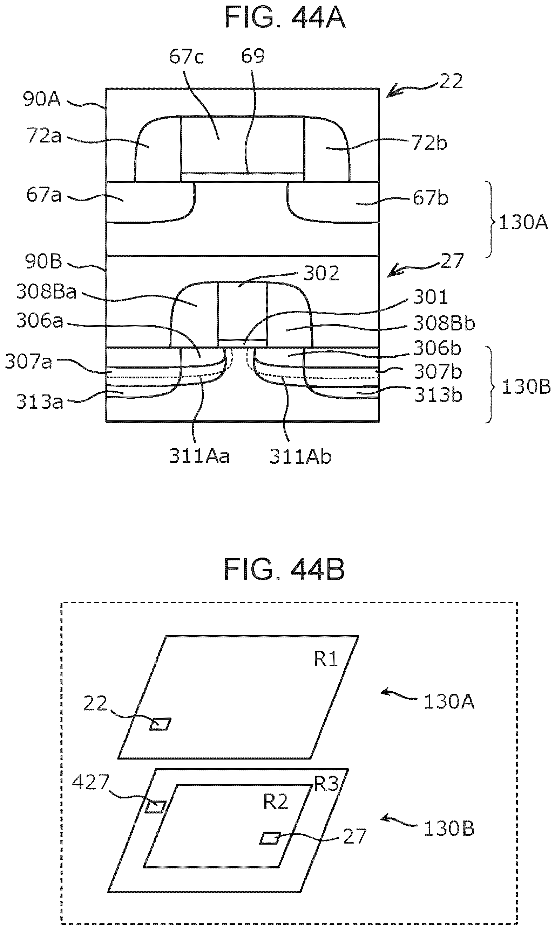

In the following, imaging devices according to specific examples of the present disclosure are described with reference to Figs. 44A to 48B. Figs. 44A to 48B omit to illustrate the photoelectric conversion layer 12, the channel region, the first epitaxial layer 135, the second epitaxial layer 136, the third epitaxial layer 137, or other components. In each of Figs. 44A, 45A, 46A, 47A, and 48A, the solid or dotted lines in the semiconductor substrates 130A, 130B, or 130C schematically represent the boundaries of a region in which an impurity spreads. The dotted lines schematically represent the boundaries of a region in which a diffusion-suppressing species spreads. In each of Figs. 44A, 45A, 46A, 47A, and 48A, a carbon-implanted layer 311Aa or a carbon-implanted layer 311Ab are illustrated by dotted lines. The insulating parts 90A to 90C may correspond to the interlayer insulating layers described earlier.

Fig. 44A is a schematic cross-sectional view of an imaging device according to a first specific example. Fig. 44B is a schematic perspective view of the imaging device according to the first specific example. Fig. 44A omits to illustrate the second peripheral transistor 427. In the imaging device according to the first specific example, the pixel region R1 is constituted using a semiconductor substrate 130A. The first peripheral region R2 and the second peripheral region R3 are constituted using a semiconductor substrate 130B. The first peripheral region R2 is surrounded by the second peripheral region R3. In the first specific example, the semiconductor substrate 130B, the insulating part 90B, the semiconductor substrate 130A, the insulating part 90A, and the photoelectric conversion layer 12 are stacked in this order. An output section that outputs a pixel signal is provided near a peripheral edge of the pixel region R1. This makes it possible to shorten the length of a wire that leads a pixel signal from the pixel region R1 to the second peripheral region R3. This is advantageous from the point of view of securing transfer speed.

In a modification (not illustrated) of the first specific example, the semiconductor substrate 130A, the insulating part 90A, the semiconductor substrate 130B, the insulating part 90B, and the photoelectric conversion layer 12 are stacked in this order. In this modification, a transistor that can be manufactured by a low-temperature process may be utilized as at least one selected from the group consisting of the first peripheral transistor 27 and the second peripheral transistor 427. The low-temperature process may contribute to the securement of the performance of a peripheral transistor, as the low-temperature can better suppress the diffusion of a conductive impurity than a high-temperature process. Examples of transistors that can be manufactured by the low-temperature process include silicon transistors, germanium transistors, carbon nanotube transistors, TMD (transition metal dichalcogenide) transistors, and oxide semiconductor transistors. Examples of oxide semiconductors of oxide semiconductor transistors include IGZO constituted by In-Ga-Zn-O, IAZO constituted by In-Al-Zn-O, and ITZO constituted by In-Sn-Zn-O. Examples of TMD transistors include molybdenum sulfide (MoS₂) transistors and tungsten sulfide (WS₂) transistors. In a case where a silicon transistor is utilized, it is also possible to use a low-temperature diffusion process, such as solid-phase epitaxial regrowth (SPER), by which an amorphized diffusion layer regrows in a solid phase in a range of approximately 400°C to 650°C.

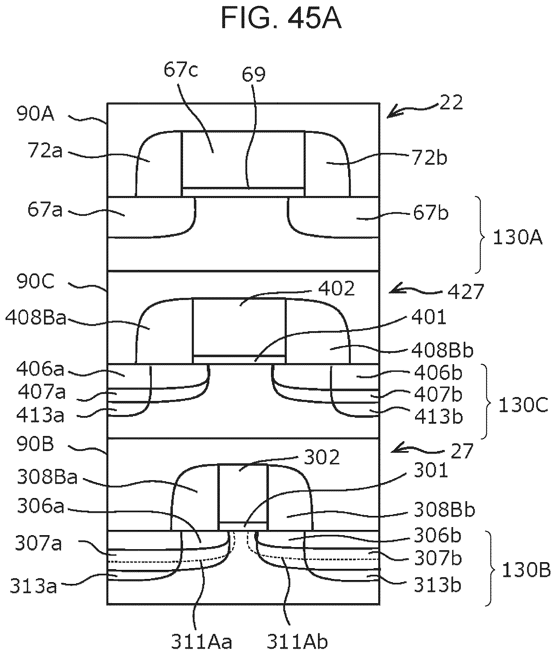

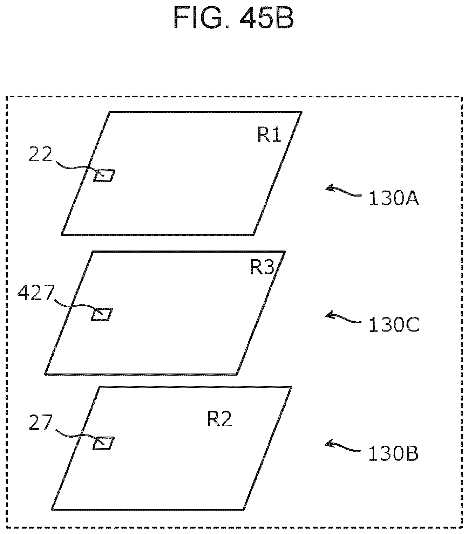

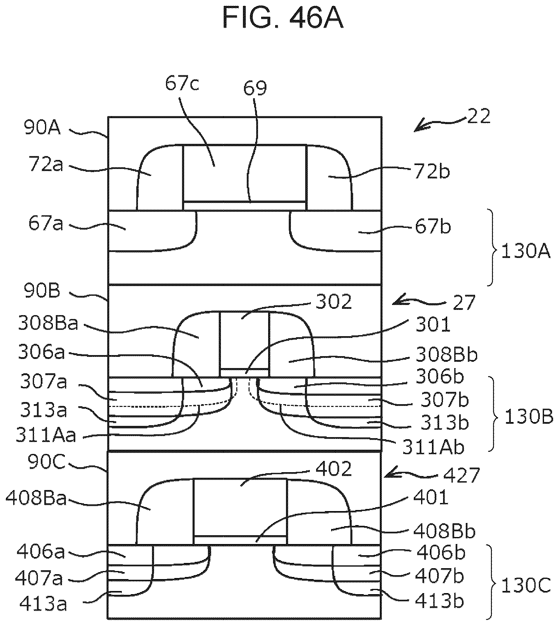

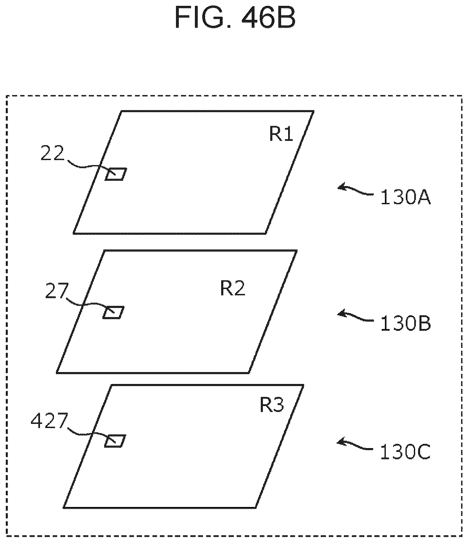

Fig. 45A is a schematic cross-sectional view of an imaging device according to a second specific example. Fig. 45B is a schematic perspective view of the imaging device according to the second specific example. Fig. 46A is a schematic cross-sectional view of an imaging device according to a third specific example. Fig. 46B is a schematic perspective view of an imaging device according to the third specific example. In each of the imaging devices according to the second and third specific examples, the pixel substrate portion included in the pixel region R1, the first peripheral substrate portion included in the first peripheral region R2, and the second peripheral substrate portion included in the second peripheral region R3 are stacked on top of each other. In each of the second and third specific examples, the pixel region R1 is constituted using a semiconductor substrate 130A. The first peripheral region R2 is constituted using a semiconductor substrate 130B. The second peripheral region R3 is constituted using a semiconductor substrate 130C. The pixel substrate portion, the first peripheral substrate portion, and the second peripheral substrate portion are isolated by insulator films or other films, are electrically joined, for example, via plugs, and can exchange signals.

In the second specific example shown in Figs. 45A and 45B, the first peripheral substrate portion included the first peripheral region R2, the second peripheral substrate portion included in the second peripheral region R3, and the pixel substrate portion included in the pixel region R1 are stacked in this order. The semiconductor substrate 130B, the semiconductor substrate 130C, and the semiconductor substrate 130A are stacked in this order. The gate length of the second peripheral transistor 427 of the second peripheral region R3 is longer than the gate length of the first peripheral transistor 27 of the first peripheral region R2. This makes it easy to keep the first peripheral transistor 27, which is relatively short in gate length and susceptible to noise, distant from the pixel region R1. This makes it hard for pixel characteristics to be affected by noise from the first peripheral transistor 27. Further, the second peripheral transistor 427, which is relatively long in gate length, can be easily held close to the pixel region R1. This makes it easy to secure the transfer speed of signal charge from the pixel region R1 to the second peripheral transistor 427.

Specifically, in the second specific example, the semiconductor substrate 130B, the insulating part 90B, the semiconductor substrate 130C, the insulating part 90C, the semiconductor substrate 130A, the insulating part 90A, and the photoelectric conversion layer 12 are stacked in this order.

In the third specific example shown in Figs. 46A and 46B, the second peripheral substrate portion included in the second peripheral region R3, the first peripheral substrate portion included in the first peripheral region R2, and the pixel substrate portion included in the pixel region R1 are stacked in this order. The semiconductor substrate 130C, the semiconductor substrate 130B, and the semiconductor substrate 130A are stacked in this order. The first peripheral transistor 27 of the first peripheral region R2 has a first extension diffusion layer that is shallow in junction depth. In the first extension diffusion layer, which is shallow in junction depth, diffusion of a conductive impurity of the first extension diffusion layer by heat easily causes variations in characteristic of the first peripheral transistor 27. However, in the third specific example, in which the second peripheral region R3, the first peripheral region R2, and the pixel region R1 are stacked in this order, the second peripheral region R3, the first peripheral region R2, and the pixel region R1 can be formed in this order in the process of manufacturing the imaging device. This makes it hard for the first peripheral region R2 to be affected by heat in the formation of the second peripheral region R3. This makes it possible to suppress the diffusion layer redistribution of the conductive impurity of the first extension diffusion layer and reduce variations in characteristic of the first peripheral transistor 27.

Specifically, in the third specific example, the semiconductor substrate 130C, the insulating part 90C, the semiconductor substrate 130B, the insulating part 90B, the semiconductor substrate 130A, the insulating part 90A, and the photoelectric conversion layer 12 are stacked in this order.

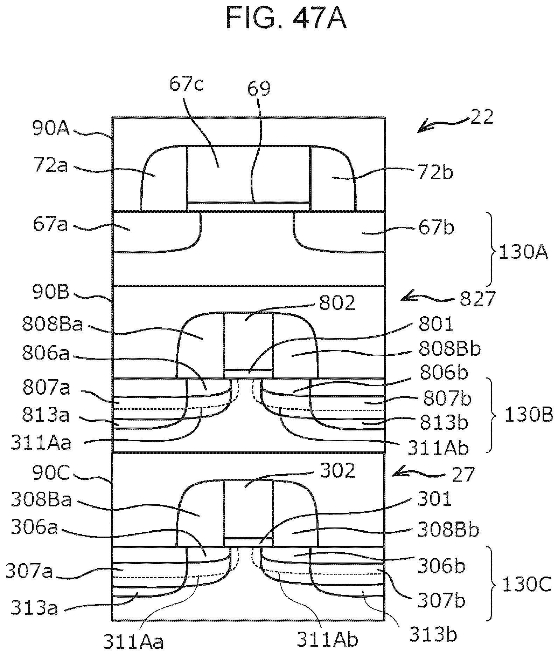

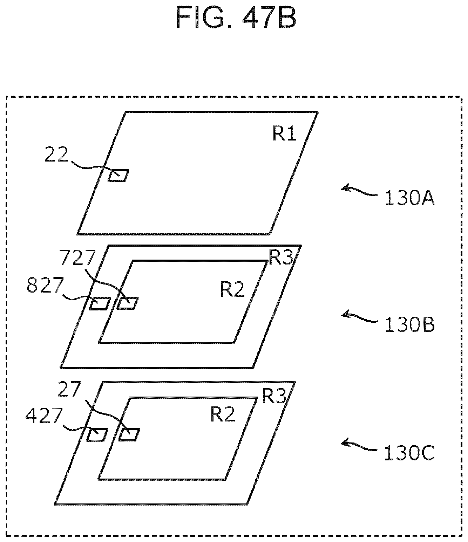

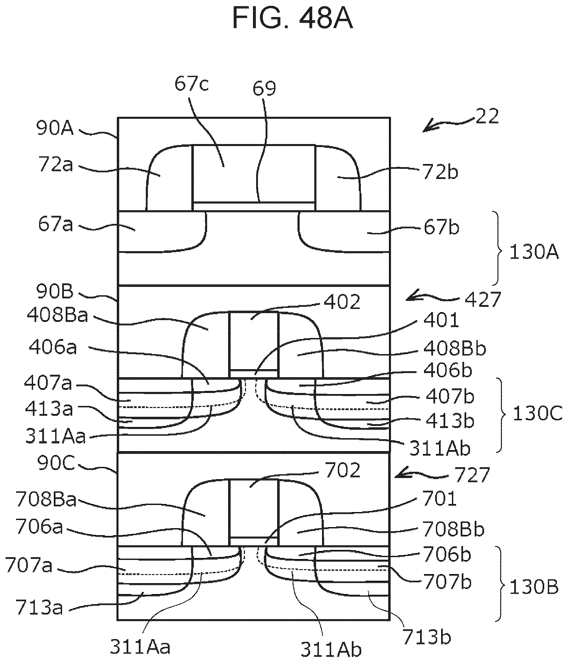

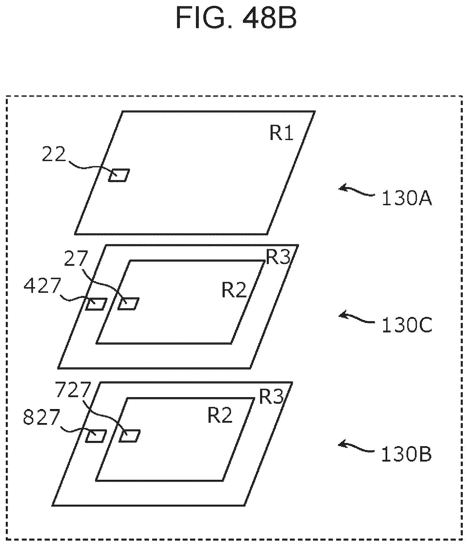

Fig. 47A is a schematic cross-sectional view of an imaging device according to a fourth specific example. Fig. 47B is a schematic perspective view of the imaging device according to the fourth specific example. Fig. 48A is a schematic cross-sectional view of an imaging device according to a fifth specific example. Fig. 48B is a schematic perspective view of the imaging device according to the fifth specific example. In each of the imaging devices according to the fourth and fifth specific examples, the pixel substrate portion included in the pixel region R1 is included in a semiconductor substrate 130A. The first peripheral substrate portion included in the first peripheral region R2 and the second peripheral substrate portion included in the second peripheral region R3 each have a portion included in a semiconductor substrate 130B. The first peripheral transistor 27 and the second peripheral transistor 427, which are N-channel transistors, are provided in the semiconductor substrate 130B. The first peripheral substrate portion included in the first peripheral region R2 and the second peripheral substrate portion included in the second peripheral region R3 each have a portion included in a semiconductor substrate 130C. The first peripheral transistor 727 and the second peripheral transistor 827, which are P-channel transistors, are provided in the semiconductor substrate 130C. The semiconductor substrate 130A, the semiconductor substrate 130B, and the semiconductor substrate 130C are stacked on top of each other. Specifically, in both the semiconductor substrate 130B and the semiconductor substrate 130C, the second peripheral region R3 is located outside the first peripheral region R2 in a plan view. More specifically, in both the semiconductor substrate 130B and the semiconductor substrate 130C, the second peripheral region R3 is in the shape of a frame surrounding the first peripheral region R2 in a plan view.

In each of the fourth and fifth specific examples, the N-channel transistors and the P-channel transistors are provided in semiconductor substrates that are different from each other. This configuration makes it easy to optimize a process step such as a stacking order of semiconductor substrates in consideration of a change in thermal stability due to diffusion of a p-type impurity and a change in thermal stability due to diffusion of an n-type impurity. Further, in each of the fourth and fifth specific examples, the N-channel transistors and the P-channel transistors are provided not in one semiconductor substrate spreading in the same plane but in stacked semiconductor substrates that are different from each other. This configuration makes it easy to reduce the area of a CMOS circuit. For example, this configuration makes it possible to, as in the case of a CFET (complementary FET), form a CMOS by vertically stacking an NFET and a PFET that constitute the CMOS. This makes it easy to reduce the area of a CMOS circuit. The term "vertically stacking" here means staking along a direction parallel with the thickness of a semiconductor substrate. Furthermore, it is also possible to provide the first peripheral transistors and the second peripheral transistors in semiconductor substrates that are different from each other. This makes it easier to reduce the area.

Specifically, in each of the fourth and fifth specific examples, the first peripheral transistor 727 is provided in the first peripheral region R2 in the semiconductor substrate 130B. The second peripheral transistor 827 is provided in the second peripheral region R3 in the semiconductor substrate 130B. The first peripheral transistor 27 is provided in the first peripheral region R2 in the semiconductor substrate 130C. The second peripheral transistor 427 is provided in the second peripheral region R3 in the semiconductor substrate 130C. The first peripheral transistor 727 is an N-type transistor, and an operating voltage of the first peripheral transistor 727 is a first voltage. The second peripheral transistor 827 is an N-type transistor, and an operating voltage of the second peripheral transistor 827 is a second voltage. The first peripheral transistor 27 is a P-type transistor, and an operating voltage of the first peripheral transistor 27 is the first voltage. The second peripheral transistor 427 is a P-type transistor, and an operating voltage of the second peripheral transistor 427 is the second voltage. The first voltage is lower than the second voltage. The first voltage is for example 1.2 V. The second voltage is for example 3.3 V.

The transistors may contain boron (B) as a p-type impurity. The transistors may contain arsenic (As) as an n-type impurity. Boron (B) is more prone to transient enhanced diffusion than arsenic (As). In the fifth specific example shown in Figs. 48A and 48B, the semiconductor substrate 130B, the semiconductor substrate 130C, and the semiconductor substrate 130A are stacked in this order. For this reason, in the fifth specific example, the semiconductor substrate 130C, which has a p-type impurity, can be formed after the semiconductor substrate 130B, which has an n-type impurity, has been formed. This makes it hard for the first peripheral transistor 27 and the second peripheral transistor 427, which are P-channel transistors, to be affected by heat in the formation of the semiconductor substrate 130B. This configuration is advantageous from the point of view of suppressing transient enhanced diffusion of a conductive impurity.

Meanwhile, in the fourth specific example shown in Figs. 47A and 47B, the semiconductor substrate 130C, the semiconductor substrate 130B, and the semiconductor substrate 130A are stacked in this order. In a case where this configuration is adopted, the action of the suppression of transient enhanced diffusion expressed in the first specific layer is easily made use of.

In each of the first to fifth specific examples, the first specific layer may be provided in both the first peripheral transistor 27 and the first peripheral transistor 727 or only either the first peripheral transistor 27 or the first peripheral transistor 727. The first specific layer may be provided in neither the first peripheral transistor 27 nor the first peripheral transistor 727. The second specific layer may be provided in both the second peripheral transistor 427 and the second peripheral transistor 827 or only either the second peripheral transistor 427 or the second peripheral transistor 827. The second specific layer may be provided in neither the second peripheral transistor 427 nor the second peripheral transistor 827.

In each of the first to fifth specific examples, the first peripheral transistor 27 has a configuration according to the first configuration example described with reference to Figs. 5A and 5B. Note, however, in each of the first to fifth specific examples, the first peripheral transistor 27 may have a configuration according to the second configuration example described with reference to Figs. 6A and 6D. The same applies to the second peripheral transistor 427, the first peripheral transistor 727, and the second peripheral transistor 827.

Various changes are applicable to the techniques disclosed here. For example, the pocket diffusion layer 707a and pocket diffusion layer 707b of the first peripheral transistor 727 and the pocket diffusion layer 807a and pocket diffusion layer 807b of the second peripheral transistor 827 may be omitted. Further, the blocking regions 200A and 200B may be omitted. Further, a silicide layer may be formed over the drain, source, and gate electrode of the first peripheral transistor 27.

Features connected with the second peripheral region R3 may be applied to the first peripheral region R2. For example, the features of the second peripheral transistors 427 and 827 may be applied to the first peripheral transistors 27 and 727.

Features connected with the first peripheral region R2 may be applied to the second peripheral region R3. For example, the features of the first peripheral transistors 27 and 727 may be applied to the second peripheral transistors 427 and 827.

Some of the plurality of transistors included in the pixel region R1 may be vertically stacked in a vertical direction. This makes it possible to increase the area of each element. Further, substrates including stacked transistors may be bonded together to form the pixel region R1.

### Industrial Applicability

An imaging device disclosed here is useful, for example, in an image sensor, a digital camera, or other devices. The imaging device disclosed here can be used, for example, in a camera for medical use, a camera for use in a robot, a security camera, a car-mounted camera, or other cameras.

### Reference Signs List

10 photoelectric converter
11 pixel electrode
12 photoelectric conversion layer
13 counter electrode
20 readout circuit
22 amplifying transistor
24 address transistor
25 transistor
27, 727 first peripheral transistor
27a first direction transistor
27b second direction transistor
427, 827 second peripheral transistor
26 reset transistor
27r portion in which first peripheral transistor is to be formed
29 transfer transistor
32 power-supply wire
34 address signal line
35 vertical signal line
36 reset signal line
38 voltage line
39 reset voltage line
45 load circuit
47 column signal processing circuit
49 horizontal common signal line
60n, 61n, 131, 131a impurity region
62 impurity layer
62bnA n-type injection layer
62an, 62bn n-type semiconductor layer
63p, 66p p-type semiconductor layer
64, 64a, 64b p-type region
65p, 82p p-type impurity region
313a source diffusion layer
67a, 713a, 813a source
413a second source
313b drain diffusion layer
67b, 713b, 813b drain
413b second drain
67c, 302, 402, 702, 802 gate electrode
303 channel diffusion layer
68, 703, 803 channel region
403 second channel region
69, 301, 401, 701, 801 gate insulator film
70, 309a, 309b, 409a, 409b, 709a, 709b, 809a, 809b offset spacer
71a, 71b, 308Aa, 308Ab, 408Aa, 408Ab, 708Aa, 708Ab, 808Aa, 808Ab first side wall
72a, 72b, 308Ba, 308Bb, 408Ba, 408Bb, 708Ba, 708Bb, 808Ba, 808Bb second side wall
80 photodiode
81n, 83n n-type impurity region
84 color filter
85 on-chip lens
86, 186 wiring layer
87, 187 wire
88 electrical pathway
89 conducting structure
90 interlayer insulating layer
90A, 90B, 90C insulating part
100A, 100B, 100C, 100D, 100E, 100F imaging device
110 pixel
120A, 120B, 120C peripheral circuit
122, 129 vertical scanning circuit
124, 127 horizontal signal readout circuit
126 voltage supply circuit
128 control circuit
130, 130A, 130B, 130C semiconductor substrate
130a front surface
130b back surface
131s silicide layer
133 first recessed portion
134 second recessed portion
135 first epitaxial layer
135c recessed portion
136 second epitaxial layer
137 third epitaxial layer
138 fourth epitaxial layer
138e, 139e embedded portion
138r, 139r raised portion
139 fifth epitaxial layer
140, 140A, 140B supporting substrate
200A, 200B blocking region
211, cp, cx contact plug
cy plug
220 device isolation
303A n-type channel impurity-implanted layer
304A n-type well impurity-implanted layer
306a, 306b first extension diffusion layer
406a, 406b second extension diffusion layer
706a, 706b, 806a, 806b extension diffusion layer
306Aa, 306Ab first p-type impurity-implanted layer
307a, 307b first pocket diffusion layer
407a, 407b second pocket diffusion layer
707a, 707b, 807a, 807b pocket diffusion layer
307Aa, 307Ab n-type pocket impurity-implanted layer
310a, 310b amorphous layer
311, 311Aa, 311Ab carbon-implanted layer
313Aa, 313Ab second p-type impurity-implanted layer
FD charge accumulation node
R1 pixel region
R2 first peripheral region
R3 second peripheral region
X1, X2 direction
Z charge accumulation region

## Claims

1. An imaging device comprising:
a pixel region including a pixel substrate portion and a pixel transistor provided in the pixel substrate portion; and
a first peripheral region including a first peripheral substrate portion and at least one first peripheral transistor provided in the first peripheral substrate portion, wherein
signals are transmitted between the first peripheral region and the pixel region,
the pixel transistor and the at least one first peripheral transistor each include a gate,
a gate length of the at least one first peripheral transistor is shorter than a gate length of the pixel transistor, and
the at least one first peripheral transistor further includes, in the first peripheral substrate portion, a first source, a first drain, a first channel region, located between the first source and the first drain, through which carriers migrate, and a first strain-introducing layer that brings a strain to the first channel region.

2. The imaging device according to claim 1, wherein the first strain-introducing layer is a single-crystal layer.

3. The imaging device according to claim 1 or 2, wherein the first strain-introducing layer is an epitaxial layer.

4. The imaging device according to any one of claims 1 to 3, wherein the first strain-introducing layer is a crystal layer of silicon germanium, germanium, a Group III-V compound, silicon carbide, transition metal dichalcogenide, or carbon nanotubes.

5. The imaging device according to any one of claims 1 to 4, wherein
the first strain-introducing layer is a crystal layer of Si₁₋ₓGeₓ, and
X is greater than 0 and less than 1.

6. The imaging device according to any one of claims 1 to 5, wherein
the first strain-introducing layer is a crystal layer of Si₁₋ₓGeₓ, and
X is greater than or equal to 0.1 and less than or equal to 0.8.

7. The imaging device according to any one of claims 1 to 6, wherein
the first peripheral substrate portion includes a first foundation layer that is adjacent to the first strain-introducing layer, and
a lattice constant of a crystal lattice of the first strain-introducing layer is different from a lattice constant of a crystal lattice of the first foundation layer.

8. The imaging device according to claim 7, wherein the first foundation layer is a single-crystal layer of silicon.

9. The imaging device according to any one of claims 1 to 8, wherein
the first peripheral substrate portion includes a supporting substrate,
the at least one first peripheral transistor includes a first cap layer in the first peripheral substrate portion,
the supporting substrate, the first strain-introducing layer, and the first cap layer are arranged in an order from lower to upper parts of the imaging device,
the first cap layer includes an upper surface of the first peripheral substrate portion, and
a concentration of a conductive impurity of the first cap layer is lower than a concentration of a conductive impurity of the supporting substrate.

10. The imaging device according to claim 9, wherein the first cap layer is a non-doped epitaxial layer.

11. The imaging device according to any one of claims 1 to 10, wherein the first channel region includes the first strain-introducing layer.

12. The imaging device according to any one of claims 1 to 11, wherein
the first source includes the first strain-introducing layer, and
the first drain includes the first strain-introducing layer.

13. The imaging device according to any one of claims 1 to 12, wherein
the pixel transistor further includes a pixel gate insulator film,
the at least one first peripheral transistor further includes a first peripheral gate insulator film, and
the first peripheral gate insulator film is thinner than the pixel gate insulator film.

14. The imaging device according to any one of claims 1 to 6, wherein
when at least one type of impurity that suppresses transient enhanced diffusion of a conductive impurity is defined as a diffusion-suppressing species, the at least one first peripheral transistor further includes a first specific layer that is located in the first peripheral substrate portion and that contains the diffusion-suppressing species, and
the diffusion-suppressing species contains at least one selected from the group consisting of carbon, nitrogen, and fluorine.

15. The imaging device according to claim 14, wherein
the first channel region includes the first strain-introducing layer,
the at least one first peripheral transistor further includes a first pocket diffusion layer,
the first pocket diffusion layer is adjacent to the first source or the first drain, and the first specific layer is included in at least one selected from the group consisting of (a) the first pocket diffusion layer and (b) a region between the first pocket diffusion layer and the first strain-introducing layer.

16. The imaging device according to claim 14 or 15, wherein
at least one selected from the group consisting of the first source and the first drain includes the first strain-introducing layer,
the first peripheral substrate portion includes a first foundation layer,
a conductive impurity in the at least one selected from the group consisting of the first source and the first drain spreads in a first region of the first foundation layer astride an interface between the first foundation layer and the first strain-introducing layer included in the at least one selected from the group consisting of the first source and the first drain, and
the first region includes the first specific layer.

17. The imaging device according to any one of claims 14 to 16, wherein
when at least one type of impurity that induces amorphization of a region into which the at least one type of impurity has been implanted is defined as an amorphizing species, the first specific layer contains the amorphizing species, and
the amorphizing species contains at least one selected from the group consisting of germanium, silicon, and argon.

18. The imaging device according to any one of claims 14 to 17, wherein
the pixel region further includes a charge accumulation region in which a charge generated by photoelectric conversion is accumulated and that is an impurity region, and
a concentration of carbon in the first specific layer is higher than a concentration of carbon in the charge accumulation region.

19. The imaging device according to any one of claims 14 to 17, wherein
the pixel transistor further includes a source, a drain, and a channel region, located between the source and the drain, through which carriers migrate, and
a concentration of carbon in the first specific layer is higher than a concentration of carbon in the channel region of the pixel transistor.

20. The imaging device according to any one of claims 1 to 13, wherein
when at least one type of impurity that suppresses transient enhanced diffusion of a conductive impurity is defined as a diffusion-suppressing species, the at least one first peripheral transistor further includes a first specific layer that is located in the first peripheral substrate portion and that contains the diffusion-suppressing species,
the at least one first peripheral transistor comprises two first peripheral transistors,
the first peripheral region further includes a shallow trench isolation structure,
the shallow trench isolation structure provides device isolation of the two first peripheral transistors from each other,
the shallow trench isolation structure includes a trench, and
a range of distribution of the diffusion-suppressing species in the first specific layer of at least either of the two first peripheral transistors is shallower than a bottom of the trench.

21. The imaging device according to any one of claims 1 to 12, further comprising a second peripheral region including a second peripheral substrate portion and a second peripheral transistor provided in the second peripheral substrate portion, wherein
the signals are transmitted between the first peripheral region and the pixel region via the second peripheral region,
the second peripheral transistor includes a gate,
the gate length of the at least one first peripheral transistor is shorter than a gate length of the second peripheral transistor,
the gate length of the pixel transistor is longer than the gate length of the second peripheral transistor, and
the second peripheral transistor further includes, in the second peripheral substrate portion, a second source, a second drain, a second channel region, located between the second source and the second drain, through which carriers migrate, and a second strain-introducing layer that brings a strain to the second channel region.

22. The imaging device according to claim 21, wherein
the second peripheral substrate portion includes a second foundation layer that is adjacent to the second strain-introducing layer, and
a lattice constant of a crystal lattice of the second strain-introducing layer is different from a lattice constant of a crystal lattice of the second foundation layer.

23. The imaging device according to claim 21 or 22, wherein at least one selected from the group consisting of the second channel region, the second source, and the second drain includes the second strain-introducing layer.

24. The imaging device according to any one of claims 21 to 23, wherein
the pixel transistor further includes a pixel gate insulator film,
the at least one first peripheral transistor further includes a first peripheral gate insulator film,
the second peripheral transistor further includes a second peripheral gate insulator film,
the first peripheral gate insulator film is thinner than the second peripheral gate insulator film, and
the pixel gate insulator film is thicker than the second peripheral gate insulator film.

25. The imaging device according to any one of claims 1 to 24, wherein
the first peripheral region is located outside the pixel region, and
the pixel substrate portion and the first peripheral substrate portion are included in a single semiconductor substrate.

26. The imaging device according to any one of claims 1 to 24, wherein the pixel substrate portion and the first peripheral substrate portion are stacked on top of each other.
